# EUROPEAN PATENT APPLICATION

(11) **EP 4 800 390 A1**
(43) Date of publication of application: **02.09.2026**
(21) Application number: 25160371.8
(22) Date of filing: 26.02.2025
(51) Int. Cl.: G01N 30/86, G06F 30/27, B01D 15/10

(54) **PREDICTION, OPTIMISATION AND MONITORING OF CHROMATOGRAPHY PROCESSES**

(71) Applicant: Sartorius Stedim Data Analytics AB, 903 33 Umeå (SE)
(72) Inventor: Corbett, Brandon, Oakville, L6M 2V9 (CA); Machleid, Rafael, 37079 Göttingen (DE)
(74) Representative: Mewburn Ellis LLP

(57) **Abstract**

Computer-implemented method of designing, monitoring or controlling a chromatography process are described. The methods comprise simulating the chromatography process by solving a bulk flow mass balance model over one or more discrete volume elements along the chromatography unit by numerical integration. The bulk flow mass balance model is an ordinary differential equations model that represents the change in concentration of bound and unbound fractions of the one or more products in a discrete volume element expressed as latent variables values of a dimensionality reduction model obtained from spectroscopy data, and that comprises binding and diffusion terms that are parameterised by a single respective parameter that is predicted by a machine learning model.

## Description

### Field of the Present Disclosure

The present disclosure relates to computer implemented methods, computer programs and systems for the simulation, optimisation, monitoring and controlling of chromatographic processes. Particular methods, programs and systems of the disclosure use a mass balance model in differential volume elements, parameterised using machine learning and spectroscopy data, to predict the state of a chromatography process.

### Background

Process chromatography is a key step in the purification of most high products of bioprocesses including biotherapeutics. In the context of biotherapeutics, the specificity of chromatographic purification steps is critical to producing safe, effective products. To achieve the required specificity, the chromatography columns used in these steps have complex chemical and physical properties, requiring precise manufacturing. Chromatography columns are therefore expensive, in some processes accounting for up to 30% of the cost of biotherapeutic manufacturing. Furthermore, because of the tight specifications around these columns, their useful lifetime is limited. Therefore, there is a strong incentive to optimize the performance of chromatographic steps both in process development and in manufacturing stages of bioproduct production.

Traditionally, optimization of chromatography steps during process development involves lab experiments starting at small scale (i.e. 5 ml bed volume) and gradually increasing scale until production volumes are reached. During this process, the feed concentration, buffer conditions, and flow rate of the target product may be optimized to maximize product recovery (traditionally measured in milligrams of product per liter of chromatographic resin). Throughout the design process, simple summary statistics such as the "dynamic binding capacity" of the column (maximum amount of the target product, e.g. a target protein that can be loaded onto the column under a specific set of process conditions) are typically calculated from experimental results. These are then used to aid in design of subsequent experiments. While the simplicity of dynamic binding capacity makes it a useful design tool, it is difficult to predict how its value will change when changing flow rates or feed concentrations.

To make predictions of chromatography performance under feed-stock variation, changing flow rates, and changing physical dimensions, multiple first-principles (physics based) models of chromatography have been proposed. These can also be referred to as "mechanistic" models, and involve detailed modelling of physicochemical processes occurring in the chromatographic process, parameterised using complex processes from extensive experimentally determined concentration data. In general, because chromatography columns evolve dynamically in both spatial and temporal dimensions, these models are mathematically described by partial differential equations (PDEs). For example, the general rate model is a detailed mechanistic model that describes transport of solute molecules through the interstitial column volume by convective flow, mass transfer resistance through a stagnant film around the beads, pore (and surface) diffusion in the porous beads, and adsorption to the inner bead surfaces. Different forms of the general rate model for different chromatographic conditions/configurations have been well studied (see e.g. Shekhawat & Rathore, 2019).

While these models can be powerful predictive tools, they suffer a few drawbacks for use in practical applications. In order to mathematically describe all physical effects that take place in the column, these models require a relatively large number of complex, non-linear terms with numerous coefficients. These coefficients must be uniquely identified through careful experimentation. For a typical application, identification of these coefficients may take on the order of one to two months of experimental time. Furthermore, constructing a model using this first-principles approach requires the modeler to understand and correctly characterize each physical interaction within the column. Factors like competitive binding and complex diffusion must be explicitly described. Therefore, a great deal of prior experience is required to construct good models. Additionally, as chromatography technology has developed, the physical properties of state-of-the-art columns have become increasingly complex and difficult to model from first principles. For example, membrane columns can have complex pore structures that may be difficult, if not impossible, to completely characterize. For these reasons, construction of general rate models to describe real columns is a non-trivial task typically performed by modelling experts.

Even when using simplified models, the requirement to obtain detailed concentration measurements over many samples makes parameterisation difficult and expensive.

There is therefore a need for new approaches to model chromatography processes.

### Summary

The present inventors recognised that current state-of-the art approaches to simulate chromatographic processes (e.g. for chromatographic process optimisation, monitoring, upscaling etc.) suffer from multiple drawbacks related to the complexity of the phenomena that need to be accounted for in order to obtain reliable simulations. They hypothesised that some of this complexity could be bypassed by providing a unique new type of hybrid model that combines a simple physics-based model only capturing bulk flow (i.e. mass balance) and a machine learning model trained to capture binding and diffusion. Specifically, the machine learning model predicts parameters of the mass balance model that dynamically capture all binding and diffusion phenomena within the column. These can be seen as phenomenological parameters which are directly plugged into the simple mass balance equations, negating the need for detailed models that capture all aspects of a products binding and diffusion within the various compartments of the column. Additionally, because the mass balance model does not explicitly model diffusion geometry and uses differential volume elements, the same machine learning model can be used regardless of the geometry of the column, and the same architecture can be used regardless of the type of stationary phase (e.g. resin, membrane or monolith). This therefore represents a universal chromatography model that is simple to parameterise, stable and computationally efficient to run. They further hypothesised that information derived from spectral measurements such as Raman spectroscopy and UV absorbance could be used to represent concentration variables in such a model. The key idea behind this is that any change in the spectral signature measured in either the inlet or outlet of a chromatography column is fundamentally related to a change in concentration. Therefore, a model trained from such data to identify latent variables that capture the information in the spectral data can be used as a proxi for changes in concentrations in such a model. The present inventors therefore postulated that, rather than calibrating soft-sensors to predict concentrations of individual species, a universal chromatography model as described herein can be made to work directly from such latent variables.

According to a first aspect of the disclosure, there is provided a computer-implemented method of simulating a chromatography process whereby a feed flow comprising one or more products is passing through a chromatography unit comprising a stationary phase that the one or more products interact with, the method comprising: solving a bulk flow mass balance model over one or more discrete volume elements along the chromatography unit by numerical integration;
wherein the bulk flow mass balance model is an ordinary differential equations model that represents the change in concentration of bound and unbound fractions of the one or more products in a discrete volume element, wherein the concentration of bound and unbound fractions of the one or more products are expressed as latent variable values of a dimensionality reduction model obtained from spectroscopy data;
wherein the ordinary differential equations model comprises binding and diffusion terms, wherein a binding term captures the binding of a product to the stationary phase and a diffusion term captures the diffusion of a bound product, wherein said binding and diffusion terms are each parameterised by a single respective parameter that is predicted by a machine learning model trained to take inputs comprising the latent variable values corresponding to the concentration of the bound and unbound fractions of the one or more products in a discrete volume element and produce as output a prediction of the parameters of the binding and diffusion terms.

The present aspect also provides a method of simulating a chromatography process whereby a feed flow comprising one or more products is passing through a chromatography unit comprising a stationary phase that the one or more products interact with, the method comprising: using a mass balance module implemented in a processor to solve, over one or more discrete volume elements along the chromatography unit, a bulk flow mass balance model that represents the change in concentration of bound and unbound fractions of the one or more products in a discrete volume element, wherein the concentration of bound and unbound fractions of the one or more products are expressed as latent variable values of a dimensionality reduction model obtained from spectroscopy data, wherein the solving uses a numerical integration module, wherein the bulk flow mass balance model is an ordinary differential equations model comprising binding and diffusion terms, wherein a binding term captures the binding of a product to the stationary phase and a diffusion term captures the diffusion of a bound product, wherein said binding and diffusion terms are each parameterised by a single respective parameter; wherein said solving comprises using a machine learning module implemented in the processor to predict the value of said parameters, the machine learning module using a trained machine learning model to predict the values of said parameters using inputs comprising the latent variable values corresponding to the concentration of the bound and unbound fractions of the one or more products in a discrete volume element.

Thus, the methods of the disclosure advantageously make use of a very simple physics based model that only represents bulk flow and the effects of binding and diffusion on bulk flow via phenomenological terms (i.e. terms that do not explicitly model the detailed physico-chemical phenomena underlying the dynamics of binding of the products to the stationary phase and diffusion of the bound product), combined with a data driven phenomenological parameterisation model (machine learning model) to provide the bulk level phenomenological parameters representing diffusion and binding, where the model is directly parameterised from spectral data - without requiring any concentration measurements or explicit determination of the products that should be modelled to accurately capture the dynamics of the system. This means that any species that can be observed through spectral measurements has the opportunity to influence the column model (e.g. through competitive binding effects), since the machine learning can learn these effects. Additionally, since the approach does not require any concentration measurements, it can be parameterised in real time (i.e. the model can keep learning in real time, updating itself as data becomes available). This means that the model can be continuously adapted to best reflect the behaviour of the particular system that is being modelled, even if that system ages or changes. This also means that the model can be put in use after minimal training and will keep improving itself over time. Further, the model can be parameterised and run without the need to parametrise soft sensors to determine concentrations from spectral data for all species that may influence the dynamics of the chromatography process. Soft sensors are hard to calibrate because they require isolation of each individual species that can be present in a complex mixture and that can influence the spectroscopy data or the chromatography process (of which they can be a great number, e.g. in the context of host cell proteins, which are a big problem in biologics production). Further, because the setting up and training of the model does not require any modelling design choices, minimal input is needed from experimenters or modelers. In fact, the entire process of learning a column model could be automated on the chromatography device platform and run lights out. Finally, the models are interpretable through the dimensionality reduction model (i.e. outputs of the model can be transformed back into spectral data), so it is possible to explain how the model arrived at its conclusions. It is also possible to further transform these data into concentrations by using calibrated models for individual products, enabling specific informative measurements like product titre to be estimated.

Further, the phenomena that are not explicitly modelled occur in different compartments of the chromatography unit, such as e.g. in pores and on films on surfaces, along multiple dimensions and involve physico-chemical processes that are not necessarily well characterised. The present methods advantageously bypass all of this, using a machine learning algorithm to identify all parts of the dynamic behaviour of the system that are not easily explained by first principles. Finally, the approach relying on differential volume elements and including simple diffusion and binding terms that are captured as Ordinary Differential Equations (ODEs) means that the model has the same architecture regardless of the geometry of the chromatography unit. In other words, the model does not explicitly represent diffusion geometry, and the same model can be used for columns with different geometry, enabling straightforward application for *in silico* scale up experiments. Further, the use of ODEs over discrete volume elements means that the simulation can be run without the need for adaptive step-size partial differential equation solvers. As a result, the simulation is both more stable and more computationally efficient than prior art methods.

According to a second aspect of the disclosure there is provided a computer-implemented method of designing, monitoring or controlling a chromatography process whereby a feed flow comprising one or more products is passing through a chromatography unit comprising a stationary phase that the one or more products interact with, the method comprising:
simulating the chromatography process by solving a bulk flow mass balance model over one or more discrete volume elements along the chromatography unit by numerical integration,
wherein the bulk flow mass balance model is an ordinary differential equations model that represents the change in concentration of bound and unbound fractions of the one or more products in a discrete volume element, wherein the concentration of bound and unbound fractions of the one or more products are expressed as latent variables values of a dimensionality reduction model obtained from spectroscopy data,
wherein the ordinary differential equations model comprises binding and diffusion terms, wherein a binding term captures the binding of a product to the stationary phase and a diffusion term captures the diffusion of a bound product, wherein said binding and diffusion terms are each parameterised by a single respective parameter that is predicted by a machine learning model trained to take inputs comprising the latent variable values corresponding to the concentration of the bound and unbound fractions of the one or more products in a discrete volume element and produce as output a prediction of the parameters of the binding and diffusion terms.

Also provided according to the second aspect is a method of designing, monitoring or controlling a chromatography process whereby a feed flow comprising one or more products is passing through a chromatography unit comprising a stationary phase that the one or more products interact with, the method comprising: using a mass balance module implemented in a processor to solve, over one or more discrete volume elements along the chromatography unit, a bulk flow mass balance model that represents the change in concentration of bound and unbound fractions of the one or more products in a discrete volume element, wherein the concentration of bound and unbound fractions of the one or more products are expressed as latent variable values of a dimensionality reduction model obtained from spectroscopy data, wherein the solving uses a numerical integration module, wherein the bulk flow mass balance model is an ordinary differential equations model comprising binding and diffusion terms, wherein a binding term captures the binding of a product to the stationary phase and a diffusion term captures the diffusion of a bound product, wherein said binding and diffusion terms are each parameterised by a single respective parameter; wherein said solving comprises using a machine learning module implemented in the processor to predict the value of said parameters, the machine learning module using a trained machine learning model to predict the values of said parameters using inputs comprising the latent variable values corresponding to the concentration of the bound and unbound fractions of the one or more products in a discrete volume element.

Methods according to the first or second aspects my have any one or more of the following optional features.

In embodiments, the dimensionality reduction model is a model that applies an affine transformation to input data. In embodiments, the dimensionality reduction model is a principal component analysis model, or an autoencoder model, or a t-distributed stochastic neighbor embedding. The latent variables of the dimensionality reduction model may be centred or may have been centred by subtracting from all latent variable values a corresponding value obtained using the dimensionality reduction model for spectroscopy data associated with a reference sample. The reference sample may be a sample that does not comprise any of the products, such as e.g. a buffer sample. The spectroscopy data associated with the reference sample may not have been used to train the dimensionality reduction model.

In embodiments, the spectroscopy data comprises one or more of: Raman spectra, UV spectra, fluorescence spectra and near infrared spectra. In embodiments, the spectroscopy data comprises Raman spectra and/or UV spectra. Raman and UV spectroscopy are advantageously well studied and widely available spectroscopy technologies that have been used to characterise the flows from chromatography processes used in downstream processes in bioprocessing. For the purpose of the present disclosure it is additionally advantageous that they can be used inline in chromatography processes. This enables collection of extensive training data for parameterising the dimensionality reduction model and/or for training the machine learning model. This also enables continuous online training of one or both of these models (i.e. training as spectroscopy data about an ongoing chromatography process becomes available). Combining UV and Raman spectroscopy may be particularly advantageous as it may benefit from the sensitivity of UV spectroscopy and the specificity of Raman spectroscopy, particularly for analysing flows in downstream processes of bioprocessing.

The spectroscopy data may comprise intensity values as a function of Raman shift for a plurality of Raman shifts. The spectroscopy data may comprise intensity values as a function of wavelengths for a plurality of wavelengths. The plurality of wavelengths / Raman shift may advantageously comprise all values for which measurements are available in a digital spectrum. In other words, complete (digitally recorded) spectra may be used. subsets of spectra or downsampled spectra may be used. However, it is advantageous in practice to use the most complete information available as the dimensionality reduction model can then take care of the dimensionality reduction in a way that best captures meaningful variability in the data.

In embodiments, the dimensionality reduction model has been previously obtained from training data comprising spectroscopy data obtained at a plurality of sampling times of input and output flows of one or more chromatography processes. In embodiments, the one or more chromatography processes are chromatography processes using a feed flow that has a composition representative of the feed flow of the simulated chromatography process. In embodiments, the training data further comprises spectroscopy data obtained from offline samples comprising one or more species of interest. In embodiments, the training data further comprises one or more species concentrations measured in samples associated with any one or more of the spectroscopy data.

The method may further comprise obtaining the dimensionality reduction model from training data comprising spectroscopy data obtained at a plurality of sampling times of input and output flows of one or more chromatography processes using a feed flow expected to comprise the same one or more products, and optionally spectroscopy data obtained from offline samples and/or one or more species concentrations measured in samples associated with any one or more of the spectroscopy data. Thus, the training data may comprise concentrations measured for one or more species (e.g. one or more products and/or impurities) in one or more samples for which spectroscopy data is also included in the training data (e.g. samples corresponding to one or more of the plurality of sampling times of input and output flows, samples corresponding to one or more of the offline samples).

The training data used to train the dimensionality reduction model may comprise spectroscopy data from a plurality of spectroscopy technologies for one or more of the sampling times of one or more of the chromatography processes and/or for offline samples. Further, the training data used to train the dimensionality reduction model may comprise concentration measurements for one or more species in samples corresponding to one or more of the sampling times of one or more of the chromatography processes and/or for offline samples. In such cases, the training data may be formatted as a matrix in which measurements are aligned by sampling times within each of the one or more chromatography processes. Sampling times may be adjusted to account for residence times of the solution in non-column parts of the system. For example, sampling times may be adjusted to take into account the residence time of solution in piping between measurement locations.

In embodiments, the dimensionality reduction model has been previously obtained from training data comprising spectroscopy data obtained at a plurality of sampling times of input and output flows of a plurality of chromatography processes. The plurality of chromatography processes may comprise at least 3 chromatography processes. In embodiments, the dimensionality reduction model has been previously obtained from training data comprising spectroscopy data obtained at a plurality of sampling times of input and output flows of one or more chromatography processes, wherein the plurality of sampling times are spaced apart by at most 1 minute. In embodiments, the dimensionality reduction model has been previously obtained from training data comprising spectroscopy data obtained at a plurality of sampling times of input and output flows of one or more chromatography processes, the plurality of sampling times spread along the duration of an elution phase of a respective chromatography process. In embodiments, the dimensionality reduction model has been previously obtained from training data further comprising spectroscopy data obtained at a plurality of sampling times of elution and/or waste flows of one or more chromatography processes. In embodiments, the dimensionality reduction model has been previously obtained from training data comprising spectroscopy data obtained at a plurality of sampling times of input and output flows of one or more individual columns of a multi-column chromatography process.

In embodiments, the bulk flow mass balance model comprises: (a) one or more ordinary differential equations that represent the change in concentration of bound fractions of the one or more products in a discrete volume element expressed as latent variables values of a dimensionality reduction model obtained from spectroscopy data; and (b) one or more ordinary differential equations that represent the change in concentration of unbound fractions of the one or more products in a discrete volume element expressed as latent variables values of a dimensionality reduction model obtained from spectroscopy data; wherein the number of equations in (a) and (b) is equal to the number of latent variables in the dimensionality reduction model.

The method may further comprise determining an optimal number of latent variables in the dimensionality reduction model. Determining an optimal number of latent variables in the dimensionality reduction model may be performed using cross-validation or using analysis of the signal to noise ratio of time series of latent variable values corresponding to effluent spectra (i.e. breakthrough curves).

In embodiments, the bulk flow mass balance model comprises linear terms representing the flow of unbound compounds (products and optionally inerts) in and out of the discrete volume element, and the binding and diffusion terms, wherein a binding term captures non-linearities of the process of adsorption of unbound product on the static phase through the prediction of the respective parameter of the term by the machine learning model at each iteration of the numerical integration. In embodiments, the bulk flow mass balance model comprises equations (6) and (7) below: $\frac{d {{t}^{⇀}}_{u , n}}{dt} = \frac{{f}_{k}}{ΔV} \left({{t}^{⇀}}_{u , n - 1}-{{t}^{⇀}}_{u , n}\right) - {{k}^{˜}}_{a} ∘ {{c}^{⇀}}_{u , n} + {{k}^{⇀}}_{d} ∘ {{t}^{⇀}}_{b , n}$ $\frac{d {{t}^{⇀}}_{b , n}}{dt} = {{k}^{˜}}_{a} ∘ {{t}^{⇀}}_{u , n} - {{k}^{⇀}}_{d} ∘ {{t}^{⇀}}_{b , n}$ where fₖ is the feed flow rate, ΔV is the volume of the discrete volume element *n,* ${{t}^{⇀}}_{u , n}$ is a vector of latent variable values corresponding to concentrations of the unbound products in the discrete volume element n, ${{t}^{⇀}}_{b , n}$ is a vector of latent variable values corresponding concentrations of the bound products in the discrete volume element *n,* ${{t}^{⇀}}_{u , n - 1}$ is a vector of latent variable values corresponding to concentrations of the unbound products in the discrete volume element preceding the discrete volume element *n*, where discrete volume elements are sequentially labelled from input to output of the chromatography unit, and ∘ is an elementwise product.

The bulk flow mass balance model can further comprise equation (3) below: $\frac{d {{c}^{⇀}}_{i , n}}{dt} = \frac{{f}_{k}}{ΔV} \left({{c}^{⇀}}_{i , n - 1}-{{c}^{⇀}}_{i , n}\right)$ where ${{c}^{⇀}}_{i , n}$ is a vector of concentrations of one or more inerts in the discrete volume element *n,* ${{c}^{⇀}}_{i , n - 1}$ is a vector of concentrations of the inerts in the discrete volume element preceding the discrete volume element *n*. Thus, the bulk flow mass balance model can further represent the change in concentration of one or more inerts in the discrete volume element (e.g. using equation (3)) and the machine learning model inputs can further comprise the concentration of the one or more inerts in the discrete volume element. Modelling of inert species is optional and likely to be rare. Indeed, the formulation using equations (6) and (7) already inherently captures all species that can interact with the stationary phase of the chromatography process and that are associated with a signal in the spectroscopy data (even if that signal cannot be individualised and/or interpreted, and even if the species are unknown). Latent variable values of the dimensionality reduction model can be used for inert species instead of concentrations, but this is not recommended as the assumption that latent variable values are only associated with products simplifies the training of the machine learning model. This system of equations only represents three macrolevel phenomena in discrete volumes along the chromatography unit: flow of unbound products in and out of the volume (and optionally flow of inerts in and out of the volume), diffusion of bound products, and binding of unbound products to the stationary phase. The latter two are parameterized with "catch-all" parameters in vectors *k̃ₐ* and ${{k}^{⇀}}_{d}$, which are calculated as the output of the machine learning model.

In embodiments, the bulk flow mass balance model is solved over N discrete volume elements, wherein N is at least 2, wherein N is between 5 and 20, wherein is between 5 and 15, wherein N is selected from 8, 9, 10, 11, 12, or wherein N is 10. In embodiments, the discrete volume elements comprise a plurality of discrete volume elements along the chromatography unit in which binding and diffusion occurs, preceded by a discrete volume element in which no binding or diffusion occurs (entry dead volume) and followed by a discrete volume element in which no binding or diffusion occurs (exit dead volume). In embodiments, the bulk flow mass balance model further represents the change in concentration of one or more inerts in the discrete volume element and the machine learning model inputs further comprise the concentration of the one or more inerts in the discrete volume element.

In embodiments, the machine learning model inputs further comprise the feed flow rate. Advantageously, this means that the model (combining the mass balance model and the machine learning model) is able to capture the effects of flow rate on the dynamics of binding and diffusion (via the machine learning model), thereby making it possible to use the same model to simulate columns at different flow rates. Indeed, fluid-mechanic, binding and diffusion effects can be learned from experimental data generated at different flow-rates, making the resulting trained model applicable at least to any range of flow rate for which training data (or training data with similar flow rates) was available. Further, because the flow variable, fₖ, is not used by the machine learning model in a first-principle derived equation, this variable may be "transformed" by the user before being passed to the machine learning model. For example, while the mass balance model uses a volumetric flow rate, the flow rate can be converted to linear velocity or residence time prior to providing it as input to the machine learning model. This is expected to result in models that are less scale dependent. This property is particularly advantageous for applications where there is a desire to identify models from experiments conducted in small columns and make predictions using those models for larger-scale (commercial manufacturing relevant) columns. Thus, in embodiments, the method comprises obtaining a volumetric feed flow rate, converting said volumetric feed flow rate to a linear velocity or residence time and providing said converted feed flow rate as input to the machine learning model.

In embodiments, the machine learning model further takes as input a parameter indicative of the age of the chromatography unit. For example, the machine learning model can take as input the number of cycles that the chromatography unit has been operated for, the number of total volumes of the unit that have gone through the unit, or any other value derived therefrom (e.g. % of estimated lifetime as the number of cycles that the chromatography unit has bene used for relative to the expected number of cycles in the lifetime of the column, etc.). This advantageously enables the machine learning model to accurately capture effects of an aging column on the dynamics of the chromatography process. Instead or in addition to this, changes in the behaviour of the column can be captured by retraining (e.g. fine tuning - by-passing any pretraining as described further below and just training the model using new data and the previous weights of the model as initial weights) the machine learning model with new spectroscopy data obtained from the chromatography unit over time. This effectively adjusts the predictions of the model to the latest sets of measurements available from the chromatography unit.

In embodiments, the machine learning model is a recurrent machine learning model, wherein a recurrent machine learning model is a machine learning model that is able to account of the values of one or more predictions made at one or more preceding iterations of the numerical integration when making predictions at a current iteration of the numerical integration. In embodiments, the machine learning model further takes as input a recurrent states vector ${{x}^{⇀}}_{r , k , n}$ which comprises one or more state values for a current iteration *k* and discrete volume element *n*, and produces as output an updated recurrent state vector ${{x}^{⇀}}_{r , k + 1 , n}$ for use at the subsequent iteration. In embodiments, the machine learning model comprises a parameter prediction submodel and a recurrent state submodel, wherein the recurrent state submodel is configured to predict the updated recurrent states vector ${{x}^{⇀}}_{r , k + 1 , n}$ for use at the subsequent iteration based on the inputs of the machine learning model and the parameter prediction submdodel is configured to predict the parameters of the binding and diffusion terms based on the inputs of the machine learning model. The recurrent states vector can be concatenated with the other input variables (concentrations of the bound and unbound products, feed flow rate and concentrations of inerts if used). Prior to use as input by the machine learning model, the recurrent states vector can be transformed using any function configured to produce a bounded value from an unbounded value, such as a tanh or sigmoid function. This advantageously ensures that the state values do not increase to dominate the other input variables. In embodiments comprising a parameter prediction submodel and a recurrent state submodel, the concatenated input can be fed into both the parameter prediction submodel and the recurrent state submodel.

In embodiments, the machine learning model comprises a recurrent state submodel and a parameter prediction submodel that are parameterized by respective weights that are all learned simultaneously. In embodiments, the trained machine learning model is associated with learned weights that are the same for every discrete volume element and every iteration of the numerical integration. In embodiments, the machine learning model is a nonlinear regression model. In embodiments, the machine learning model comprises a neural network. In embodiments, the neural network is a fully connected neural network, a neural network comprising at least 2 hidden layers, a neural network comprising between 1 and 4 hidden layers, a neural network comprising 2 or 3 hidden layers, and/or a neural network comprising between 8 and 60 nodes in each hidden layer.

In embodiments, the method further comprises training the machine learning model using training data comprising latent variable values of the dimensionality reduction model obtained from training data comprising spectroscopy data obtained at a plurality of sampling times of input and output flows of a plurality of chromatography processes. In embodiments, the training data comprises latent variable values from input and output spectroscopy data each associated with a respective discrete time point during a chromatographic process. In embodiments, the training data comprises latent variable values from input and/or output spectroscopy data associated with a time range during a chromatographic process. The machine learning model may have been trained using training data comprising latent variable values of the dimensionality reduction model obtained from training data comprising spectroscopy data obtained at a plurality of sampling times of input and output flows of a plurality of chromatography chromatography processes. Latent variable values from input and/or output spectroscopy data associated with a time range during a chromatographic process may be data collected using a fraction collector or simply data collected using a spectroscopy apparatus that has a known latency (acquisition time) when obtaining spectral measurements, such that spectral measurements are representative of the respective flow over a known time range.

Spectroscopy data obtained at a plurality of sampling times of input and output flows may be indicative of feed (inlet) product concentrations and effluent (outlet) product concentrations, respectively. The training data used to train the machine learning model may comprise latent variable values of the dimensionality reduction model obtained from training data that was used to train the dimensionality reduction model. In other words, the dimensionality reduction model and the machine learning model may be trained using the same training spectroscopy data. Training the machine learning model may be performed prior to the use of the machine learning model to simulate a chromatography process (e.g. for the purpose of monitoring or controlling a chromatography process). Training the machine learning model may additionally be performed one or more additional times after commencing the use of the machine learning model to simulate a chromatography process for the purpose of monitoring or controlling a chromatography process. In other words, the machine learning model may be retrained or further trained while the method is being used to monitor or control a chromatography process, using additional training data that has been acquired during the use of the chromatograph process. For example, the machine learning model may be retrained when one or more predetermined criteria have been met, using training spectroscopy data including spectroscopy data acquired during use of the chromatography process since the machine learning model was last trained. The one or more criteria may include a predetermined number of chromatography cycles since the machine learning model has been last trained (i.e. the machine learning model may be trained at regular intervals (e.g. every N cycles, where N can be 1, 2, 3, 4 or 5)). The one or more criteria may include the error between simulated output data and corresponding measured data exceeding a predetermined threshold. The one or more criteria may include additional training data being available. For example, the machine learning model may simply be retrained every time new training data, or a predetermined amount of new training data is available. Using high frequency updates (e.g. updates every time some or small amounts of new training data is available and/or when the error exceeds a low predetermined threshold) may be associated with small amounts of computing power since only small adjustments to the model are expected to be needed, which may be more practical than less regular, larger updates that may require more computer power at discrete times. A preferred set of criteria to trigger updates is likely to depend on the particular circumstances including but not limited to the computing infrastructure available and the tolerance to drifts in the performance of the machine learning model. It is within the capability of the skilled person, based on their circumstances and the teaching of the present disclosure, to select these criteria appropriately. When retraining the machine learning model, this may be performed using starting weights that are set at the latest used weights. Retraining the machine learning model may be performed without any of the pretraining steps described herein. Retraining may be performed using the training data that has been previously used to train the machine learning model, and additional training data that has been acquired during the use of the chromatograph process. Retraining may apply different weights to different subsets of the training data. For example, higher weights may be applied to more recent training data than to older training data or data that has been acquired prior to the use of the chromatography process. This may be advantageous in the context of recipe optimization in real time (e.g. model predictive control) where it can be beneficial to place emphasis on recent observations/cycles. Conversely, in the context of obtaining a more general model over the entire life of the column (and/or where the age of the column is taken into account as a parameter that is provided to the machine learning model), it can be more advantageous to place equal weights on different subsets of the training data. Applying weights to subsets of the training data can be achieved by weighting the loss function used to differently penalise departure from ground truth data in different subsets of the training data (e.g. penalising more severely errors in predictions for a subset of the training data than for another subset of the training data). Retraining of the machine learning model can be used in combination with the use of the error between simulated output data and corresponding measured data as an indicator of a problem in the process, e.g. to determine whether to repack the chromatography unit, whether to switch the feed to a different column in a multi-column chromatography process, or whether a fault or aging condition is present in the chromatography unit as will be explained further below. Indeed, the detection of the error between simulated output data and corresponding measured data exceeding a predetermined threshold can be used as an indicator of any of the above (i.e. to trigger any remedial action as identified above or detect a fault), while the retrained model can be used to predict the behaviour of the chromatography process if no such remedial action is taken (where a remedial action encompasses one or more of: repacking the chromatography unit, switching the feed to a different column in a multi-column chromatography process, and addressing a fault or aging condition in any other way than by repacking the chromatography unit).

In embodiments, training the machine learning model comprises iteratively updating weights of the machine learning model by:
for each of one or more training datasets each comprising latent variable values of the dimensionality reduction model corresponding to spectroscopy data obtained for an input flow, and latent variable values of the dimensionality reduction model corresponding to spectroscopy data obtained for an output flow and feed flow rate data for a chromatographic process corresponding to a plurality of time points during the chromatographic process, solving the bulk flow mass balance model using values of the parameters of the binding and diffusion terms predicted by the machine learning model at a preceding iteration of the training at discrete time intervals corresponding to plurality of time points from the training dataset, with feed rate trajectories corresponding to the feed flow rate data from the training dataset and latent variable values from the training dataset, thereby obtaining simulated data corresponding to each of the one or more training dataset;
evaluating a loss function quantifying the difference between the simulated data and the corresponding one or more training datasets; and
updating the weights of the machine learning model based on the weights of the machine learning model at the current iteration and the value of the loss function, optionally using a gradient descent procedure, until one or more predetermined stopping criteria are satisfied.

In embodiments, training the machine learning model comprises, at a first iteration of said iterative training, setting the weights of the machine learning model to initial weights that correspond to predetermined values of the parameters of the binding and diffusion terms,
optionally wherein setting the weights of the machine learning model to said initial weights comprises obtaining said predetermined values of the parameters of the binding and diffusion terms, setting the weights of the machine learning model to default values, and pretraining the machine learning model, wherein said pretraining comprises iteratively updating the weights of the machine learning model by: predicting, using the machine learning model, values of the parameters of the binding and diffusion terms using inputs to the machine learning model sampled from the training data,
evaluating a loss function quantifying the difference between the predicted values of the parameters of the binding and diffusion terms and the predetermined values of the parameters of the binding and diffusion terms; and
updating the weights of the machine learning model based on the weights of the machine learning model at the current pretraining iteration and the value of the loss function.

In embodiments, training the machine learning model comprises determining the predetermined values of the parameters of the binding and diffusion terms by performing one or both of:
(a) setting the values of the parameters of the diffusion terms and the parameters of the binding terms or corresponding parameters associated with corresponding non-linear binding terms, to respective default values,
   solving the bulk flow mass balance model by numerical integration using the default values of the parameters of the diffusion and binding terms and predetermined latent variable values of the dimensionality reduction model for the input flow and feed flow rate data, optionally wherein said predetermined latent variable values of the dimensionality reduction model for the input flow and said predetermined feed flow rate data are selected as the maximum values of the feed flow rate and latent variable values of the dimensionality reduction model for the input flow observed in the training data,
   determining whether the numerical integration was not able to calculated any of the solutions of the model, and
   when the numerical integration was not able to calculated any of the solutions of the model, updating the default values of the parameters of the binding and diffusion terms by reducing the default values by a predetermined factor;
   wherein the above steps are repeated until an iteration where the numerical integration was able to calculate all of the solutions of the model, and the values of the parameters of the binding and diffusion terms are selected as those used at said iteration;
(b) setting the values of the parameters of the diffusion terms and the parameters of the binding terms or corresponding parameters associated with corresponding non-linear binding terms to respective default values, optionally wherein said default values are obtained using a method of step (a),
   for each of one or more training datasets each comprising latent variable values of the dimensionality reduction model corresponding to spectroscopy data obtained for an input flow, latent variable values of the dimensionality reduction model corresponding to spectroscopy data obtained for an output flow and feed flow rate data for a chromatographic process corresponding to a plurality of time points during the chromatographic process, solving the bulk flow mass balance model using said default values of the parameters of the binding and diffusion terms thereby obtaining simulated data corresponding to each of the one or more training dataset;
   evaluating a loss function quantifying the difference between the simulated data and the corresponding one or more training datasets; and
   updating the default values of the parameters of the binding and diffusion terms based on the value of the loss function, optionally using a gradient descent procedure,
   wherein the above steps are repeated until one or more predetermined stopping criteria are satisfied. Steps (a) and (b) may be referred to as pretraining the machine learning model. These may be bypassed when previously trained weights are available for the machine learning model, such as e.g. when retraining the machine learning model.

In embodiments, solving the bulk flow mass balance model comprises:
(a) iteratively integrating the model over a plurality of discrete time intervals of predetermined duration, wherein at each iteration predictions for the parameters of the binding and diffusion terms are obtained for each of the discrete volume elements using the machine learning model and a current state vector comprising the latent variable values corresponding to the concentration of bound products in each discrete volume element at a latest iteration, the latent variable values corresponding to the concentrations of unbound products in each discrete volume element at the latest iteration, and optionally the concentrations of inerts in each discrete volume element at the latest iteration, and optionally the feed flow rate, identifying a discrete state-space model using the bulk flow mass balance model parameterised using said predictions, and determining an updated state vector for the time interval corresponding to the current iteration using the values of the current state vector and the coefficients of the discrete state-space model; and/or
(b) integrating the model for each of the one or more discrete volume elements at a plurality of discrete time points, thereby obtaining simulated data comprising the latent variable values corresponding to the concentration of the products in the effluent (output) of the chromatography unit at the plurality of discrete time points, and determining using said simulated data and an inverse dimensionality reduction model, spectroscopy data comprising one or more spectra for the effluent at one or more of the plurality of discrete time points.

The method may further comprise determining using said simulated data, one or more of: effluent product concentrations from one or more spectra obtained from the simulated data, spectroscopy data comprising one or more spectra for the effluent for a plurality of simulated fractions using the simulated data and a predetermined fractionation scheme, a product adsorption rate, a product desorption rate, a total captured amount of a product, a dynamic binding capacity of the chromatography process with respect to a product, a product binding capacity per cycle, a product percent recovery, a maximum breakthrough concentration with respect to a product, a maximum percent breakthrough with respect to a product, and costs associated with the simulated chromatography process. Any metrics that are associated with concentrations (such as e.g. a product adsorption rate, a product desorption rate, a total captured amount of a product, a dynamic binding capacity of the chromatography process with respect to a product, a product binding capacity per cycle, a product percent recovery, a maximum breakthrough concentration with respect to a product, a maximum percent breakthrough with respect to a product, and costs associated with the simulated chromatography process) can be obtained using any method known in the art to calculate these values from concentrations, using concentrations obtained from one or more spectra obtained from simulated data. Such concentrations can be obtained from synthetic spectra (i.e. spectra obtained from simulated data) or measured spectra using soft sensors (i.e. inference methods) that have been designed for this purpose. Soft sensors that can be applied to infer concentrations from e.g. Raman spectra are known in the art and are not the subject of the present disclosure, which is not limited in this regard. Further, such soft sensors can be trained outside of the context of chromatography and would not need to be trained contemporaneously with (or with the same data as) the chromatography model described herein.

In embodiments, the method comprises: (i) simulating a chromatography process using the method of any embodiment of the first aspect, using feed flow rate data corresponding to measured or planned feed flow rates of a chromatography process and latent variables values data for the feed flow of the chromatography process corresponding to measured feed spectroscopy data or spectroscopy data corresponding to planned feed concentrations of the chromatography process, thereby obtaining simulated effluent latent variable values corresponding to the effluent latent variable values of the chromatography process; and (ii) comparing the simulated effluent latent variable values or one or more metrics derived therefrom to observed effluent latent variable values or metrics derived therefrom, and determining whether to repack the chromatography unit based on the results of the comparing, whether to switch the feed to a different column in a multi-column chromatography process, or whether a fault or aging condition is present in the chromatography unit.

In embodiments, the method comprises: (i) simulating the chromatography process using a plurality of candidate sets of process parameters each comprising at least latent variables values data for the feed flow and a feed flow rate using the method of any embodiment of the first aspect, thereby obtaining simulated latent variables values data for the effluent flow for each candidate set of process parameters; and (ii) comparing the simulated latent variables values data for the effluent flow or one or more metrics derived therefrom to select a set of process parameters from the sets of candidate process parameters to use in operating the chromatography process.

Thus, also described according to the first or second aspects is a computer-implemented method of designing a chromatography process, the method comprising: simulating the chromatography process using a plurality of candidate sets of process parameters each comprising at least latent variables values data for the feed flow and a feed flow rate using the method of any embodiment above, thereby obtaining simulated latent variables values data for the effluent flow for each candidate set of process parameters; and comparing the latent variables values data for the effluent flows or one or more metrics derived therefrom (e.g. corresponding spectral data and/or concentrations derived therefrom) to select a set of process parameters from the sets of candidate process parameters. The candidate sets of process parameters can comprise the use of different chromatography technologies (e.g. different columns). The candidate sets of process parameters can comprise different stationary phases and simulating the chromatography process can comprise using respective machine learning models trained with respective training data acquired using the respective stationary phases. A single dimensionality reduction model trained with training data acquired using the different stationary phases may be used. Alternatively, respective dimensionality reduction models trained with training data acquired using the respective stationary phases may be used. The candidate process parameters can be compared using the simulated latent variables value data, or using concentrations or other metrics derived from this data. Indeed, it is possible to directly use the latent variables values (e.g. PCA scores), and specifically the latent variable values for a latent variable that can be expected to correspond to a product of interest. This is likely to be the latent variable values for the first latent variables (where the first latent variable is the latent variable that captures the largest amount of variation in the data, e.g. PC1 of a PCA). This essentially assumes that the values of this latent variable correspond to the product, which is likely to be a valid assumption in many cases, especially when the training data comprises data obtained by loading the chromatography unit to breakthrough with the product of interest, and the column has a high selectivity for product (as in this case the bulk of the variability in the training data, which will be reflected in the selected latent variable and its loadings) would correspond to the product of interest. In short, when designing a recipe, the primary concern is normally to manage breakthrough, and this can be assessed using the latent variable values (most simply, the values for the latent variable that captures the largest variability in the training data, e.g. t1 scores for PC1 in a PCA) and manipulating the recipe to meet objectives (typically around column utilization). The same reasoning applies to any method described herein, i.e. latent variable values, and specifically the latent variable capturing the largest variability in the training data, can typically be used directly and assumed to be representative of the behaviour of the chromatography process with respect to a product of interest.

The candidate sets of process parameters can comprise the use of different numbers of columns connected in series or in parallel. The candidate sets of process parameters can comprise the use of different numbers of columns connected in series. Such methods can find uses in many different contexts. For example, the methods can find use in the context of designing a multi-column chromatography process. The methods of the present disclosure are particularly advantageous in such cases because the same models are applicable to single and multi-column settings, and the models can be run efficiently (i.e, rapidly) over many different sets of process parameters. Further, the methods of the present disclosure are particularly advantageous in that multi-column processes can be simulated using models that have been trained exclusively or mostly on batch (i.e. single column) training data. As another example, the methods can find use in the context of process design for scaling up, for example for predicting binding capacities at large scale from small scale trials. Indeed, the methods of the present disclosure are particularly advantageous in that they are independent of scale, i.e. large-scale processes can be simulated using models that have been trained on training data from different scales.

Also described according to the first or second aspects is a method of monitoring a chromatography process, the method comprising: simulating the chromatography process using the method of any embodiment above and feed latent variables data for a feed flow and feed flow rate data corresponding to the measured or planned feed(s) and feed flow rate(s) of the chromatography process, thereby obtaining simulated latent variables values data for the effluent flow of the chromatography process corresponding to spectral data for the effluent flow of the chromatography process; and comparing the simulated latent variables values data for the effluent flow or one or more metrics derived therefrom (e.g. the corresponding spectral data or parts thereof) to observed latent variables values for the effluent flow or metrics derived therefrom (or from which they were obtained, such as the spectral data), wherein the comparison is indicative of the presence of a fault or aging condition of the chromatography unit.

Also described according to the first or second aspects is a method of controlling a chromatography process, the method comprising: (a) simulating a chromatography process using the method of any embodiment above and latent variables values data for the feed flow and feed flow rate data corresponding to the measured or planned feed(s) and feed flow rate(s) of the chromatography process, thereby obtaining simulated latent variables values data for the effluent corresponding to spectral data for the effluent flow of the chromatography process; and comparing the simulated latent variables values data for the effluent or one or more metrics derived therefrom to observed latent variables values data for the effluent or metrics derived therefrom (or from which they were obtained, such as the spectral data), and determining whether to repack the chromatography unit based on the results of the comparing or whether to switch the feed to a different column in a multi-column chromatography process; and/or (b) simulating the chromatography process using a plurality of candidate sets of process parameters each comprising at least latent variables values data for the feed flow and a feed flow rate using the method of embodiment of the first aspect, thereby obtaining simulated latent variables values data for the effluent for each candidate set of process parameters, and comparing the simulated latent variables values data for the effluent or one or more metrics derived therefrom (e.g. corresponding spectral data) to select a set of process parameters from the sets of candidate process parameters to use in operating the chromatography process. The candidate sets of process parameters may comprise spectral data or corresponding latent variable values corresponding to an expected feed product concentration or feed flow.

Also described according to a third aspect is a computer-implemented method of obtaining a trained model for simulating a chromatography process whereby a feed flow comprising one or more products is passing through a chromatography unit comprising a stationary phase that the one or more products interact with, the method comprising: obtaining training data comprising latent variable values of a dimensionality reduction model obtained from training data comprising spectroscopy data obtained at a plurality of sampling times of input and output flows of a plurality of chromatography processes; and training a machine learning model to take inputs comprising the latent variable values corresponding to the concentration of the bound and unbound fractions of the one or more products in a discrete volume element and produce as output a prediction of parameters of binding and diffusion terms of a bulk flow mass balance model of the chromatography unit;
wherein said training comprises solving the bulk flow mass balance model over one or more discrete volume elements along the chromatography unit by numerical integration; wherein the bulk flow mass balance model is an ordinary differential equations model that represents the change in concentration of bound and unbound fractions of the one or more products in a discrete volume element, wherein the concentration of bound and unbound fractions of the one or more products are expressed as the latent variables values of the dimensionality reduction model; wherein the ordinary differential equations model comprises binding and diffusion terms, wherein a binding term captures the binding of a product to the stationary phase and a diffusion term captures the diffusion of a bound product.

Methods of the third aspect can have any of the features described in relation to any preceding aspect. For example, the method may further comprise obtaining the dimensionality reduction model using training data as described herein. Training the machine learning model and/or the dimensionality reduction model may be performed as described herein, such as e.g. as described in relation to embodiments of the first and second aspects.

All of the steps of the methods described herein are computer implemented unless context indicates otherwise. In particular, any of the steps of the present method may be implemented by a computing device, optionally in operable communication with one or more sensors, one or more chromatographic processes (e.g. each a single or multi-column chromatography unit), other computing devices and/or user interfaces.

According to a further aspect, there is provided a system including: at least one processor; and at least one non-transitory computer readable medium containing instructions that, when executed by the at least one processor, cause the at least one processor to perform operations comprising the steps of any method of any preceding aspect. In particular, the at least one non-transitory computer readable medium may contain instructions that, when executed by the at least one processor, cause the at least one processor to perform operations comprising any of the operations described in relation to the first, second and/or third aspects. The system can further comprise one or more of: a chromatography unit, one or more sensors and a user interface. The processor may implement a chromatography unit controller. In other words, the methods of the present disclosure may be implemented as part of a chromatography control platform, which may form part of a chromatography apparatus. Thus, also described herein is a chromatography apparatus comprising a chromatography unit and a processor configured to implement the methods of any aspect of the disclosure.

According to a further aspect, there is provided a non-transitory computer readable medium comprising instructions that, when executed by at least one processor, cause the at least one processor to perform the method of any embodiment of any aspect described herein.

According to a further aspect, there is provided a computer program comprising code which, when the code is executed on a computer, causes the computer to perform the method of any embodiment of any aspect described herein.

### Brief Description of the Drawings

Embodiments of the present disclosure will now be described by way of example with reference to the accompanying drawings in which:
**Figure 1** shows a simplified process diagram for a system in which embodiments of the present disclosure can be used.
**Figure 2** illustrates schematically (A) a method of simulating a chromatographic process according to embodiments of the present disclosure, and (B) method of obtaining a trained machine learning model according to embodiments of the present disclosure.
**Figure 3** illustrates schematically components used in a method of simulating a chromatographic process and/or obtaining a trained machine learning model according to the present disclosure.
**Figure 4** illustrates schematically a method of monitoring a chromatographic process, a method of optimising a chromatographic process, and a method of controlling a chromatographic process according to embodiments of the disclosure.
**Figure 5** illustrates schematically a system according to embodiments of the present disclosure.
**Figure 6** illustrates schematically a discretisation scheme used to describe a chromatographic process according to embodiments of the disclosure.
**Figure 7** illustrates schematically a machine learning model structure used to parameterise a mass balance model according to embodiments of the disclosure.
**Figure 8 A-B** illustrate schematically a method of training a machine learning model according to embodiments of the disclosure.

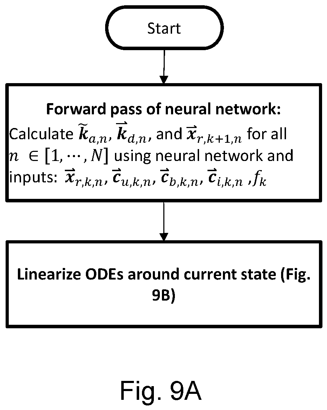

**Figures 9A-B** illustrate schematically a method of simulating a chromatographic process according to embodiments of the disclosure (**A**: flow chart illustrating the process used and **B:** mass balance model equations used - note that each of B-1 to B-3 show the same system of equations at the top, with the states of the system in vector form, and develops the terms of the A and B matrices for the states vector corresponding to the concentration of unbound products (B-1), bound products (B-2) and inerts (B-3) along the differential volume elements 1 to n; B-4 combines the information in B-1 to B-3).

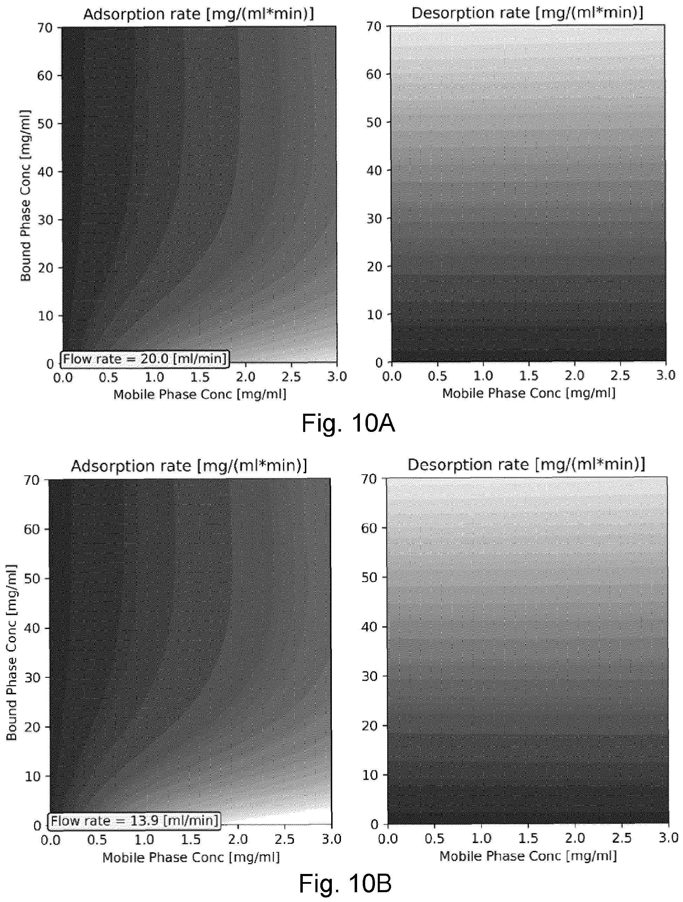

**Figure 10A-D** show the results of a simulation of a chromatographic process using methods described herein with varying values of the flow rate through the chromatographic process (**A**: flow rate=20 ml/min, B: flow rate=13.9 ml/min, **C:** flow rate=5.9 ml/min, **D:** flow rate=1.8 ml/min). Left in each subfigure shows the calculated adsorption rate for different bound phase concentrations and mobile phase concentrations, and right shows the calculated desorption rate for different bound phase concentrations and mobile phase concentrations. The data shown simulates the binding phase of a chromatography process, which is why differences are primarily visible in the calculated adsorption rate. However, the methods described herein are equally applicable to simulation of the elution phase of a chromatography process, where differences between operational settings would be more apparent in the calculated desorption rate.
**Figure 11** shows representative model prediction performance for both training data (i.e. data used to identify model parameters) and validation data unseen by the training algorithm. Scatter points (filled circles) in this figure represent experimental measurements of product concentration at column outlet (monoclonal antibody titer in mg/ml) while solid lines represent corresponding model predictions. Examples are shown for three different feed-flow rates used as training data and two feed-flow rates used as validation cases.
**Figure 12** shows an example of a user interface for accessing a method of the disclosure.

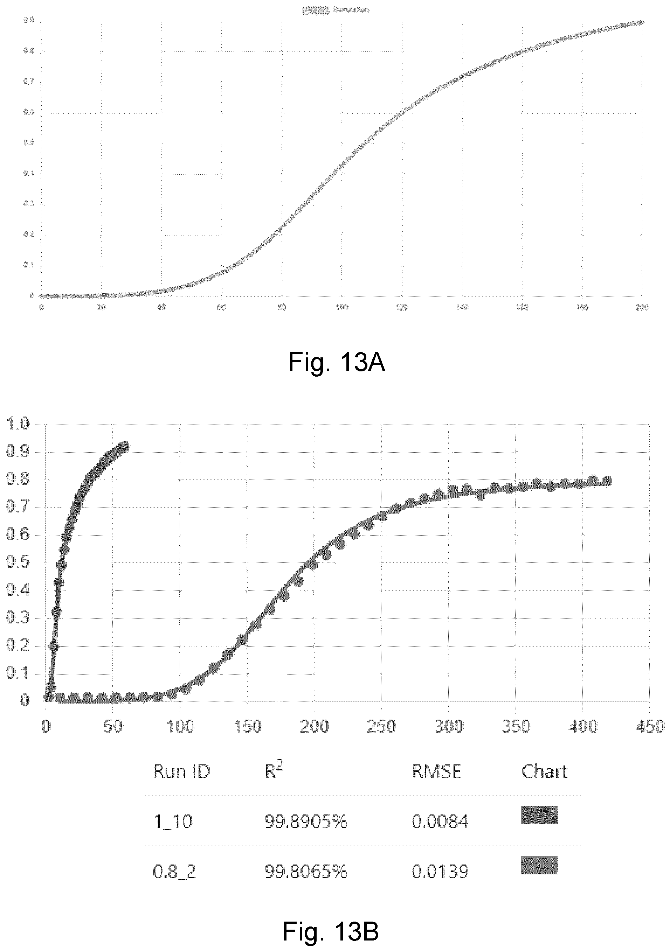

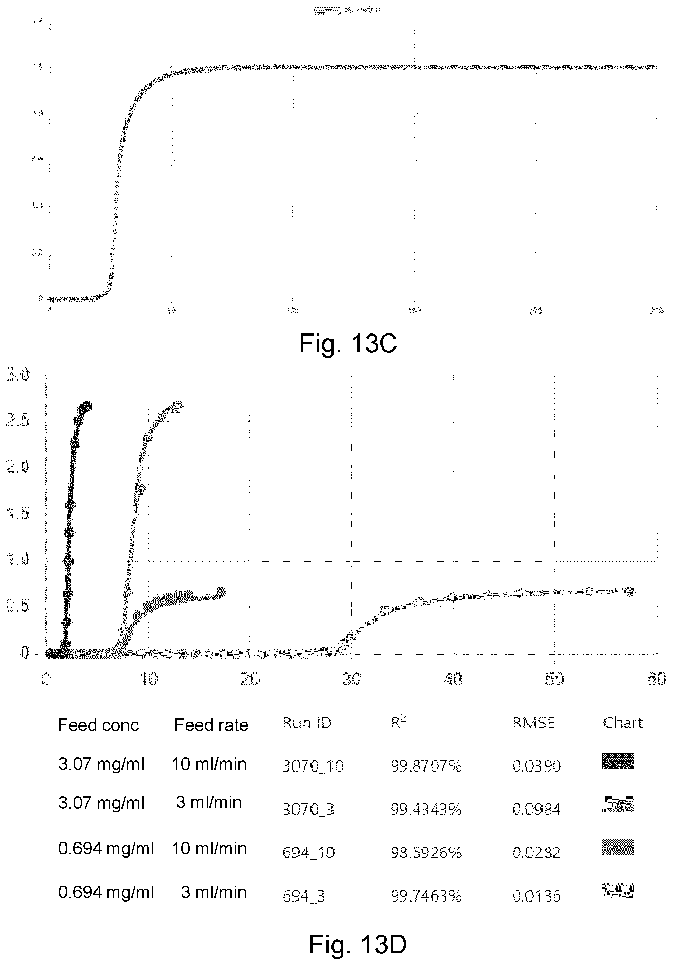

**Figure 13** shows examples results of a simulation method of the disclosure applied to the purification of protein A using the same operating parameters (feed rate=2.5 ml/min, feed concentration=1 mg/ml, simulation duration=200 minutes, breakthrough threshold %=5) but using two different protein A chromatography systems, (**A-B**) a MabSelect^{™} SuRe chromatography resin from Cytiva(calculated breakthrough time=53.77 min, calculated dynamic binding capacity=134.42 mg/ml) and (**C-D**) a Sartobind^{®} Rapid A Membrane from Sartorius Stedim Biotech GmbH (calculated breakthrough time=24.10 min, calculated dynamic binding capacity=50.20mg/ml); A and C show the results of the simulation, and B and D show model validation data (from experiments at different feeding rates and feed concentrations to demonstrate the validity of the model predictions) and associated R² and RMSE between predicted (continuous lines) and observed (points) breakthrough curves; each model was trained using real data (4 experimentally obtained breakthrough curves) using the respective substrates and columns; each plot shows breakthrough curves, i.e. product concentration in the effluent (mg/ml) as a function of time (minutes).
**Figure 14** shows an example of the use of a method described herein for economic modeling and/or optimization of a chromatography process; the heatmaps show the profit associated with running a chromatographic process with the indicated values of titer and flow rate (model used to generate the results on Figure 13), using either a MabSelect^{™} (**A**) or a Sartobind^{®} Rapid A Membrane (B) chromatography column.
**Figure 15** shows an example of the use of a method described herein for column scale up prediction.
**Figure 16** shows the set-up of an exhaustive assessment of methods of the present disclosure using data generated with a numerically evaluated general rate model.

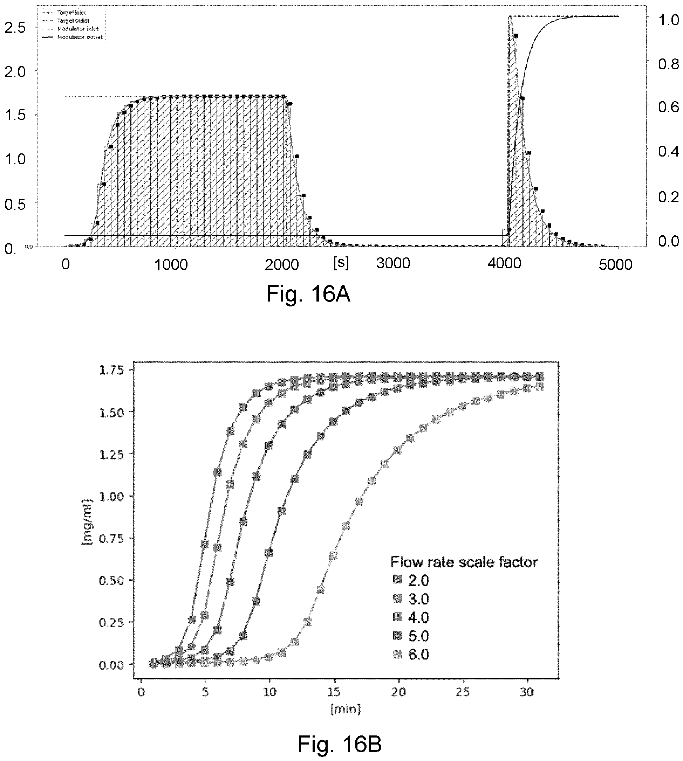

   **Fig. 16A** shows an example of full synthetic data from the general rate model showing the target mobile phase concentration at the inlet (dashed red), the target mobile phase concentration at the outlet (solid red), the modulator mobile phase concentration at the inlet (dashed black) and the modulator mobile phase concentration at the outlet (solid black), where target indicates the mobile phase concentration of a target molecule which we want to separate and modulator is the mobile phase concentration of some buffer solution that has the effect of negating the binding effect of the target molecule to the solid phase hence causing the target molecule to elute. The figure also shows how the data in A is used to generate synthetic fraction point measurements of target mobile phase concentration (black squares) by integrating over time periods of the synthetic data.
   **Fig. 16B** shows simulated data (points) from the numerically evaluated general rate model used for training and validation of a model of the present disclosure, and corresponding predictions from the trained model of the present disclosure. For each experiment the model was trained on four timeseries and validated on a final series. The plot shows an example set of training and validation data (CADET simulated breakthrough curves) from one experiment.
**Figure 17** shows results of the assessment described by reference to Figure 16. Each figures show simulation results from a method as described herein (crosses and dashed lines) and corresponding data from a mechanical simulation used for training (left) and validation (right) (squares and continuous lines).
   **Fig. 17A** shows an exemplary result with validation loss=0.1.
   **Fig. 17B** shows an exemplary result with validation loss= 4.4·10-3 (recall median 4.3·10-3).
**Figure 18** illustrates schematically simplified chromatography process diagrams for systems in which embodiments of the present disclosure can be used. The chromatography processed may be implemented as downstream process 12 of Figure 1.
   **Fig. 18A** shows a simplified process diagram for a single column system.
   **Fig. 18B** shows a simplified process diagram for a multi-column system.
**Figure 19** shows schematically a spectral data matrix and process for obtaining spectral data-derived scores for training of a chromatography model.
**Figure 20** shows a flow diagram illustrating schematically a process of training a chromatography model using spectral data-derived scores.
**Figure 21** shows the set up for chromatography experiments run on the Resolute^{®} BioSC Platform.
**Figure 22** shows exemplary Raman spectra from a proof-of-concept experiment.
   **Fig. 22A** shows raw spectra during different phases of the chromatography process.
   **Fig. 22B** shows raw spectra at different stages of chromatography, in the same phase.
**Figure 23** shows latent "score" values of Raman spectra obtained over an exemplary chromatography experiment, colored by the phase of the experiment, plotted as scatterplots along pairs of principal components.
   **Fig. 23A** shows PCA latent scores of observed Raman spectra along the first and second principal components (x and y axes, respectively).
   **Fig. 23B** shows PCA latent scores of observed Raman spectra along the first and third principal components (x and y axes, respectively).
   **Fig. 23C** shows PCA latent scores of observed Raman spectra along the second and third principal components (x and y axes, respectively).
**Figure 24** shows latent "score" values of Raman spectra obtained over an exemplary chromatography experiment, colored by the phase of the experiment, plotted as time courses over the course of the experiment, individually for each of principal components (PC) 1 to 4.
   **Fig. 24A** shows a time course of PCA scores of Raman spectra along the first PC.
   **Fig. 24B** shows a time course of PCA scores of Raman spectra along the second PC.
   **Fig. 24C** shows a time course of PCA scores of Raman spectra along the third PC.
   **Fig. 24D** shows a time course of PCA scores of Raman spectra along the fourth PC.
**Figure 25** shows loading plots for the first to fourth principal components (loadings of each principal component at each Raman wavelength in the input data).
   **Fig. 25A** shows the loadings of the first PC.
   **Fig. 25B** shows the loadings of the second PC.
   **Fig. 25C** shows the loadings of the third PC.
   **Fig. 25D** shows the loadings of the fourth PC.

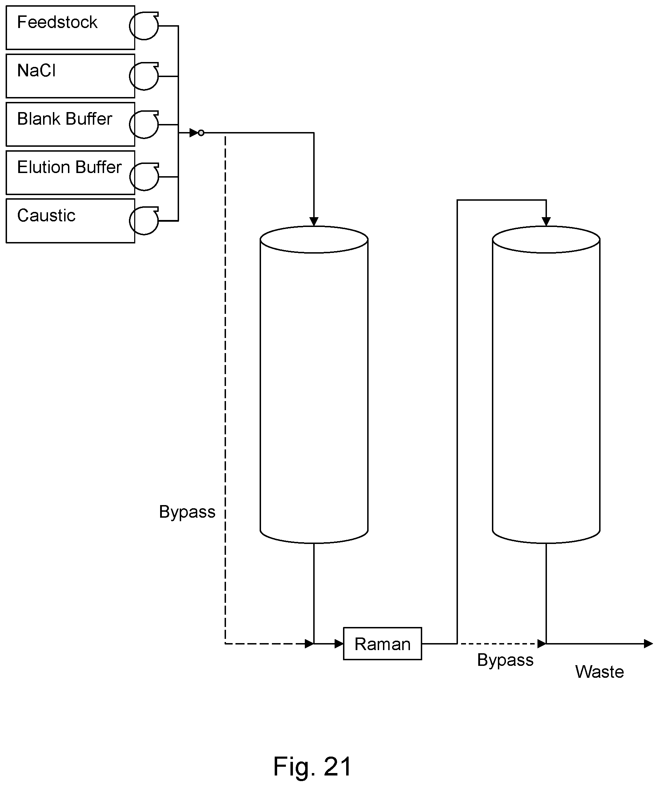

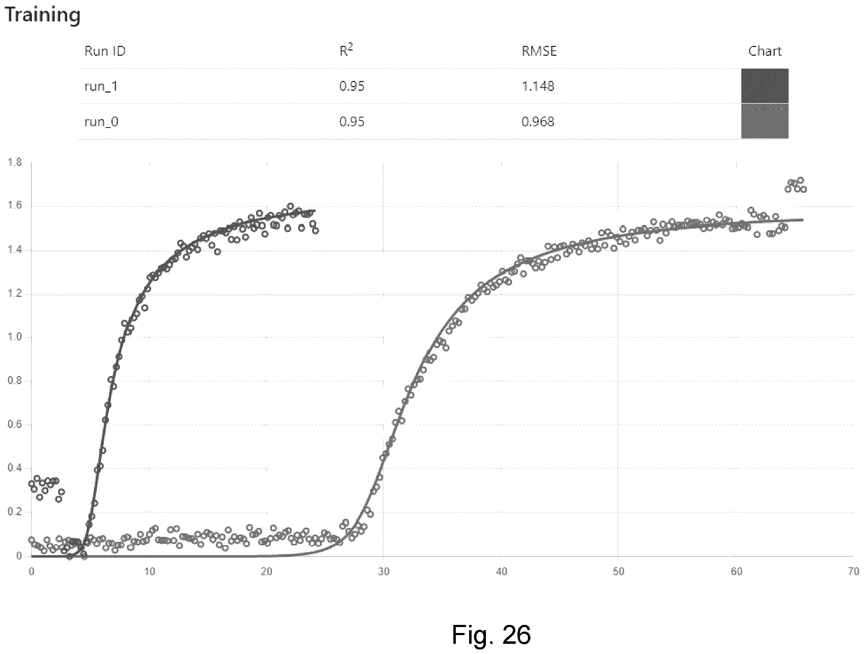

**Figure 26** shows the results of training of a hybrid chromatography model directly from spectral data (data on Figures 21-24) for two runs: run 0 used a flow rate of 0.6 ml/min with a feed concentration of 1.55 mg/ml lysozyme, run1 used a flow rate of 2 ml/min with a feed concentration of 2.0 mg/ml lysozyme. Individual points show scores for the first principal component for measured Raman spectra as a function of time in the chromatography process at which the measurements were taken (x-axis, expressed in sampling intervals). Lines show the corresponding model predictions. The R² between model predictions and measurements was 0.95 for both runs, indicating excellent prediction accuracy.

Where the figures laid out herein illustrate embodiments of the present invention, these should not be construed as limiting to the scope of the invention. Where appropriate, like reference numerals will be used in different figures to relate to the same structural features of the illustrated embodiments.

### Detailed Description

Specific embodiments of the invention will be described below with reference to the figures.

The present disclosure describes new methods of simulating a chromatographic process and methods that make use of such simulations for process design, control, monitoring and optimisation.

A "chromatographic process" refers to any process that makes use of liquid chromatography, particularly in the context of purifying one or more products present in a feed solution. A chromatographic process is typically performed in a chromatography unit comprising one or more individual chromatography columns. Each column comprises a stationary phase (e.g. resin, membrane, monoliths), and a mobile phase. The methods of the present disclosure are not limited in any way in terms of the geometry of the column(s), organisation of multiple columns (e.g. connection of multiple columns in series), type of stationary or mobile phase. Liquid chromatography is typically used to purify one or more molecules, compounds or particles of interest (collectively referred to as "products" or "bioproducts" by reference to the fact that chromatography is commonly use in the purification of products of bioprocesses). The products can be proteins or particles such as viral particles. Purification of products is performed by loading the product(s) onto the column buy flowing a feed liquid comprising the product(s) through the column, where the products interact with the stationary phase and are immobilised thereon (where they are referred to as "bound product"). When the column has been loaded with product(s), the column is typically washed, and then a buffer solution is flowed through the column in an elution phase, where the buffer is chosen such that the affinity of products to the stationary phase is reduced and the products are eluted out of the column. The outcoming flow of a chromatography column can be referred to as "effluent", whether in the loading or elution phase. The methods described herein are applicable to simulate any part of the chromatography process, provided that training data for the corresponding phase is used to train the machine learning model as will be described further below. For example, the methods described herein can be used to simulate the loading phase of a chromatography process (e.g. to obtain simulated breakthrough curves and metrics derived therefrom), using a machine learning model trained using training data comprising loading phase data (e.g. breakthrough curves). As another example, the methods described herein can be used to simulate the loading and elution phases of a chromatography process, using respective machine learning models trained using training data comprising loading phase data and elution phase data, respectively. The wash phase can be ignored or can also be simulated using a machine learning model trained using training data comprising wash phase data. Note that the same machine learning model can be used to simulate multiple phases (such as e.g. complete cycles comprising load, wash, elute and regeneration, or parts thereof such as e.g. just a load-wash-elute process) provided that the machine learning model was trained using training data comprising the multiple phases modelled.

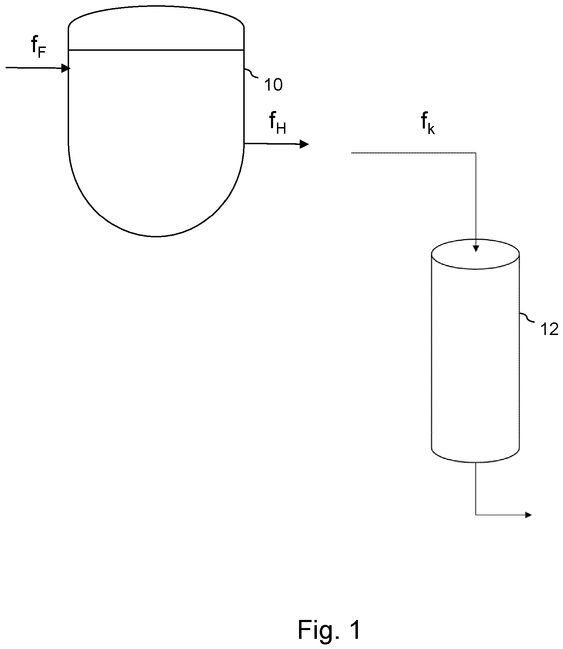

**Figure 1** shows a simplified process diagram for a system in which embodiments of the present disclosure can be used. The bioprocess comprises an upstream process 10 in which a product is being produced, here illustrated as a bioreactor 10. In embodiments where the bioreactor is operated as a perfusion process, as illustrated, permeate (also referred to as "harvest flow" or "harvest stream") is obtained from the bioreactor with a flow rate f_{H}. The bioreactor 10 can also be fed with a flow rate f_{F}. The permeate is typically the primary output of the upstream process, comprising the one or more products of interest. The permeate typically comprises bulk culture that has been subject to a cell separation step. In such embodiments the output of the upstream process 10 can be continuously processed in a downstream process 12. In other embodiments the process may be operated as a batch process a continuous harvest flow is not present and the product of the upstream process is processed after completion of the upstream process. The methods of the present disclosure are independent of the way in which the upstream process is run, or even the type of upstream process used. The illustrated embodiment only provides context for a typical use of chromatographic processes in which the methods of the disclosure can be deployed. The downstream process 12 comprises a chromatography unit, here illustrated as a single chromatography column although multiple columns in parallel or in series may in fact be used. A chromatography unit can include one or more chromatography columns and a flow control system. The chromatography unit receives an input feed (also referred to herein as "input" or "feed") with flow rate fₖ. The chromatography unit produces an output feed (also referred to herein as "output" or "effluent") with flow rate fₖ, where the output feed has a different concentration of the one or more products of interest. The input feed can be obtained directly from the upstream process, i.e. in the case of a perfusion process the input feed of the chromatography unit can be directly linked to (or equal) to the harvest flow of the upstream process. According to the present disclosure, the feed flow (input) of a chromatography process may have been obtained directly from an upstream process. Thus, the feed flow may comprise a cell culture harvest stream. The cell culture harvest stream may have been filtered at harvest time.

As used herein, the term "bioprocess" (also referred to herein as "biomanufacturing process") refers to a process where biological components such as cells, parts thereof such as organelles or multicellular structures such as organoids or spheroids are maintained in a liquid medium in an artificial environment such as a bioreactor. In the context of the present disclosure, a bioprocess typically refers to a cell culture. A bioprocess typically results in a product, which can include biomass and/or one or more compounds that are produced as a result of the activity of the biological components. For example, live cells can be cultured to a desired cell density then used in a fermentation process to produce one or more desired products in a bioreactor. This is typically referred to as "upstream process" (USP). The one or more desired products may be extracted from the cells or the culture medium in a downstream process (DSP). A downstream process may comprise one or more steps, such as separation and/or purification steps. A bioreactor can be a single-use vessel or a multi-use vessel in which a liquid medium suitable for carrying out a bioprocess can be contained. For example, a bioreactor may be chosen from: multi-parallel single-use bioreactors (such as e.g. Ambr^{®} 250 or Ambr^{®} 15 bioreactors from The Automation Partnership Ltd.), single use bag-based bioreactors (e.g. such as Biostat^{®} STR bioreactors from Sartorius Stedim Biotech GmbH, available in 50 to 2000L capacity for process development up to commercial manufacturing), stainless steel bioreactors (such as e.g. Biostat^{®} D-DCU bioreactors available in capacities from 10 to 200L or Biostat^{®} Cplus available in capacities from 5 to 30L, all from Sartorius Stedim Systems GmbH), benchtop systems (such as e.g. Biostat^{®} B and Biostat^{®} B-DCU from Sartorius Stedim Systems GmbH, which support either 2L single-use rigid wall vessel or 1, 2, 5 and 10L glass vessels, like Univessel^{®} SU in capacity of 2L and Univessel^{®} Glass available in capacities from 2 to 10L, all from Sartorius Stedim Biotech GmbH), etc. The present invention is applicable in the context of downstream processes associated with upstream processes in any type of bioreactor and in particular in bioreactors from any vendor and at any scale from benchtop systems to manufacturing scale systems.

A cell culture refers to a bioprocess whereby live cells are maintained in an artificial environment such as a bioreactor. The methods, tools and systems described herein are applicable to bioprocesses that use any types of cells that can be maintained in culture, whether eukaryotic or prokaryotic. The invention can in particular be used to monitor and/or control bioprocesses using cells types including but not limited to mammalian cells (such as Chinese hamster ovary (CHO) cells, human embryonic kidney (HEK) cells, Vero cells, etc.), non-mammalian animal cells (such as e.g. chicken embryo fibroblast (CEF) cells), insect cells (such as e.g. *D. melanogaster cells, B. mori* cells, etc.), animal cells of any cell type (such as e.g. induced pluripotent stem cells (iPSCs), stem cells such as e.g. mesenchymal stem cells, immune cells such as T cells and natural killer cells), bacterial cells (such as e.g. *E. coli* cells), fungal (e.g. yeast) cells (such as e.g. *S*. *cerevisiae* cells), and plant cells (such as e.g. *A. thaliana* cells). A bioprocess typically results in the production of a product, which can be the cells themselves (e.g. a cell population for use in further bioprocesses, a cell population for use in cell therapy, a cell population for use as a product such as a probiotic, feedstock, etc.), a macromolecule or macromolecular structure such as a protein, peptide, nucleic acid or viral particle (e.g. a monoclonal antibody, immunogenic protein or peptide, a viral or non-viral vector for gene therapy, enzymes such as e.g. for use in the food industry, for environmental applications such as water purification, decontamination, etc.), or a small molecule (e.g. alcohols, sugars, amino acids, etc.).

When the product comprises a macromolecule or macromolecular structure such as a protein, peptide, nucleic acid or viral particle, the downstream process typically comprises at least one chromatographic separation step, i.e. a chromatographic process. The present disclosure provides methods that apply to such processes. The methods of the present disclosure are applicable to any chromatographic process, including those performed on single and multi-column platforms of any scale (including but not limited to e.g. the Resolute^{®} BioSC Platform and the Resolute^{®} BioSMB Platform from Sartorius Stedim Chromatography Systems Ltd.), those performed using any chromatographic stationary phase known in the art such as resins, membranes, and monoliths, and those performed for separation of any types of analytes including proteins (e.g. protein A, antibodies and fragments thereof including e.g. monoclonal antibodies, enzymes), viral particles, small molecules (e.g. metabolites), etc.

A product of a bioprocess (also referred to herein as "biomaterial" or "target biologic") may include a metabolite, a cell, a desired protein, an antibody, an immunoglobulin, a toxin, one or more by-products, a target molecule, or any other type of molecule manufactured using a bioprocess. There may be more than one biomaterial (product) of interest. Products of a bioprocess may have one or more critical quality attributes (CQAs). As used herein, a "critical quality attribute" is any property of a product (including in particular any chemical, physical, biological and microbiological property) that can be defined and measured to characterise the quality of a product. The quality characteristics of a product (in terms of the values of one or more CQAs) may be defined to ensure that the safety and efficacy of a product is maintained within predetermined boundaries. The term "metabolite" refers to any molecule that is consumed or produced by a cell in a bioprocess. Metabolites include in particular nutrients such as e.g. glucose, amino acids etc., by-products such as e.g. lactate and ammonia, desired products such as e.g. recombinant proteins or peptides, complex molecules that participate in biomass production such as e.g. lipids and nucleic acids, as well as any other molecules such as oxygen (O₂) that are consumed or produced by the cell. Depending on the particular situation, the same molecule may be considered a nutrient, a by-product or a desired product, and this may even change as a bioprocess is operated. However, all molecules that take part in cellular metabolism (whether as an input or output of reactions performed by the cellular machinery) are referred to herein as "metabolites". In particular, metabolites may include any suitable analyte, including but not limited to: amino acids (e.g., alanine, arginine, aspartic acid, asparagine, cysteine, cysteine, glutamic acid, glutamine, glycine, histidine, hydroxyproline, isoleucine, leucine, lysine, methionine, phenylalanine, proline, serine, threonine, tryptophan, tyrosine, valine, etc.), saccharides (e.g., fucose, galactose, glucose, glucose-1-phosphate, lactose, mannose, raffinose, sucrose, xylose, etc.), organic acids (e.g., acetic acid, butyric and 2-hydroxy- butyric acids, 3-hydroxybutyric acid, citric acid, formic acid, fumaric acid, isovaleric acid, lactic acid, maleic acid, propionic acid, pyruvic acid, succinic acid, etc.), other organic compounds (e.g., acetone, ethanol, pyroglutamic acid, etc.).

The term "spectroscopy data" (also referred to herein as "spectral data") refers to spectra obtained using any spectroscopy technology (also referred to as spectroscopy) from which information about the composition of chromatography flows can be obtained. The spectroscopy is typically a spectroscopy that is based on electromagnetic radiations. The spectroscopy technology may include any one or more of: Raman spectroscopy, UV spectroscopy, infrared spectroscopy (e.g. near infrared spectroscopy, NIR), and fluorescence spectroscopy. It is advantageous according to embodiment of the present disclosure for the spectroscopy technology to be one that can be used inline in a chromatography process. Indeed, this means that spectroscopy data can be collected that can capture dynamics of a chromatography process at low cost and without delays associated with sample collection and analysis. Advantageously, UV and/or Raman spectroscopy may be used. The combination of UV and Raman is particularly advantageous as the two measurement technologies have different sensitivity and specificity properties and therefore provide complementary information. The spectroscopy data may include at least Raman spectroscopy data.

The term "dimensionality reduction model" refers to any statistical model that can take an input data set and transform it into an output dataset of lower dimensionality that captures relevant variability in the input dataset. The lower dimensionality values are referred to herein as latent variable values (or "scores"). A dimensionality reduction model may be a model that applies an affine transformation to input data, or a linear model, such as e.g. a principal component analysis model or a linear autoencoder. An autoencoder is a type of neural network that is trained to learn a lower dimensionality representation of input data from which the input data can be reconstructed. The dimensionality reduction model may be a nonlinear model, such as a t-distributed stochastic neighbor embedding (t-SNE) model, a uniform manifold approximation and projection (UMAP) model, or a non-linear autoencoder. Affine or linear models such as PCA (principal component analysis) and PLS (partial least square regression) may be particularly advantageous due to their simplicity, and because they faithfully capture the underlying assumption that concentrations in a mass balance model can be represented by the latent variable values of such a dimensionality reduction model. Affine or linear models may be applicable in any situation in which the concentrations of one or more products of interest are believed to be linearly related to spectroscopy data. This is likely to be the case e.g. for Raman and UV spectroscopy data provided that it has been acquired with a well calibrated device (where device calibration is known in the art and within the capabilities of the skilled person). Without wishing to be bound by theory, the present inventors believe that nonlinearities in the measurement technology can be accounted for in the dimensionality reduction model (e.g. by increasing the number of latent variables, i.e. the dimension of the latent representation of the input data). Therefore, the present methods are robust to the presence of nonlinearities between spectroscopy data and concentrations.

In embodiments, the dimensionality reduction model has been previously obtained from training data comprising spectroscopy data obtained at a plurality of sampling times of input and output flows of one or more chromatography processes. In embodiments, the one or more chromatography processes are chromatography processes using a feed flow that has a composition representative of the feed flow of the simulated chromatography process. In embodiments, the training data further comprises spectroscopy data obtained from offline samples comprising one or more species of interest. In embodiments, the training data further comprises one or more species concentrations measured in samples associated with any one or more of the spectroscopy data. The dimensionality reduction model may have been trained using spectroscopy data (and optionally corresponding measured concentrations - together referred to as "training data") for samples expected to comprise or be likely to comprise one or more products. This can include e.g. inlet flows (specifically feed flows), outlet flows, waste flows, and offline samples known or expected to comprise one or more products. The term "samples" refers to solutions from which data is acquired, which can be inline rather than requiring a physical sampling step from a flow. The data used to train the dimensionality reduction model may not include training data associated with samples that only contain inert species. This is optional as data for samples comprising only inert species can be accommodated, and these species can also be represented in the ordinary differential equations model using latent variable values of the model, but this can make the training of the machine learning model more challenging and is therefore not recommended.

The expression "one or more chromatography processes" in the context of training data refers to one or more individual runs of a respective chromatography process, where the chromatography process may be the same or different between the individual runs (such as e.g. using different flow rates, inlet product concentrations, column configurations, etc.). The term "output flow" includes at least the product output flow. The output flows can further include a waste output flow, if present. This is completely optional, and it may not be present, measured by spectroscopy, or have such measurements used to train the dimensionality reduction model. However, if spectroscopy data is available for a waste flow of the chromatography process (or any other flow) then it is advantageous to include it in the training data used to train the dimensionality reduction model. Thus, the dimensionality reduction model may have been previously obtained from training data comprising spectroscopy data obtained at a plurality of sampling times at a plurality of flow locations of one or more chromatography processes. The flow locations can advantageously include at least the input flow (i.e. inlet flow, comprising the feed flow in the loading phase) and the output flow (i.e. product outlet). A feed flow that has a composition representative of the feed flow of the simulated chromatography process may be a feed flow expected to comprise the same one or more products, or a feed flow representative of expected normal operation for the process. The term "offline samples" refers in this context to samples that are not obtained by sampling a fluid line that goes into or comes out of a chromatography process. This is by contrast to the data that is obtained for a plurality of sampling times of flows into and/or out of the chromatography process. Note that these are advantageously online samples in that the spectroscopy data is obtained using in line probes associated with these flows. However, there is no strict requirement for these data to be obtained from inline probes. It is simply beneficial and more practical for it to be the case as this means that higher sampling frequencies can be achieved. The one or more offline samples can comprise one or more species of interest, such as e.g. one or more products to be separated and/or one or more impurities (together referred to as "products", encompassing all species expected to interact with the stationary phase of the chromatography process). The one or more offline samples can be selected from samples of the feed flow, samples of the input flow, samples of the output flow, samples of the waste flow or samples that are not obtained from any of the flows the chromatography process. For example, the offline samples can comprise synthetic samples comprising one or more species at predetermined concentrations that may be higher or lower than expected in any one or more of the flows of the chromatography process. Spectroscopy data for these samples can be included in the data used to train the model thereby increasing the sensitivity of the resulting model to the presence and/or variations in concentrations of these species.

The spectroscopy data used to train the dimensionality reduction model (And generally any spectroscopy data used in any method described herein) may have been pre-processed prior to obtaining the dimensionality reduction model. For example, Raman spectroscopy data may be corrected for scattering and/or baseline drift (e.g. using known methods such as asymmetric least-squares for Raman baseline correction, etc.). Any spectroscopy data (and any optional concentration data) may be normalised, smoothed, scaled, denoised and/or baseline corrected, prior to being used in the methods described herein.

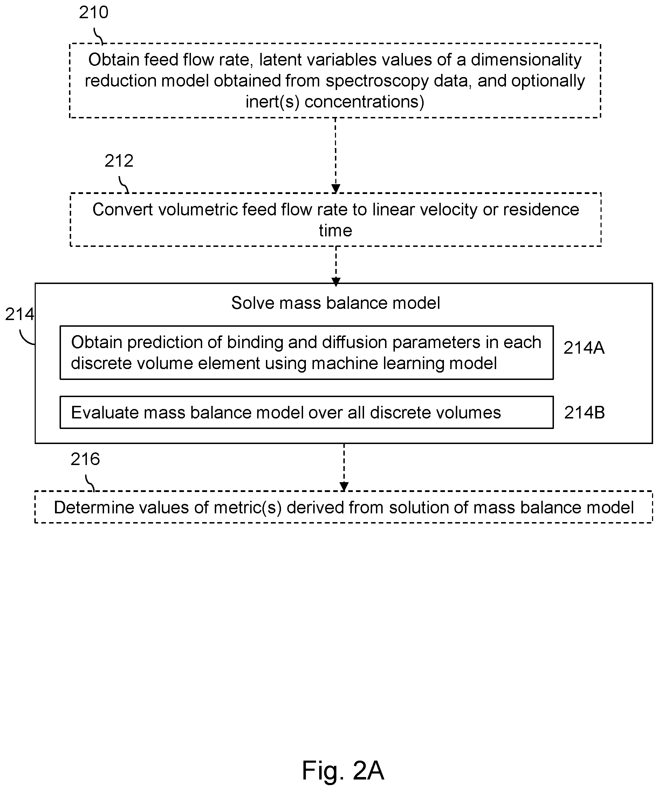

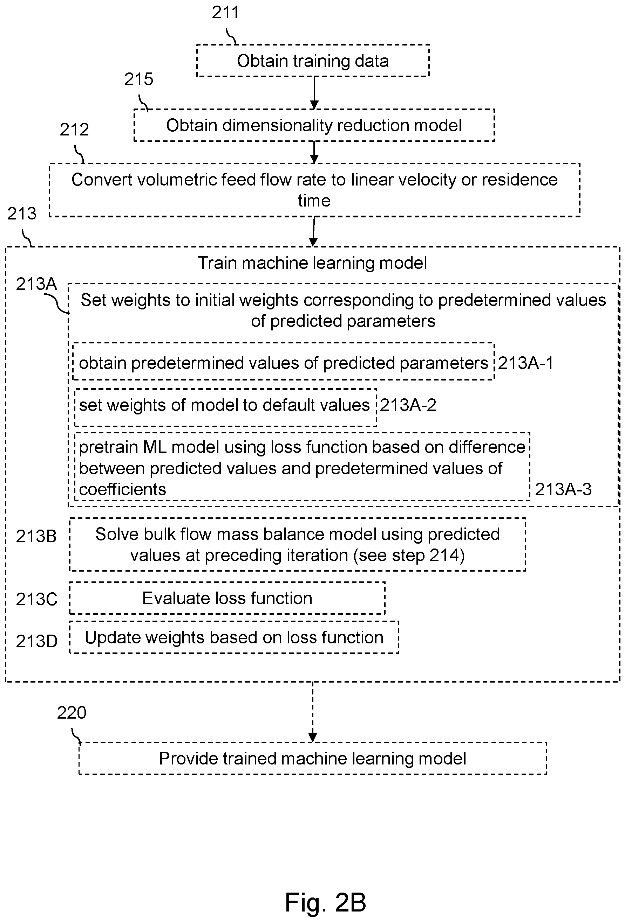

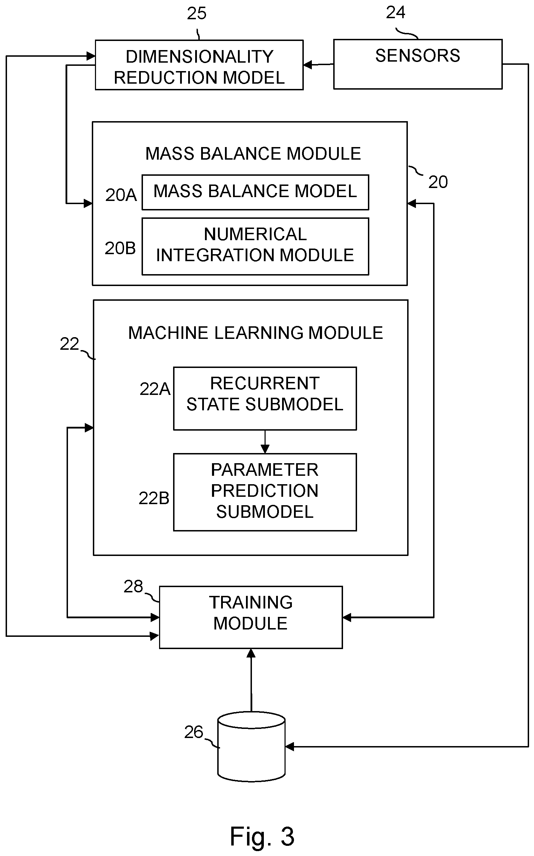

In embodiments, the dimensionality reduction model has been previously obtained from training data comprising spectroscopy data obtained at a plurality of sampling times of input and output flows of one or more chromatography processes, wherein the plurality of sampling times are spaced apart by at most 1 minute. The plurality of sampling times may be spaced apart by at most 1 minute, at most 30 seconds, at most 20 seconds, at most 10 seconds, between 1 second and 1 minute, between 1 second and 30 seconds, or between 1 second and 15 seconds. The time between sampling times may be determined by practical constraints (e.g. sampling interval of the measurement device - where the sampling interval refers to the period of time over which a particular spectrum is being acquired) and/or by design constraints. For example, longer exposure times may be necessary to obtain measurements of species present at low concentrations (e.g. low concentration host cell proteins). Where it is desirable to include spectroscopy data that accurately captures the presence of such species, the methods described herein can naturally accommodate longer sampling times by averaging simulated data (predicted spectroscopy data) over multiple time points that correspond to a sampling interval.**Figure 2** illustrates schematically (A) a method of simulating a chromatographic process according to embodiments of the present disclosure, and (B) a method of obtaining a trained machine learning model according to embodiments of the present disclosure. **Figure 3** illustrates components used in a method of simulating a chromatographic process and/or training a machine learning model according to the present disclosure. In embodiments, both the steps described by reference to **Figure 2A** and the steps described by reference to **Figure 2B** are performed.

The methods of the present disclosure make use of a hybrid, physics informed chromatography model comprising a simple physics-based model limited to mass balance equations in the bulk flow of the liquid phase - where the variables representing the concentration of bound and unbound fractions of the one or more products are expressed as latent variables values of a dimensionality reduction model obtained from spectroscopy data, and a machine learning model trained to predict the value of phenomenological parameters of the physics based model capturing all binding kinetics details, diffusion effects and any other interactions (e.g. all resin/membrane interactions, competitive binding, etc.).

As explained above, a chromatographic process is a process whereby a feed flow comprising one or more products is passing through a chromatography unit comprising a stationary phase that the one or more products interact with. The bulk flow mass balance model is also referred to herein as "mass balance model" or "column model". As illustrated on **Figure 3****,** solving the bulk flow mass balance model over one or more discrete volumes along the chromatography unit by numerical integration can be implemented by a mass balance module 20 implemented by a processor, the mass balance module storing or accessing the mass balance model 20A and using a numerical integration module 20B. Thus, a method of simulating such a chromatographic process can comprise step 214 of solving (e.g. using a mass balance module 20 implemented in a processor) a bulk flow mass balance model (e.g. implemented in a mass balance model 20A stored in the mass balance module 20) over one or more discrete volume elements along the chromatography unit by numerical integration (e.g. using a numerical integration module 20B of the mass balance module). The bulk flow mass balance model is an ordinary differential equations model that represents the change in concentration of bound and unbound fractions of the one or more products in a discrete volume element, expressed as latent variables values of a dimensionality reduction model obtained from spectroscopy data. The ordinary differential equations model comprises binding and diffusion terms, wherein a binding term captures the binding of a product to the stationary phase and a diffusion term captures the diffusion of a bound product. These binding and diffusion terms are each parameterised by a single respective parameter that is predicted by a machine learning model trained to take inputs comprising the latent variable values corresponding to the concentration of the bound and unbound fractions of the one or more products in a discrete volume element and produce as output a prediction of the parameters of the binding and diffusion terms. Thus, solving the bulk flow mass balance model can comprise at step 214A using a machine learning module 22 implemented in a processor (e.g. processor 101 as described below), storing or accessing a trained machine learning model, and using the trained machine learning model to predict the values of the diffusion and binding term parameters using inputs comprising the latent variable values corresponding to the concentration of the bound and unbound fractions of the one or more products in a discrete volume element. Solving the bulk flow mass balance model can comprise using a machine learning module 22 implemented in a processor, storing or accessing a trained machine learning model, and using the trained machine learning model to predict the values of the diffusion and binding term parameters using inputs comprising the latent variable values corresponding to the concentration of the bound and unbound fractions of the one or more products in a discrete volume element. As the skilled person understands, numerical integration is an iterative process whereby a model is integrated over subsequent discrete time periods. The machine learning model and bulk flow mass balance model operate only on latent variable values corresponding to the concentration of the bound and unbound fractions of the one or more products in a discrete volume element - no concentrations of products are ever used by these models. The latent variable values corresponding to the concentration of the bound and unbound fractions of the one or more products in a discrete volume element are determined by solving the bulk flow mass balance model using as input concentrations for all products the latent variable values corresponding to spectral data obtained for the feed (input) flow obtained from a dimensionality reduction model 25. The dimensionality reduction model is a model that obtains a latent variable representation of input spectroscopy data that is of lower dimensionality than the input spectroscopy data, but from which the spectroscopy data can be reconstructed.

The methods described above advantageously make use of a very simple physics based model that only represents bulk flow and the effects of binding and diffusion on bulk flow via phenomenological terms (i.e. terms that do not explicitly model the detailed physico-chemical phenomena underlying the dynamics of binding of the products to the stationary phase and diffusion of the bound product) expressed using latent variable values of a dimensionality reduction model obtained from spectroscopy data as proxi for concentrations of all species measurable by spectroscopy and that may influence the dynamics of the chromatography process. This is combined with a data driven phenomenological parameterisation model to provide the bulk level phenomenological parameters representing diffusion and binding. The phenomena that are not explicitly modelled occur in different compartments of the chromatography unit, such as e.g. in pores and on films on surfaces, along multiple dimensions and involve physico-chemical processes that are not necessarily well characterised. The present methods advantageously bypass all of this, using a machine learning algorithm to identify all parts of the dynamic behaviour of the system that are not easily explained by first principles. Advantageously, the approach relying on differential volume elements and including simple diffusion and binding terms that are captured as ODEs means that the model has the same architecture regardless of the geometry of the chromatography unit. In other words, the model does not explicitly represent diffusion geometry, and the same model can be used for columns with different geometries, enabling straightforward application for *in silico* scale up experiments. Further, the use of ODEs over discrete volume elements means that the simulation can be run without the need for adaptive step-size partial differential equation solvers. As a result, the simulation is both more stable and more computationally efficient than prior art methods. Finally, to the best of the inventors' knowledge, there is no chromatography modelling method that is able to simulate a chromatography process directly from spectroscopy data, bypassing the need for any concentration information. For example, Feidl et al. 2019 describes the combining of mechanistic modelling and Raman spectroscopy for monitoring antibody chromatographic purification. However, this combines traditional mechanistic kinetic modelling of the chromatography process using concentrations of products, and a partial least squares approach to predict titer from Raman data. Indeed, multiple methods for using Raman spectroscopy to determine concentrations of products using a soft sensor approach have been proposed (e.g. Feidl et al. 2023; Wang et al. 2023; Wei et al. 2022; Lin et al. 2021; Rollinger et al. 2023). However, none of these methods enable direct modelling of a chromatography process from spectroscopy data (without the need to identify, quantify and model all species of relevance for the dynamics of the chromatography process).

As the skilled person understands, numerical integration is an iterative process whereby a model is integrated over subsequent discrete time periods. Thus, solving the model can comprise iteratively evaluating (step 214B) the model over all discrete volumes at a respective time using solutions from the previous iteration, where the binding and diffusion parameters are evaluated at each iteration using the machine learning model and latent variable values corresponding to concentrations in the respective discrete volume elements at the preceding iteration. This can use, at every time point, initial conditions for the first discrete volume of the column (entry dead volume) set by observed spectral data from which latent variable values (or centred versions thereof, as explained below) corresponding to the concentrations of the products (and concentrations of inerts, if used) received at step 210, and a known feed flow value (volumetric feed flow is used in the model defined below) also received at step 210. Initial conditions for all other discrete volumes can be set to the latent variable values obtained at the preceding iteration. At the very first iteration, latent variable values corresponding to concentrations of bound and unbound products in subsequent volumes of the column can be set to default values associated with a buffer only solution (e.g. latent variable values obtained for a buffer spectrum, or values of 0 in embodiments where the latent variable values are centred around the latent variable values obtained for a buffer spectrum by subtracting from all latent variable values from spectroscopy data by the latent variable values obtained for the buffer solution used in the elution phase - i.e. the mobile phase used, thereby making latent variable values of 0 equivalent to a "buffer only" / "no product" situation), reflecting the assumption that no products are present in the column at initialisation. Thus, references to latent variable values encompass normalised (e.g. centred) versions thereof unless context indicates otherwise. Alternatively, latent variable values corresponding to concentrations of bound and unbound products in subsequent volumes of the column can be set at the very first iteration to previously obtained values (e.g. from a previous simulation; which can also be latent variable values that have been simulated using centred latent variable values). The chromatography unit can comprise a single column. The chromatography unit can comprise a pluralities of columns connected in series and simulating the chromatography process can comprise connecting a plurality of instances of the bulk flow mass balance model each corresponding to a respective column such that the latent variable values corresponding to the outlet concentration obtained by solving a bulk flow mass balance model for a first column of the plurality of columns sets the latent variable values corresponding to the inlet concentration used for solving the bulk flow mass balance model for a second column of the plurality of columns connected in series with the first column.

The bulk flow mass balance model can comprise linear terms representing the flow of unbound compounds (products and optionally inerts) into and out of each discrete volume element, and the binding and diffusion terms, wherein a binding term captures non-linearities of the process of adsorption of unbound product on the static phase through the prediction of the respective parameter of the term by the machine learning model at each iteration of the numerical integration, and wherein the concentration of bound and unbound fractions of the one or more products are expressed as latent variables values of a dimensionality reduction model obtained from spectroscopy data. The bulk flow mass balance model can comprise equations (6) and (7) below: $\frac{d {{t}^{⇀}}_{u , n}}{dt} = \frac{{f}_{k}}{ΔV} \left({{t}^{⇀}}_{u , n - 1}-{{t}^{⇀}}_{u , n}\right) - {{k}^{˜}}_{a} ∘ {{c}^{⇀}}_{u , n} + {{k}^{⇀}}_{d} ∘ {{t}^{⇀}}_{b , n}$ $\frac{d {{t}^{⇀}}_{b , n}}{dt} = {{k}^{˜}}_{a} ∘ {{t}^{⇀}}_{u , n} - {{k}^{⇀}}_{d} ∘ {{t}^{⇀}}_{b , n}$ where fₖ is the feed flow rate, ΔV is the volume of the discrete volume element *n,* ${{t}^{⇀}}_{u , n}$ is a vector of latent variable values corresponding to concentrations of the unbound products in the discrete volume element n, ${{t}^{⇀}}_{b , n}$ is a vector of latent variable values corresponding concentrations of the bound products in the discrete volume element *n,* ${{t}^{⇀}}_{u , n - 1}$ is a vector of latent variable values corresponding to concentrations of the unbound products in the discrete volume element preceding the discrete volume element *n*, and ∘ is an elementwise product. In these equations, *k̃ₐ* and ${{k}^{⇀}}_{d}$ describe the overall effect, at any given sampling time, of binding and diffusion on the bulk concentration for each non-inert species in the discrete volume. Inert species are species that are not expected to bind to the column. When one or more inert species are additionally being modeled, the buk flow mass balance model can additionally comprise equation (3) below: $\frac{d {{c}^{⇀}}_{i , n}}{dt} = \frac{{f}_{k}}{ΔV} \left({{c}^{⇀}}_{i , n - 1}-{{c}^{⇀}}_{i , n}\right)$ where ${{c}^{⇀}}_{i , n}$ is a vector of concentrations of one or more inerts in the discrete volume element *n,* ${{c}^{⇀}}_{i , n - 1}$ is a vector of concentrations of the inerts in the discrete volume element preceding the discrete volume element *n*. Thus, the bulk flow mass balance model can further represent the change in concentration of one or more inerts in a discrete volume element. In such embodiments, the machine learning model inputs further comprise the concentration of the one or more inerts in the discrete volume. Note that it is also possible to represent the inert species concentrations using latent variable values of the model, and this equation (3) should be interpreted to encompass embodiments in which ${{c}^{⇀}}_{i , n}$ and ${{c}^{⇀}}_{i , n - 1}$ are vectors of latent variable values corresponding to concentrations of the one or more inerts in the discrete volume elements n and n-1. However, the model described above assumes that all latent variable values of the model represent species and their concentrations which have the option to "bind" to the column. Introducing inert species into the latent variable model is still possible as the machine learning model would learn that the corresponding latent variable values are associated with species that do not bind to the column. However, introducing inert concentrations to the latent variable model would needlessly increase the complexity of learning the binding function and is therefore not recommended. Further, modeling of inert species is optional (i.e. equation (3) is optional and not included by default), and in rare cases where it is included, their inclusion as concentrations is much less onerous than for the products because inert species are typically limited to species that are present in buffers for which the concentrations are known (i.e. inerts are typically known species fed into the chromatography process at known concentrations, such that there is not much burden in determining their inlet concentration for the purpose of simulation as described herein).

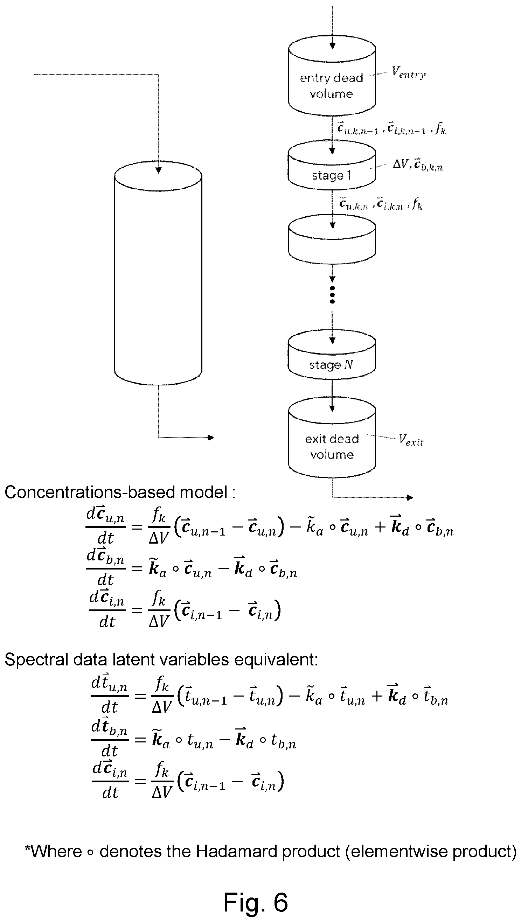

This system of equations only represents three macrolevel phenomena in discrete volumes along the chromatography unit: flow of unbound products in and out of the volume (and optionally flow of inerts in and out of the volume), diffusion of bound products, and binding of unbound products to the stationary phase. The latter two are parameterized with "catch-all" parameters in vectors *k̃ₐ* and ${{k}^{⇀}}_{d}$, which are calculated as the output of the machine learning model. The bulk flow mass balance model can be solved over N discrete volume elements (N being an integer), where N is a parameter of the chromatographic process simulation method which represents the granularity at which the chromatography unit is modelled. N is at least 2, and can be between 5 and 20, between 5 and 15, or selected from 8, 9, 10, 11, 12. The present inventors have found values of N equal to about 10 to afford good accuracy of simulation, stability and computational efficiency. The discrete volume elements can comprise a plurality of discrete volume elements along the chromatography unit in which binding and diffusion occurs, preceded by a discrete volume element in which no binding or diffusion occurs (entry dead volume) and followed by a discrete volume element in which no binding or diffusion occurs (exit dead volume). An embodiment of such a model is illustrated on **Figure 6****.**

Thus, in more detail, solving the bulk flow mass balance model at step 214 can comprise iteratively integrating the model over a plurality of discrete time intervals of predetermined duration, wherein at each iteration predictions for the parameters of the binding and diffusion terms are obtained for each of the discrete volume elements using the machine learning model (step 214A), and a current state vector comprising the latent variable values corresponding to the concentrations of bound products in each discrete volume element at a latest iteration, the latent variable values corresponding to the concentrations of unbound products in each discrete volume element at the latest iteration, and optionally the concentrations of inerts in each discrete volume element (if used) at the latest iteration. The predictions for the parameters of the binding and diffusion terms can further use the feed flow rate (which can also be provided as input to the machine learning model), and any other input provided to the machine learning model such as e.g. a parameter indicative of the age of the column. At each iteration, these predictions are used to evaluate the mass balance model over the discrete volumes at step 214B by identifying a discrete state-space model using the bulk flow mass balance model parameterised using said predictions, and determining an updated state vector for the time interval corresponding to the current iteration using the values of the current state vector and the coefficients of the discrete state-space model. For example, solving the bulk flow mass balance model can comprise linearising equations (6)-7) (and (3) if used) around the current state (defined by ${{t}^{⇀}}_{u , k , n} , {{t}^{⇀}}_{b , k , n} , {{c}^{⇀}}_{i , k , n}$ ,*fₖ*) by obtaining estimates for the parameters *k̃ₐ* and parameter ${{k}^{⇀}}_{d}$ from the machine learning model, calculating a discrete state-space model using equation (4), and updating the state for one or more intervals using equation (5) below: ${\left({e}^{\left[\begin{matrix}A & B \\ 0 & 0\end{matrix}\right]}\right)}^{T} = \left[\begin{matrix}{A}_{d} & {B}_{d} \\ 0 & I\end{matrix}\right]$ ${x}_{k + 1} = {A}_{d} {x}_{k} + {B}_{d} {u}_{k}$ where A and B are the matrices A and B in the equation below: $\left[\begin{matrix}\frac{d {\vec{x}}_{u}}{dt} \\ \frac{d {\vec{x}}_{b}}{dt} \\ \frac{d {\vec{x}}_{i}}{dt}\end{matrix}\right] = A \left[\begin{matrix}{\vec{x}}_{u} \\ {\vec{x}}_{b} \\ {\vec{x}}_{i}\end{matrix}\right] + B \left[\begin{matrix}{\vec{c}}_{u , i , n} \\ {\vec{c}}_{i , i , n}\end{matrix}\right]$ where $A = \left[\begin{matrix}{A}_{u , u} & {A}_{u , b} & 0 \\ {A}_{b , u} & {A}_{b , b} & 0 \\ 0 & 0 & {A}_{i , i}\end{matrix}\right] , B = \left[\begin{matrix}{B}_{u} \\ 0 \\ {B}_{i}\end{matrix}\right] , {\vec{x}}_{u} = \left[\begin{matrix}{{t}^{⇀}}_{u , entry} \\ {{t}^{⇀}}_{u , 1} \\ {{t}^{⇀}}_{u , 2} \\ ⋮ \\ {{t}^{⇀}}_{u , n} \\ {{t}^{⇀}}_{u , exit}\end{matrix}\right] , {\vec{x}}_{b} = \left[\begin{matrix}{{t}^{⇀}}_{b , 1} \\ {{t}^{⇀}}_{b , 2} \\ ⋮ \\ {{t}^{⇀}}_{b , n}\end{matrix}\right] , {\vec{x}}_{i} = \left[\begin{matrix}{{c}^{⇀}}_{i , entry} \\ {{c}^{⇀}}_{i , 1} \\ {{c}^{⇀}}_{i , 2} \\ ⋮ \\ {{c}^{⇀}}_{i , n} \\ {{c}^{⇀}}_{i , exit}\end{matrix}\right]$ and A_{u,b}, Bᵤ, A_{u,u}, A_{b,u}, A_{b,b}, Bᵢ, A_{i,i} have the meanings on **Figures 9B-1****,** **9B-2** and **9B3**.

Calculating a discrete state-space model can comprise calculating matrices A_{d} and B_{d} using equation (4). In embodiments, calculating a discrete state-space model can comprise re-using the coefficients of a calculated discrete state-space model (e.g. A_{d} and B_{d}) from a previous iteration when it is determined that the coefficients of the linearized bulk flow mass balance model at the current iteration are within a predetermined range from those of the the linearized bulk flow mass balance model at the previous iteration. This can advantageously improve computational efficiency of the method by removing the need to re-calculate the discrete state-space model at every iteration, when the dynamics of the system have not changed much between subsequent iterations.

The machine learning model can further take as input the feed flow rate fₖ. Advantageously, this means that the model (combining the mass balance model and the machine learning model) is able to capture the effects of flow rate on the dynamics of binding and diffusion (via the machine learning model), thereby making it possible to use the same model to simulate columns at different flow rates. Indeed, fluid-mechanic, binding and diffusion effects can be learned from experimental data generated at different flow-rates, making the resulting trained model applicable at least to any range of flow rate for which training data (or training data with similar flow rates) was available. Further, because the flow variable, fₖ, is not used by the machine learning model in a first-principle derived equation, this variable may be "transformed" by the user before being passed to the machine learning model. Thus, the method can optionally comprise obtaining a volumetric feed flow rate at step 210, converting said feed flow rate to a linear velocity or residence time at step 212 and providing said converted feed flow rate as input to the machine learning model at step 214A. For example, while the mass balance model uses a volumetric flow rate, the flow rate can be converted to linear velocity or residence time prior to providing it as input to the machine learning model. This is expected to result in models that are less scale dependent. This property is particularly advantageous for applications where there is a desire to identify models from experiments conducted in small columns and make predictions using those models for larger-scale (commercial manufacturing relevant) columns.

The machine learning model can be a recurrent machine learning model, wherein a recurrent machine learning model is a machine learning model that is able to account of the values of one or more predictions made at one or more preceding iterations of the numerical integration when making predictions at a current iteration of the numerical integration. For example, the machine learning model can be a machine learning model that further takes as input a recurrent states vector ${{x}^{⇀}}_{r , k , n}$ which comprises one or more state values for a current iteration k and discrete volume element n, and produces as output an updated recurrent state vector ${{x}^{⇀}}_{r , k + 1 , n}$ for use at the subsequent iteration. The present inventors have found a single state value for each discrete volume element to be sufficient to enable the machine learning model to capture the dynamics of binding and diffusion in a chromatography process. Thus, the recurrent states vector ${{x}^{⇀}}_{r , k , n}$ can contain a single state value for each discrete volume element n for the current iteration k. As illustrated on **Figure 3****,** the machine learning model can comprise a parameter prediction submodel 22B and a recurrent state submodel 22A (both of which can be executed by the machine learning module). The recurrent state submodel is configured (i.e. trained) to predict the updated recurrent states vector ${{x}^{⇀}}_{r , k + 1 , n}$ for use at the subsequent iteration based on the inputs of the machine learning model and the parameter prediction submdodel is configured (i.e. trained) to predict the parameters of the binding and diffusion terms based on the inputs of the machine learning model. The recurrent states vector can be concatenated with the other input variables (latent variable values corresponding to concentrations of the bound and unbound products, feed flow rate and concentrations of inerts if used). Prior to use as input by the machine learning model, the recurrent states vector can be transformed using any function configured to produce a bounded value from an unbounded value, such as a tanh or sigmoid function. This advantageously ensures that the state values do not increase to dominate the other input variables. In embodiments comprising a parameter prediction submodel and a recurrent state submodel, the concatenated input can be fed into both the parameter prediction submdodel and the recurrent state submodel. The parameter prediction submodel 22B is configured (i.e. trained) to provide predictions of the vectors *k̃ₐ* and ${{k}^{⇀}}_{d}$ for use at the current iteration *k* for each volume *n* (i.e. *k̃_{a,k,n}* and ${{k}^{⇀}}_{d , k , n}$) associated with latent variable values ${{t}^{⇀}}_{u , k , n}$, ${{t}^{⇀}}_{b , k , n}$, flow rate fₖ, current state vector ${{x}^{⇀}}_{r , k , n}$, and concentrations ${{c}^{⇀}}_{i , k , n}$,if used. At every iteration, the values for ${{t}^{⇀}}_{u , k , n} , {{t}^{⇀}}_{b , k , n} , {{c}^{⇀}}_{i , k , n}$_{,} are obtained by integration of the model provided by equations (6)-(7) and optionally (3) (which itself uses predictions from the machine learning model for the *k̃ₐ* and ${{k}^{⇀}}_{d}$ parameters at the previous iteration). Further, at every iteration the machine learning model as illustrated additionally outputs an updated state vector for use at the next iteration.

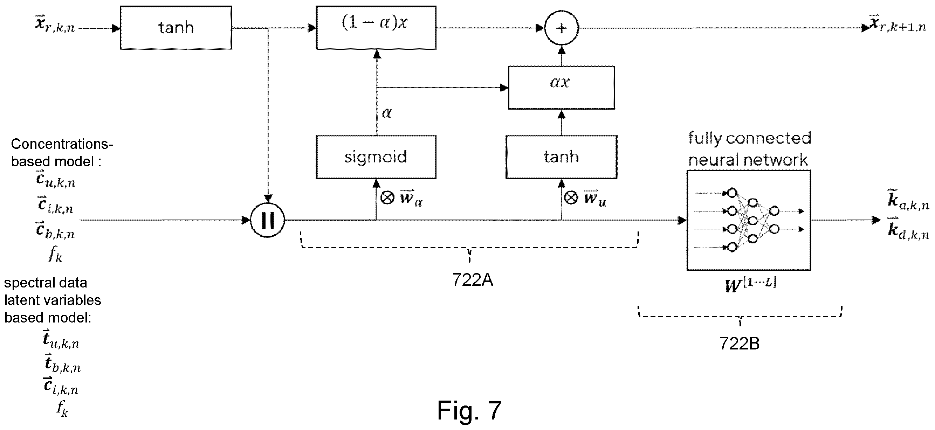

The recurrent state submodel and the parameter prediction submodel are parameterised by respective weights that can all be learned simultaneously. The trained machine learning model can be associated with learned weights that are the same for every discrete volume element and every iteration of the numerical integration. The recurrent state submodel 22A can comprise a first branch comprising a node that takes the concatenated input and applies a first activation function with learned weights vector ${{w}^{⇀}}_{a}$, and a second branch comprising a node that takes the concatenated input and applies a second activation function with learned weights vector ${{w}^{⇀}}_{d}$. Both activation functions can be functions configured to produce a bounded output from an unbounded input. The first activation function (in the first branch) can be configured to produce an output (α) bounded between 0 and 1. For example, the first activation function can be a sigmoid function. The first branch can further comprise a node that takes as input the recurrent states vector ${{x}^{⇀}}_{r , k , n}$ of the current iteration of the numerical integration and the output of the first activation function and produces an output that weights the values of the recurrent states vector ${{x}^{⇀}}_{r , k , n}$ based on the output of the first activation function (e.g. weighting by 1- α). The second activation function produces an output that can be interpreted as a new proposed value for the recurrent states vector. The first activation function produces an output that can be interpreted as a "forgetting factor". The second branch can further comprise a node that takes as input the output of the first activation function and the output of the second activation function, and produces an output that weights the output of the second activation function based on the output of the first activation function (e.g. weighting by α). The outputs of the first and second branches can be summed to produce the output of the recurrent state submodel. This output can be interpreted as a weighted average between the current value of the recurrent states vector ${{x}^{⇀}}_{r , k , n}$ and proposed new values of the recurrent states vector ${{x}^{⇀}}_{r , k , n}$, wherein the current and proposed new values are weighted by (1- α) and α, respectively (i.e. based on the forgetting factor). An embodiment of such a machine learning model is illustrated on **Figure 7** (spectral data latent variables-based model, i.e. ${{t}^{⇀}}_{u , k , n} , {{t}^{⇀}}_{b , k , n}$ are used instead of ${{c}^{⇀}}_{u , k , n} , {{c}^{⇀}}_{b , k , n}$)*.*

The machine learning model can be a nonlinear regression model. the machine learning model can comprise a neural network, which can be fully connected and can comprise any number of layers. In embodiments, the neural network comprises at least 2 hidden layers, between 1 and 4 hidden layers, or 2 or 3 hidden layers. In embodiments, the neural network comprises between 8 and 60 nodes in each hidden layer. For example, the neural network can comprise between 1 and 4 hidden layers with 8 to 60 nodes each, such as 2 or 3 hidden layers with at least 10 nodes each. For example, the neural network can comprise 2 hidden layers with about 20 nodes each. The neural network can additionally comprise a plurality of input nodes (1 for each input) and a plurality of output nodes (one for each output). The output nodes can each comprise an activation function that is a function configured to produce a bounded output from an unbounded input, such as e.g. a tanh or sigmoid function. The function can be a smooth function (e.g. not a step function). The neural network can consist of the above input nodes, output nodes and hidden layers. Note that the trained machine learning models are typically specific to a particular stationary phase and product(s) (and inert(s) if used), but are applicable to any column size, configuration, product(s) concentration(s) (and inert(s) concentration(s), if used) and feed flow rate (although it is advantageous for the product / inert concentrations and feed flow rates used for simulation to be within ranges of values for which training data was available, or within a certain distance from those, such as e.g. within 50% of those, as this is likely to improve the accuracy of the resulting predictions).

As the skilled person understands, solving a bulk flow mass balance model over one or more discrete volume elements along the chromatography unit by numerical integration comprises integrating the model for each of the one or more discrete volume elements at a plurality of discrete time points, thereby obtaining simulated data (also referred to as a trajectory) comprising the latent variable values corresponding to concentration of the products in the effluent of the chromatography unit at the plurality of discrete time points. In embodiments, the method can further comprise at step 216 determining using said simulated data, corresponding spectral data using a reverse of the dimensionality reduction model, such as e.g. an inverse PCA when the dimensionality reduction model is a PCA model. This can comprise, prior to obtaining the spectral data using the reverse of the dimensionality reduction model, reversing a centring of the latent variable values that may have been applied (e.g. where the latent variable values used by the model were centred by subtracting latent variable values for a buffer solution, in which case these values can be re-added to the simulate latent variable values prior to being input to the reverse of the dimensionality reduction model, thereby obtaining simulated spectral data). Further, the method can also comprise at step 216 determining one or more of: effluent product concentrations for one or more products from spectral data obtained from the simulated data (e.g. using one or more soft-sensors configured to determine the concentration of respective products from spectroscopy data - in this case using the simulated spectral data), spectral data for a plurality of simulated effluent fractions using the simulated data and a predetermined fractionation scheme, a product adsorption rate, a product desorption rate, a total captured amount of a product, a dynamic binding capacity of the chromatography process with respect to a product, a product binding capacity per cycle, a product percent recovery, a maximum breakthrough concentration with respect to a product, a maximum percent breakthrough with respect to a product, and costs associated with the simulated chromatography process. In particular, the method can comprise determining using the simulated data for the chromatography process, costs associated with said process using an economic model that takes into account one or more of: a cost associated with regeneration of the chromatography unit, a cost associated with buffer consumed in the chromatography process, a cost of waste generated in the chromatography process, and a gain associated with the amount of product recovered. The method can comprise providing any of the values obtained at steps 214 or 216 to a user, for example through a user interface, or to a controller or computing device associated with the chromatography unit or an upstream process that provides the feeds to the chromatography unit. Determining spectral data for a plurality of simulated effluent fractions can be used when deploying the method for simulation, and when using the simulation for training of the machine learning model when the training data comprises concentration data associated with a time range during a chromatographic process, i.e. data collected using a fraction collector and a known fractionation scheme, or data collected using a spectroscopy sensor that has a known latency that the user wishes to take into account (i.e. where spectral data is effectively equivalent to data collected for a fraction, even though fractions may not in fact be collected as the sensor may be online and may simply have e.g. exposure times long enough compared to the dynamics of the chromatography process that it is desirable to take the "virtual fraction" nature of the measurements into account).

A method of providing a trained machine learning model (which can be performed prior to step 214), can comprise a step 211 of obtaining training data and a step 213 of training the machine learning model, using training data received at step 211 and comprising feed (inlet) spectroscopy data and effluent (outlet) spectroscopy data from a plurality of chromatography processes, or latent variable values derived therefrom (optionally centred as described above), depending on whether a dimensionality reduction model has been previously obtained or not. Alternatively, the method described by reference to **Figure 2A** can comprise receiving a previously trained model, wherein the machine learning model has been trained using training data comprising feed spectroscopy data and effluent spectroscopy data from a plurality of chromatography processes, or corresponding latent variable values. Feed spectroscopy data is spectroscopy data indicative of inlet flow composition and effluent spectroscopy data is spectroscopy data indicative of outlet flow composition. The training data can comprise feed end effluent spectroscopy data each associated with a respective discrete time points during a chromatographic process and/or feed and effluent spectroscopy data associated with a time range during a chromatographic process, such as data collected using a fraction collector or data collected using a spectroscopy sensor that collects measurements representative of flow over a period of time (e.g. spectroscopy sensors with non-negligible exposure times). The training data further comprises feed flow rate data. This can be a volumetric flow rate, a linear speed or a residence time, and conversion between any of these (e.g. to provide a volumetric flow rate for use by the mass balance model and any rate of choice for use by the machine learning model) can also be performed at optional step 212 as explained in relation to step 212 in Figure 2A. The same training data can be used to train the machine learning model at step 213 and to train the dimensionality reduction model at step 215. Alternatively, the dimensionality reduction model can be a model that has been previously obtained from training data comprising spectroscopy data obtained at a plurality of sampling times of input and output flows of one or more chromatography processes. The one or more chromatography processes can advantageously comprise chromatography processes that use a feed flow representative of the feed flow of the simulated chromatography process.

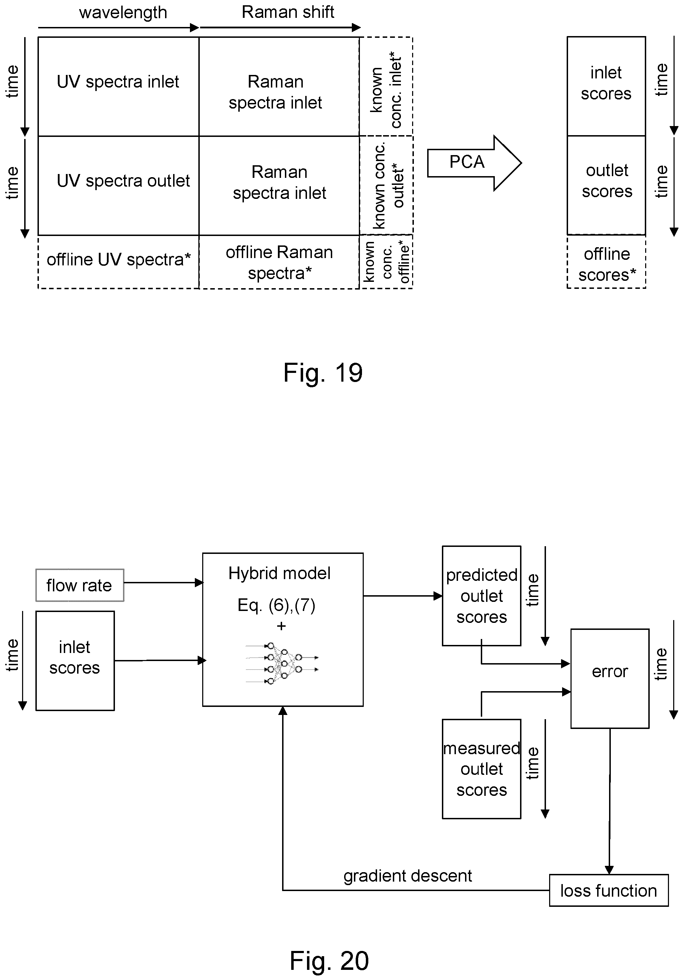

As illustrated in the exemplary embodiment on **Fig. 19****,** the training data used to train both the machine learning model and the dimensionality reduction model can comprise data indicative of concentration of one or more products (and optionally data indicative of concentration of one or more inerts, for training the machine learning model - this is advantageously not used for training the dimensionality reduction model) in the effluent of the chromatography unit. This can be referred to as outlet spectroscopy or effluent spectroscopy data. This data can include time resolved spectroscopy data (e.g. from inline sensors) and fractionated effluent spectroscopy data. The training data can comprise spectroscopy data indicative of composition (and optionally one or more concentrations of one or more inert species) in the feed of the chromatography unit. This can be referred to as inlet spectroscopy data or feed spectroscopy data. The spectroscopy data indicative of composition of the effluent of the chromatography unit can also be referred to as breakthrough curves, which include time resolved spectroscopy data for the effluent of the chromatography unit (by analogy to typical breakthrough curves which include concentration data for one or more products in the effluent as a function of time). The training data can comprise data that has been collected for inputs comprising the same products (e.g. same or similar feeds, feeds from the same or a similar upstream process, etc.), optionally the same buffer (i.e. the same mobile phase), using the same stationary phase at a plurality of sets of process parameters comprising a feed flow rate and a feed concentration. The training data can comprise data that has been collected at a plurality of feed flow rates. The training data can comprise multiple replicates for at least one set of process parameters. The training data can comprise fraction data, i.e. effluent spectroscopy data points each associated with respective time range during a chromatographic process. The effluent spectroscopy data can include a plurality of effluent spectra for each of respective time points or time ranges of a chromatography process in the training data. For example, the training data can comprise, for each chromatography process at least 5, 10 or more effluent spectroscopy data points (where a data point can be in the form of a complete spectrum, set of spectra from a plurality of different spectroscopy instruments, such as e.g. UV and Raman, or downsampled or trimmed versions thereof) associated with respective time points or time ranges. As the skilled person understands, in embodiments where the machine learning model takes as input the feed flow rate and/or any other input such as a parameter indicative of the age of the chromatography unit, this data is typically also part of the training data, for each experimentally determined set of concentration data. The training data used for training the dimensionality reduction model can also include one or more concentrations of one or more products in the inlet (feed) flow. The training data used for training the dimensionality reduction model can also include one or more concentrations of one or more products in the outlet (effluent) flow. The training data used for training the dimensionality reduction model can also include one or more spectra obtained from offline samples. These may be samples of any flows that are believed to contain the one or more products of interest, i.e. any flows that have a composition believed to be representative of the composition of any flows of the chromatography processes that are modelled in the simulation methods described herein.

The method can comprise at step 215 using a training module 28 implemented by a processor to train the dimensionality reduction model using training data comprising spectroscopy data obtained at a plurality of sampling times of input and output flows of one or more chromatography processes (i.e. inlet and outlet spectroscopy data from one or more chromatography processes), and optionally additional spectroscopy data and/or concentration data (see example illustrated on Fig. 19, where "additional" spectra indicated as offline spectra and known concentrations are all indicated as dashed boxes indicated that they are optional). The use of concentration data is completely optional and default embodiments are based solely on spectroscopy data. The dimensionality reduction model may be trained to identify a latent variable representation of input spectroscopy data that has lower dimensionality than the input data and captures the variability in the training data from which the model was obtained. In other words, the dimensionality reduction model may be trained to identify a latent variable representation of input spectroscopy data from which the input data can be reconstructed. In embodiments, the dimensionality reduction model is a PCA (principal component analysis) model. The optimal number of principal components (PCs) (or generally the optimal number of dimensions of the dimensionality reduction model) may be identified using any method known in the art, such as e.g. cross-validation. Alternatively, the optimal number of PCs (or dimensions of any other dimensionality reduction model) can be identified using a signal to noise ratio metric applied to time series of latent variable values corresponding to effluent spectra (i.e. breakthrough curves in latent variable values space). In particular, timeseries of latent variable values for each dimension of the dimensionality reduction model can be plotted as additional dimensions are being included (e.g. from the dimensions capturing the highest amounts of variance to dimensions progressively capturing lower and lower amounts of variance). Additional dimensions can be excluded (i.e. the process of adding dimensions to the dimensionality reduction model can be stopped) when the time series for the last added dimension become too noisy. This can be evaluated manually or using any signal to noise ratio metric known in the art (e.g. comparing a smoothed signal to the observed signal for the time series of latent variable values along subsequent dimensions of the dimensionality reduction model, and stopping the inclusion of additional dimensions when the signal to noise ratio metric falls below a predetermined threshold). The dimensionality reduction model may be identified using a method that is tolerant to the presence of missing data (if missing data is present, e.g. if spectroscopy data for one or more of the one or more chromatography processes in the training data does not include data for all of the time points for which data is available for another one of the one or more chromatography processes in the training data). Instead or in addition to this, any data imputation method that is compatible with the chosen dimensionality reduction model may be used prior to learning the dimensionality reduction model. The trained (also referred to as "determined" or "parameterised") dimensionality reduction model can then be used to transform any spectroscopy data (e.g. feed and effluent spectroscopy data for use in training the machine learning model) into corresponding latent variable values. The machine learning model can then be trained using exclusively such latent variables values.

The method can comprise at step 213 using a training module 28 implemented by a processor to train the machine learning model using training data comprising latent variables values corresponding to effluent product concentration data from a plurality of chromatography processes. The training module 28 can obtain the training data from a data store 26 and use this to train the machine learning model (e.g. including the recurrent state submodel 22A and the parameter prediction submodel 22B) stored in the machine learning module 22. The training data may have been obtained from sensors 24 or from a user interface at step 211, then processed by the data dimensionality reduction model obtained at step 215 (or a previously obtained data dimensionality reduction model). The training module 28 can communicate with the mass balance module 20 to solve the mass balance model 20A using the numerical integration module 20B using predictions from the machine learning module 22. The simulated data obtained through this process can be used by the training module 28 to update the weights of the machine learning model 22 using the simulated data and corresponding training data obtained from data source 26.

Training the machine learning model can comprise at step 213B, for each of one or more training datasets each comprising feed spectroscopy data, effluent spectroscopy data and feed flow rate data for a chromatographic process corresponding to a plurality of time points during the chromatographic process, solving the bulk flow mass balance model using values of the parameters of the binding and diffusion terms predicted by the machine learning model at a preceding iteration of the training at discrete time intervals corresponding to plurality of time points from the training dataset, with feed rate trajectories corresponding to the feed flow rate data from the training dataset and latent variable values corresponding to the feed spectroscopy data from the training dataset (feed spectroscopy data) obtained from the trained dimensionality reduction model, thereby obtaining simulated data corresponding to each of the one or more training dataset. This can be performed as explained above in relation to step 214 on Figure 2A. Training the machine learning model can comprise at step 213C, evaluating a loss function quantifying the difference between the simulated data and the corresponding one or more training datasets (i.e. simulate latent variable values for the effluent flow and corresponding latent variable values for the effluent flow obtained from measured spectroscopy data for the effluent flow, i.e. effluent spectroscopy data, using the trained dimensionality reduction model). Training the machine learning model can comprise at step 213D, updating the weights of the machine learning model based on the weights of the machine learning model at the current iteration and the value of the loss function, optionally using a gradient descent procedure, until one or more predetermined stopping criteria are satisfied. The one or more predetermined stopping criteria can apply to the number of iterations, the value of the loss function and/or the difference between the updated weights and the weights at the current iteration. The iterative training process can start with default weights, random weights, weights of a previously trained model (e.g. for a similar chromatographic process, e.g. similar products, inert species and/or mobile phase), or weights initialised using a "warm start" procedure as will now be described.

A "warm-start" procedure can also be referred to as "pretraining", and sets weights of the machine learning model to values that are promising starts for training of the model, thereby increasing the computational efficiency of the training process and increasing the likelihood that the training process will converge to a suitable solution. In embodiments, training the machine learning model can comprise at a first iteration of said iterative training, setting (step 213A) the weights of the machine learning model to initial weights that correspond to predetermined values of the parameters of the binding and diffusion terms. Setting the weights of the machine learning model to said initial weights can comprise obtaining said predetermined values of the parameters of the binding and diffusion terms (step 213A-1), setting the weights of the machine learning model to default values (step 213A-2), and pretraining (step 413A-3) the machine learning model, using a loss function that is based on the difference between predicted values from the model and the predetermined values of the parameters of the binding and diffusion terms. In particular, said pretraining can comprise iteratively updating the weights of the machine learning model by: predicting, using the machine learning model, values of the parameters of the binding and diffusion terms using inputs to the machine learning model sampled from the training data, evaluating a loss function quantifying the difference between the predicted values of the parameters of the binding and diffusion terms and the predetermined values of the parameters of the binding and diffusion terms; and updating the weights of the machine learning model based on the weights of the machine learning model at the current pretraining iteration and the value of the loss function. Advantageously, this approach increases the chance of the model training converging, compared to a random weight or other uninformed weight initialisation procedure. This is particularly useful in the present context because the machine learning model captures complex dynamic phenomena that, if improperly parameterised, can lead to instability in the solution of the mass balance module, in some cases preventing the entire training method from converging.

Step 213A-1 of obtaining the predetermined values of the parameters of the binding and diffusion terms can comprise one or both of the following processes. In a first process, predetermined values can be obtained by: (i) setting the values of the parameters of the diffusion terms and the parameters of the binding terms or corresponding parameters associated with corresponding non-linear binding terms to respective default values, (ii) solving the bulk flow mass balance model by numerical integration using these default values and predetermined feed latent variable values and feed flow rate data, optionally wherein said predetermined feed latent variable values and feed flow rate data are selected as the maximum values of the feed flow rate and feed concentration observed in the training data, (iii) determining whether the numerical integration was not able to calculated any of the solutions of the model, and (iv) when the numerical integration was not able to calculated any of the solutions of the model, updating the default values of the parameters of the binding and diffusion terms by reducing the default values by a predetermined factor. The above steps can be repeated until an iteration where the numerical integration was able to calculate all of the solutions of the model, and the values of the parameters of the binding and diffusion terms are selected as those used at said iteration. In a second process, which can be performed after the first process or instead of the first process, predetermined values can be obtained by: (i) setting the values of the parameters of the diffusion terms and the parameters of the binding terms or corresponding parameters associated with corresponding non-linear binding terms to respective default values (e.g. default values obtained using the first process above); (ii) for each of one or more training datasets each comprising feed spectroscopy data (or corresponding latent variable values obtained using the trained dimensionality reduction model), effluent spectroscopy data (or corresponding latent variable values obtained using the trained dimensionality reduction model) and feed flow rate data for a chromatographic process corresponding to a plurality of time points during the chromatographic process, solving the bulk flow mass balance model using said default values of the parameters of the binding and diffusion terms thereby obtaining simulated data corresponding to each of the one or more training dataset; (iii) evaluating a loss function quantifying the difference between the simulated data and the corresponding one or more training datasets (i.e. differences between effluent latent variable values obtained using the trained dimensionality reduction model from measured effluent spectroscopy data and simulated effluent latent variable values); and (iv) updating the default values of the parameters of the binding and diffusion terms based on the value of the loss function, optionally using a gradient descent procedure. The above steps can be repeated until one or more predetermined stopping criteria are satisfied. Advantageously, each of the first and second processes above increase the chance of the training process converging. In particular, the first process ensures that pretraining of the model is based on values of the parameters of the binding and diffusion terms that are unlikely to cause numerical instability when solving the bulk flow mass balance model. The second process ensures that pretraining of the model is based on values of the parameters of the binding and diffusion terms that are informed by data in a computationally efficient process, prior to starting the more computationally intensive training of the machine learning model. A parameter of a diffusion term can be denoted as *k̃ₐ* and can be a linearized version of a corresponding parameter ${{k}^{⇀}}_{a}$, calculated as ${{k}^{˜}}_{a} = {{k}^{⇀}}_{a} ∘ \left({{t}^{⇀}}_{tot}-{{t}^{⇀}}_{b}\right)$, where ${{k}^{⇀}}_{a}$ is a corresponding parameter associated with a corresponding nonlinear binding term (where the corresponding nonlinear binding term is ${{k}^{⇀}}_{a} ∘ \left({{t}^{⇀}}_{tot}-\right.$ $\left.{{t}^{⇀}}_{b}\right) ∘ {{t}^{⇀}}_{u , n}$), and ${{t}^{⇀}}_{tot}$ is the total binding capacity of the column (also referred to as static binding capacity of the column) expressed in terms of latent variables values. The linear binding term corresponding to this is therefore *k̃ₐ* ∘ *t_{u,n}*. The value of ${{t}^{⇀}}_{tot}$ can also be set to a default value that can be identified using the same process as explained above. As the skilled person understands, the reference to "diffusion terms", "binding terms", and "flow terms" refers to multiple terms because a separate equation is evaluated for each discrete volume element *n* and because the latent variable representation of the flows can have more than 1 dimension (and multiple inert species may be modelled, if inert species are modelled) - i.e. there can be more than one latent variables, each associated with a respective value for the inlet and outlet (feed and outlet) flows in the measured and simulated data, and each associated with respective values for bound and outbound fractions in the discrete volume elements in the simulated data. However, for a single product in a single discrete volume element there would typically be a single diffusion term, a single binding term and a single flow term (although the same binding term can appear in the equations for the bound and unbound fractions of the product with a different sign).

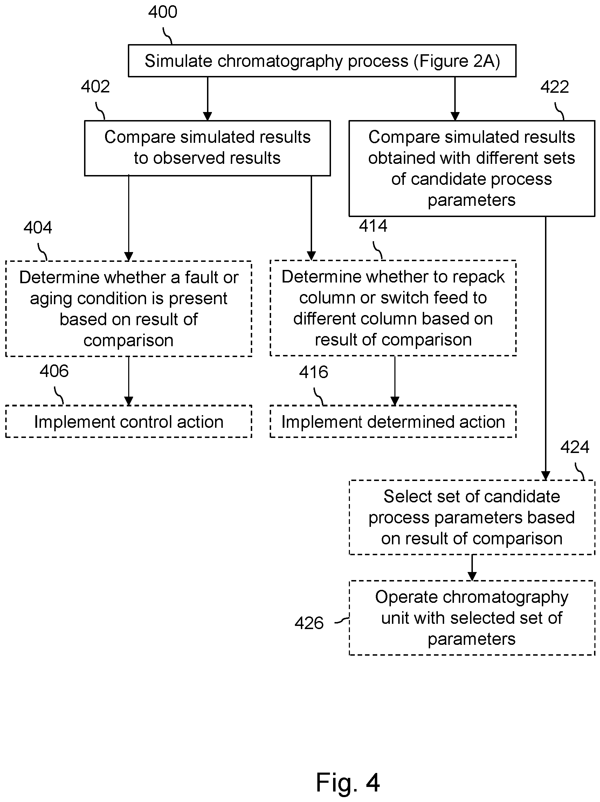

**Figure 4** illustrates schematically a method of monitoring a chromatographic process, a method of optimising a chromatographic process, and a method of controlling a chromatographic process according to embodiments of the disclosure. A method of monitoring a chromatography process can comprise a step 400 of simulating the chromatography process using a method as described herein (such as e.g. by reference to **Figure 2A**) and feed spectroscopy data and feed flow rate data corresponding to the measured or planned feed compositions and feed flow rates of the chromatography process, thereby obtaining simulated effluent spectroscopy data (or latent variable values corresponding to said spectroscopy data) corresponding to the effluent composition of the chromatography process. Such a method can further comprise a step 402 of comparing the simulated effluent spectroscopy data or one or more metrics derived therefrom to observed effluent spectroscopy data or metrics derived therefrom (e.g. concentrations of one or more products identified using soft sensors configured to determine the concentrations of the respective products from spectroscopy data), wherein the comparison is indicative of the presence of a fault or aging condition of the chromatography unit. Thus, at optional step 404, the results of the comparison can be used to determine whether a fault or aging condition is present, for example when the simulated effluent spectroscopy data (or the latent variable values for the effluent themselves) or one or more metrics derived therefrom differ from the observed effluent spectroscopy data (or corresponding latent variable values) or corresponding metrics derived therefrom by more than a predetermined threshold, or when the difference increases by more than a predetermined threshold over a predetermined period of time. At optional step 406, a control action can be implemented based on the results of the determining. For example, the chromatography process can be interrupted or the feed can be directed to another column when it is determined that a fault or aging condition is present.

A method of controlling a chromatography process can comprise a step 400 of simulating the chromatography process using a method as described herein (such as e.g. by reference to **Figure 2A**) and feed spectroscopy data and feed flow rate data corresponding to the measured or planned feed compositions and feed flow rates of the chromatography process, thereby obtaining simulated effluent spectroscopy data (or latent variable values corresponding to said spectroscopy data) corresponding to the effluent composition of the chromatography process. Such a method can further comprise a step 402 of comparing the simulated effluent latent variable values, corresponding effluent spectroscopy data or one or more metrics derived therefrom to observed spectroscopy data, corresponding latent variable values, or metrics derived therefrom, and a step 414 of determining whether to repack the chromatography unit or whether to switch the feed to a different column in a multi-column chromatography process based on the results of the comparing. For example, when the simulated effluent spectroscopy data or latent variable values or one or more metrics derived therefrom differ from the observed effluent spectroscopy data, corresponding latent variable values or corresponding metrics derived therefrom by more than a predetermined threshold, or when the difference increases by more than a predetermined threshold over a predetermined period of time, the method can determine that the column should be repacked (e.g. single column chromatography unit) or the feed switched to another column (e.g. multi-column chromatography unit). Such a method can further comprise optional step 416 of implementing the identified control action (e.g. repacking the column or switching the feed to another column).

A method of controlling a chromatography process can comprise a step 400 of simulating the chromatography process using a method as described herein (such as e.g. by reference to **Figure 2A**) using a plurality of candidate sets of process parameters each comprising at least feed spectroscopy data and a feed flow rate, thereby obtaining simulated effluent spectroscopy data (or latent variable values from which such data can be obtained using the dimensionality reduction model) for each candidate set of process parameters. Such a method can further comprise a step 422 of comparing the simulated effluent spectroscopy data, simulated effluent latent variable values or one or more metrics derived therefrom to select a set of process parameters from the sets of candidate process parameters to use in operating the chromatography process. The candidate sets of process parameters can comprise spectroscopy data corresponding to an expected feed composition or feed flow (which can be expected e.g. based on current operating schedule or current or planned operation of an upstream process that provides the feed to the chromatography process). The method can further comprise step 424 of selecting one of the sets of candidate process parameters based on the results of the comparison (e.g. the set that is optimal using one or more optimality criteria that apply to the simulated effluent data or metrics derived therefrom). The method can further comprise operating the chromatography unit with the selected set of parameters at step 426. Note that simulating the chromatography process can comprise simulating the chromatography process using different sets of candidate parameters which comprise the use of models associated with different chromatography units (e.g. units with different static phases, buffers, physical configuration, etc.), and selection / operating the chromatography unit with the selected set of parameters can therefore comprise operating a different chromatography unit depending on the selected set of parameters.

The methods of the present disclosure find uses in many contexts including in process development, column health modelling and advance control. For example, in process development, the methods can be used to design a transition from batch to continuous chromatography with a lower experimental burden than was previously possible (e.g. by enabling *in silico* recipe design for multi-column operations from batch breakthrough experiments, and robustness testing for connected continuous processes). As another example, the methods can be used for scaling processes, for example by enabling to predict binding capacities at large scale from small scale trials, and enabling recipe design for continuous chromatography at scale based on development scale equipment. In production, the methods can be used for column health modelling, enabling to compare digital-twin predictions to real-time performance and flag deviations from expectations, and capture and quantify column-to-column variation at/following column changes. Still in production, the methods can enable advanced control by automatic adaptation of multi-column process to variations in feed stock (forecast or measured), as well as real-time economic optimization of column use particularly in multi-column set ups.

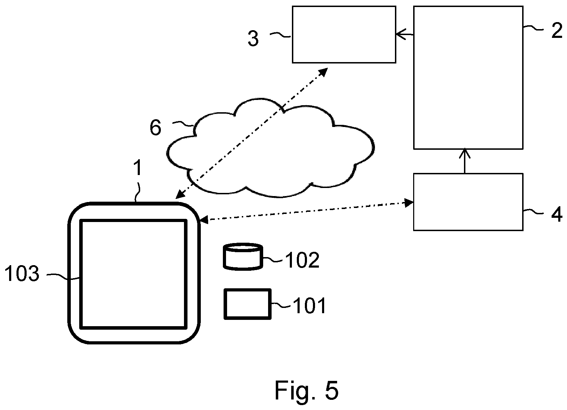

**Figure 5** shows an embodiment of a system for implementing methods of the present disclosure. The system comprises a computing device 1, which comprises a processor 101 and computer readable memory 102. In the embodiment shown, the computing device 1 also comprises a user interface 103, which is illustrated as a screen but may include any other means of conveying information to a user such as e.g. through printing or emitting audible or visual signals. The computing device 1 can be operably connected, such as e.g. through a network 6 or a wired connection, to one or more sensors 3 (e.g. sensors associated with the feed flow or effluent of the chromatography unit) which include a spectroscopy sensor. The computing device 1 can be operably connected, such as e.g. through a network 6 or a wired connection, to one or more effectors 4 (e.g. flow control system) associated with a chromatography unit 2 (such as e.g. unit 12 as illustrated on Figure 1). The computing device 1 may be a smartphone, tablet, personal computer or other computing device. The computing device 1 is configured to implement a method for simulating a chromatography process and/or a method for training a chromatography process simulation model and/or a method for monitoring a chromatography process, as described herein. In alternative embodiments, the computing device 1 is configured to implement part of a method for simulating or monitoring a chromatography process and/or training a model as described herein, and to communicate with a remote computing device (not shown), to implement other parts of a method of simulating or monitoring a chromatography process and/or training a model as described herein, as described herein. For example, the computing device 1 may be a distributed control unit and may communicate with a remote computing device that implements the functions of one or all of the mass balance module 20, machine learning module 22 and training module 28 illustrated on Figure 3. The computing device 1 may form part of a chromatography system. Communication between the computing device 1 and the remote computing device may be through a wired or wireless connection, and may occur over a local or public network such as e.g. over the public internet. Each of the sensor(s) 3 and optional effector(s) 4 may be in wired connection with the computing device 1 (or the remote computing device, if present), or may be able to communicate through a wireless connection (i.e. through a network 6), such as e.g. through WiFi, as illustrated. The connection between the computing device 1 and the effector(s) 4 and sensor(s) 3 may be direct or indirect (such as e.g. through a remote computer). The one or more sensors 3 may each be on-line sensors (sometimes also referred to as "inline sensors"), which automatically and continuously measure a property of the chromatography effluent, or off-line sensors (for which a sample of the effluent, also referred to as "fraction" is obtained whether manually or automatically, and subsequently processed to obtain the measurement). Each measurement from a sensor (or quantity derived from such a measurement) represents a data point, which is associated with a time value (or range of time in the case of a fraction). The one or more sensors can advantageously include one or more online spectroscopy sensors measuring inlet flow properties. For the purpose of training a model as described herein, the one or more sensors can additionally advantageously include one or more online spectroscopy sensors measuring outlet flow properties The one or more sensors include one or more spectroscopy sensors. The one or more sensors can additionally include one or more sensors that measure the concentration of one or more bioproducts (including e.g. products of interest, bioproducts that are contaminants for the purpose of production of the bioproduct but are referred to as products in the context of the chromatography modelling because they also interact with the chromatographic stationary phase, and bioproducts that are contaminants for the purpose of production of the bioproduct and are referred to as inert species (or simply "inerts") in the context of the chromatography modelling because they do not interact with the chromatographic stationary phase) in the effluent. Examples of such sensors are known in the art and include NMR spectrometers, mass spectrometers, enzyme-based sensors, spectrophotometric sensors, etc. As used herein, sensors 3 may also refer to systems that estimate the concentration of a metabolite or the amount of biomass from one or more measured variables (e.g. provided by other sensors). For example, a metabolite sensor may in practice be implemented as a processor (e.g. processor 101) receiving information from one or more sensors (e.g. measuring physical/chemical properties of the system) and using one or more mathematical models to estimate the concentration of a bioproduct from this information. For example, a product sensor may be implemented as a processor receiving spectra from a near infrared spectrometer and estimating the concentration of one or more products from these spectra. Such sensors may be referred to as "soft sensors" (by reference to their "measurements" being obtained using a software rather than by direct measurement). The one or more sensors 3 may further include one or more sensors that measure further process conditions such as pH, flow rate, temperature, etc. Such sensors are known in the art. The measurements from the sensors 3 are communicated to the computing device 1, which may store the data permanently or temporarily in memory 102. The computing device memory 102 may store one or more trained models as described herein. The processor 101 may execute instructions to train a model to simulate a chromatography process using these models and the data from the one or more sensors 3, as described herein. Note that this does not require direct interaction with the sensors 3, chromatography unit 3 or effectors 4. Instead, data from these may have been previously collected (including data that may have been collected at different times using different sensors, chromatography units and effectors) and stored in any memory, then obtained by computing device 1 and stored in memory 102 for training the model by the processor 102. The processor 101 may execute instructions to simulate a chromatography process using a previously trained model. The processor 101 may further execute instructions to compare the simulated results with measurements received from sensors 3, to identify a fault condition or an aging of the chromatography unit. In such embodiments the processor 101 may receive data from sensors 3 in a continuous or periodic manner.

As used herein, the terms "computer system" includes the hardware, software and data storage devices for embodying a system or carrying out a method according to the above-described embodiments. For example, a computer system may comprise one or more processing units (processors) such as a central processing unit (CPU) and/or a graphical processing unit (GPU), input means, output means and data storage, which may be embodied as one or more connected computing devices. Preferably the computer system has a display or comprises a computing device that has a display to provide a visual output display (for example in the design of the business process). The data storage may comprise RAM, disk drives or other computer readable media. The computer system may include a plurality of computing devices connected by a network and able to communicate with each other over that network. For example, a computer system may be implemented as a cloud computer. Thus, the processors may be webservers. The methods described herein may be provided as computer programs or as computer program products or computer readable media carrying a computer program which is arranged, when run on a computer, to perform the method(s) described herein. The term "computer readable media" includes, without limitation, any non-transitory medium or media which can be read and accessed directly by a computer or computer system. The media can include, but are not limited to, magnetic storage media such as floppy discs, hard disc storage media and magnetic tape; optical storage media such as optical discs or CD-ROMs; electrical storage media such as memory, including RAM, ROM and flash memory; and hybrids and combinations of the above such as magnetic/optical storage media.

The methods and systems described herein have many benefits. They do not require a detailed understanding of the physico-chemical mechanisms influencing the behaviour of the chromatography process. These are typically at best difficult to obtain (requiring specialist knowledge and extensive experiments), and sometimes even not possible to obtain. For example, it is often not clear how to model the impact of impurity profile on column performance (such as e. g. host cell protein, DNA, aggregates). Such a detailed understanding is not required in the present methods and instead all processes that practically do impact the behaviour of the chromatography process are captured in the machine learning prediction of phenomenological parameters of the mass balance model. Further, the present methods do not require extensive experiments as the models are simple to train even with low amounts of data, and trained models are applicable to any geometry of column using the same stationary phase and mobile phase. Additionally, the present approaches are able to flexibly make use of historical experimental data, and can accommodate fraction data or combinations of inline and fraction data. The present methods are also highly computationally efficient (certainly compared to a full general rate model), while being natively able to account for competitive binding and diffusion. Finally, the work in the present application directly makes use of spectral data to fit and deploy such a model, bypassing completely the need for measuring concentrations of products and impurities in the system that may affect its performance. This means that the method can straightforwardly account for the presence of competitively binding species in the column (specifically, any species that can be observed through spectral data will have the opportunity to influence the column model, for instance through competitive binding effects learned by the machine learning model), without requiring the concentrations of these species being measured (which is practically almost infeasible given that measurement of even the most prevalent impurities, such as host cell proteins (HCPs) is time-consuming and expensive (costs of up to 2500 USD per sample, such that models built on measured concentrations are necessarily limited in scope). Having obtained modelling results that inherently takes these species into account, the result can then be processed to obtain concentrations of specific species of interest (e.g. product titer) at a fraction of the effort, by conducting calibration experiments after training the column model to correlate simulated spectral signatures to species (i.e. soft sensor models can be implemented at a later date for selected species of interest without the need to re-train the column model). Because no concentration analysis is required, the model can learn online (i.e. in real time) as spectral data becomes available through online sensors. Online sensors for concentrations are typically extremely limited and not commonly available. Relatedly, the approach requires minimal input from experimenters or modelers, and the entire process of learning a column model (or updating it with new data) can be automated on the chromatography device platform and run "lights out".

Narayanan et al. (2021) describes a hybrid modelling where the chromatographic unit behaviour is learned by a combination of neural network and mechanistic model while fitting suitable experimental breakthrough curves. The methods described therein differ from the present methods in several ways. Firstly, the mechanistic model used was not a simple mass balance model and still maintained much of the complexity of the physical phenomena in the column. In other words, the authors did not reduce the complexity of the physics model significantly and only reduced the experimental burden in parameterising it via machine learning. At least in part because of this, the authors had trouble getting their training algorithm to be stable. In their conclusions, they noted that training times were intractable and that gradient descent did not always converge. The different model structure proposed in the present work, and related improved solver resolves those issues. Furthermore, the work in Narayanan et al. explicitly neglected diffusion. By contrast, the models developed in the present work are able to accurately account for diffusion, particularly when using the proposed recurrent machine learning model. Additionally, the use of recurrent machine learning in embodiments of the present disclosure enables the method to be usable with coarse spatial discretization, further reducing the complexity of the model, increasing computational efficiency and stability of the method. Finally, the methods in Narayanan et. al. are limited to the use of concentrations, using extensive inlet and outlet concentration measurements of a mAb product and ignoring all other species that are not measured. ***Examples*** Exemplary methods of simulating a chromatographic process and uses of such simulations in chromatographic process optimisation will now be described.

### Example 1 - Universal Chromatography Model

### Introduction

The present inventors set out to solve problems associated with state-of-the-art chromatography modelling approaches, which are based on first-principles governing mass transport (i.e. capturing convection, diffusion through stagnant films, diffusion in pores, etc), are numerically unstable due to stiffness related issues in partial differential equations, require parameterisation from detailed experiments, and require modelling experts to adjust the model for each chromatography process.

They developed a chromatography modelling framework that uses a hybrid of a machine learning algorithm (neural networks are illustrated here) and physics derived equations to provide powerful predictions. The approach is directly usable by chromatography practitioners rather than modelling experts (as it does not require detailed understanding of the physico-chemical phenomena likely to influence the chromatographic process), has minimal data requirements, is computationally efficient, easy to integrate with models of other unit operations, and applies to resins, membranes, and monoliths without modification by the user.

The new approach is particularly useful in the context of facilitating the transition from batch to continuous processing, for example enabling the design of continuous chromatography recipes from batch data as well as enabling optimisation of the conditions of continuous chromatography to demonstrate value of continuous processing without requiring lengthy and costly experimental trials. The new approach is also particularly useful in reducing costly process development experiments at manufacturing scale, for example by reducing the number of experiments needed in process scale-up, and also in decoupling dependencies on the upstream process development and enabling process development at scale for advanced columns (such as membranes and monoliths). The new approach is also particularly useful in the context of risk mitigation / column health monitoring, where a digital twin of a column can be run to enable early detection of column failures, aid in deviation root cause analysis, and enable longer time between repacking columns (through health monitoring). Further, the new approach is also particularly useful in chromatographic process optimisation, including economic optimisation. Indeed, since the same approach can be used to model a chromatographic process over a wide range of operating conditions, it is possible to simulate the costs associated with different conditions in order to optimise the economics of the bioproduction process (e.g. cost per amount of recovered product).

### Universal Chromatography Model Framework Overview

The approach described herein combines machine learning models for intensive (volume independent) process predictions with a simple physics model that captures process scale. The architecture of both parts of the universal chromatography model are independent of column size or types of stationary phase (binding phase), i.e. the same architecture can be used for membranes, monoliths and resins.

The approach requires minimal amounts of experimental data, i.e. the only data needed is the data used to train the machine learning model, which is limited to breakthrough data (i.e. data about the concentration of adsorbate in the column effluent as a function of time, including at least the desired product(s) although the model can also take into account inerts - i.e. any other compound in the feed that can influence the interaction between the product(s) and the column). Note that the approach can even make use of fractionated breakthrough data instead of or in addition to time-resolved breakthrough data. This is particularly useful as in many cases detailed concentration information (particularly for compounds other than the specific desired product of the process, e.g. any host proteins or other contaminants) is only available for collected fractions of the effluent because they are collected offline. The approach is capable of capturing complex interactions, is easy to use, is computationally efficient (sub-second execution) and works for poorly understood processes (e.g. advanced therapies) where accurate first principle models are simply not available.

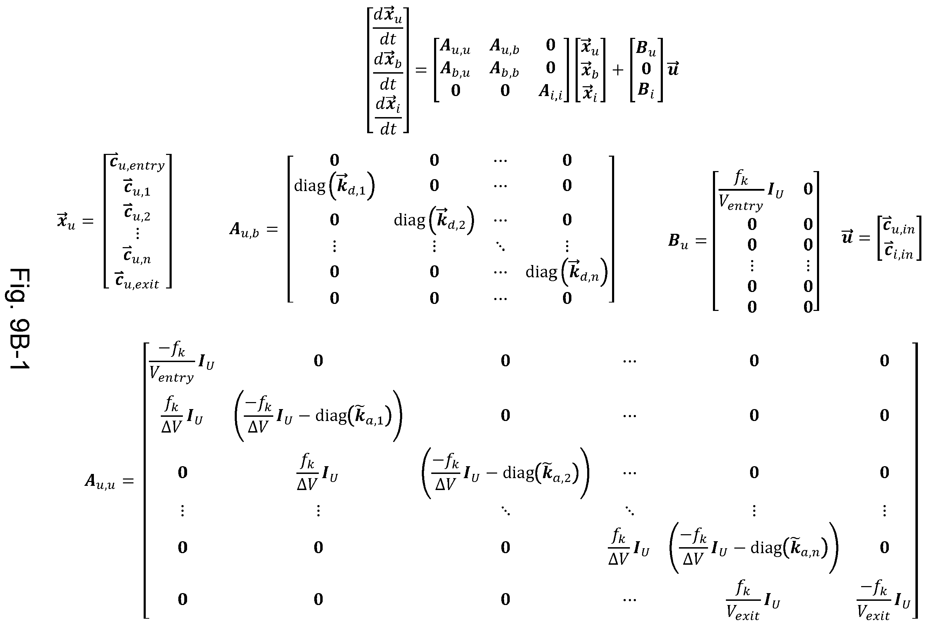

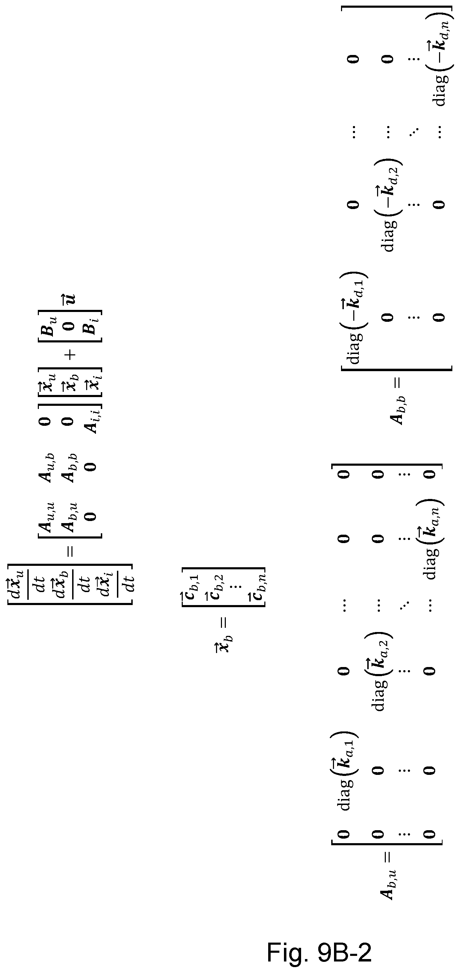

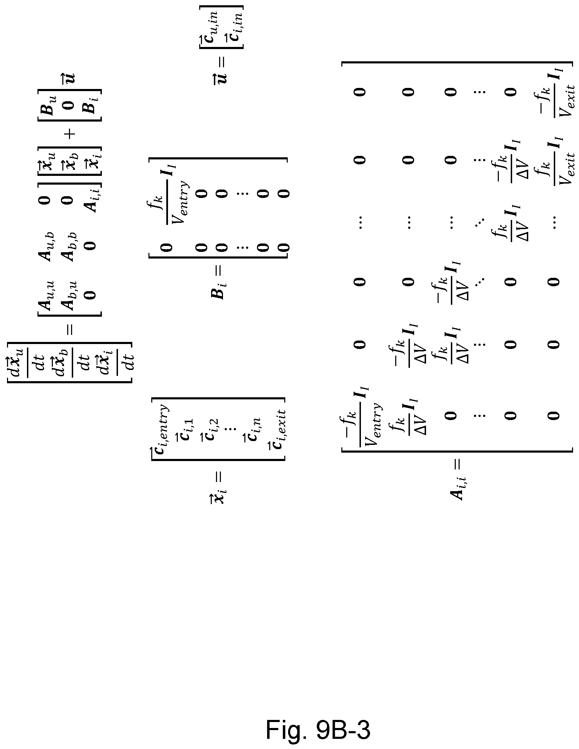

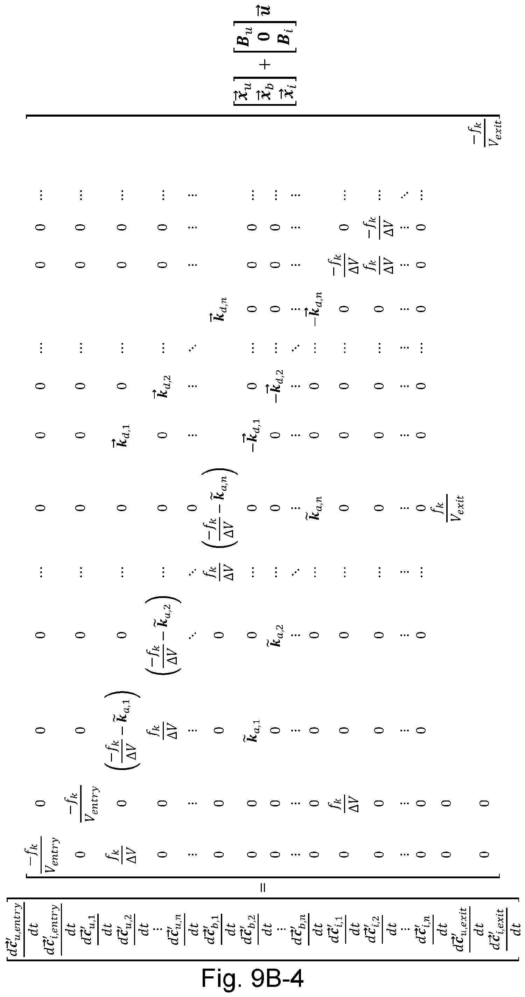

The model structure in the proposed approach combines physics-based elements for bulk flow (i.e. mass balances) with a new neural network architecture for binding and diffusion, as illustrated on **Figure** 3, using a mass balance module 20 implementing a physics-based bulk flow differential equations model (note this is an ordinary differential equations, ODE, model, not a partial differential equations, PDE, model), and a machine learning module 22 implementing a machine learning model to provide parameter estimates that are used by the mass balance module in the physics-based model. **Figure 6** shows the discretization scheme used to describe a generic chromatography column. Note that the same architecture is used regardless of the geometry of the column because the focus is on differential volume elements and the model does not explicitly model diffusion geometry. **Figure 6** illustrates schematically on the left a full chromatography column, and on the right the corresponding "stages" (also referred to as differential volume elements) represented in the model. The process receives a feed with a flow rate fₖ. The flow travels through an entry dead volume with volume V_{entry}, which is a volume that the mobile phase travels through outside of the column (i.e. prior to interacting with the stationary phase in the column). The flow then travels through a series of consecutive volumes labelled as stages 1 to N of volume ΔV (note that in the present examples all volumes ΔV are assumed to be the same for simplicity, but the volumes could in fact be different depending on the stage, in which case ΔV can be indexed with the stage number n, i.e. ΔVₙ - in the equations provided below ΔV is the volume of the stage n, which can also be written as ΔVₙ), in which the product interacts with the stationary phase. Finally, the flow travels through an exit dead volume with volume Vₑₓᵢₜ, which is a volume that the mobile phase travels through outside of the column (i.e. after interacting with the stationary phase in the column). The mass balances governing the discrete volume elements throughout the column (stages 1 to N) are given by Equations (1) to ( 3): $\frac{d {{c}^{⇀}}_{u , n}}{dt} = \frac{{f}_{k}}{ΔV} \left({{c}^{⇀}}_{u , n - 1}-{{c}^{⇀}}_{u , n}\right) - {{k}^{˜}}_{a} ∘ {{c}^{⇀}}_{u , n} + {{k}^{⇀}}_{d} ∘ {{c}^{⇀}}_{b , n}$ $\frac{d {{c}^{⇀}}_{b , n}}{dt} = {{k}^{˜}}_{a} ∘ {{c}^{⇀}}_{u , n} - {{k}^{⇀}}_{d} ∘ {{c}^{⇀}}_{b , n}$ $\frac{d {{c}^{⇀}}_{i , n}}{dt} = \frac{{f}_{k}}{ΔV} \left({{c}^{⇀}}_{i , n - 1}-{{c}^{⇀}}_{i , n}\right)$ where fₖ is the feed flow rate, ΔV is the volume of each stage, ${{c}^{⇀}}_{u , n}$ is a vector of concentrations of the unbound products in stage n (i.e. each element of the vector is a concentration of an unbound product within the current stage, i.e. within the n^{th} volumetric element), ${{c}^{⇀}}_{b , n}$ is a vector of concentrations of the bound products in stage n (i.e. each element of the vector is a concentration of a bound product within the current stage, i.e. within the n^{th} volumetric element), ${{c}^{⇀}}_{u , n - 1}$ is a vector of concentrations of the unbound products in the stage preceding stage n (i.e. each element of the vector is a concentration of an unbound product that flows into the current stage, i.e. the n^{th} volumetric element), ${{c}^{⇀}}_{i , n}$ is a vector of concentrations of the inerts in stage n (i.e. each element of the vector is a concentration of in inert within the current stage, i.e. within the n^{th} volumetric element), ${{c}^{⇀}}_{i , n - 1}$ is a vector of concentrations of the inerts in the stage preceding stage n (i.e. each element of the vector is a concentration of an inert that flows into the current stage, i.e. the n^{th} volumetric element), and ∘ denotes the Hadamard product (elementwise product). In these equations that *k̃ₐ* and ${{k}^{⇀}}_{d}$ describe the overall effect, at any given sampling time, of binding and diffusion on the bulk concentration for each non-inert species in the discrete volume. The full system of equations developed across all stages is shown on **Figure 9B**.

Note that the term "product" here refers to any molecule that interacts with the stationary phase. Typically this is the desired product(s) to be purified, although it is also possible within the same framework to include additional molecules that are not desired products but that can also interact with the stationary phase to some extent (e.g. impurities). This is by contrast with an "inert" which is any compound that does not directly interact with the stationary phase but where the presence of the compound can influence the interaction of the product(s) with the stationary phase. Representing the inerts (equation (3)) is optional in this model. For example, in situations where inert concentrations are unknown (i.e. there is no inert concentrations available for training the model) and/or inerts are not believed to materially affect the behaviour of the products, the model can use only equations (1) and (2).

In the entry dead volume and the exit dead volume, all concentrations remain unchanged - the volumes are taken into account to accurately reflect an observed time delay proportional to the feed flow rate and inversely proportional to the entry and exit dead volumes. The entry dead volume and exit dead volume additionally help to ensure the numerical stability of the solutions as no step change in concentration can be provided directly to the column dynamics, since all changes in concentrations set by the user occur at the inlet (before the entry dead volume) and at the outlet (after the exit dead volume). Step changes can cause large gradients that make the discretised solutions less accurate. Inclusion of entry and exit dead volumes accurately reflect the reality of the system (since it is not possible to build a physical chromatography system with zero dead volume) so their inclusion in the model is both accurate and helpful for the numerical integration.

The values in vectors *k̃ₐ* and ${{k}^{⇀}}_{d}$ are phenomenological parameters that describe the overall effect, at any given sampling time, of binding and diffusion on the bulk concentration for each non-inert species in the discrete volume. These can capture many different physico-chemical processes that are not explicitly modelled but contribute to the overall (i.e. observed bulk level) concentrations through dynamics that manifest themselves at the bulk level as binding (i.e. governing equilibrium between overall bound and unbound products) and diffusion (i.e. movement of the bound products). In other words, the above system of equations only represents three macrolevel phenomena in discrete volumes along the column: flow of unbound products in and out of the volume (and optionally flow of inerts in and out of the volume), diffusion of bound products, and binding of unbound products to the stationary phase. The latter two are parameterized with "catch-all" parameters in vectors *k̃ₐ* and ${{k}^{⇀}}_{d}$. These vectors are calculated as the output of a machine learning model, which is described below.

As will be explained further below, the parameter k̃ₐ is assumed to be a linearized version of a corresponding parameter ${{k}^{⇀}}_{a}$, calculated as ${{k}^{˜}}_{a} = {{k}^{⇀}}_{a} ∘ \left({{c}^{⇀}}_{tot}-{{c}^{⇀}}_{b}\right)$, where ${{c}^{⇀}}_{tot}$ is the total binding capacity of the column (also referred to as static binding capacity of the column). The parameter ${{k}^{⇀}}_{a}$ follows a traditional second order rate law form (Langmuir adsorption isotherm, which is a isotherm often used to model chromatography). Overall binding in equations (1) and (2) can be expressed as a ${{k}^{⇀}}_{a} ∘ \left({{c}^{⇀}}_{tot , n}-\right.$ $\left.{{c}^{⇀}}_{b , n}\right) ∘ {{c}^{⇀}}_{u , n}$, where ${{k}^{⇀}}_{a}$ describes a relationship that depends on both the number of still unbound binding sites ( ${{c}^{⇀}}_{tot , n} - {{c}^{⇀}}_{b , n}$) and the number of unbound molecules ( ${{c}^{⇀}}_{u , n}$), following a Langmuir adsorption model. The use of *kₐ* in the equations above and as an output of the machine learning model means that we can remove ${{c}^{⇀}}_{tot}$ as a parameter of the column model, which helps improve stability of the machine learning model training. This essentially makes the machine learning model responsible for accounting for the nonlinearity in the Langmuir model (since it is tasked with predicting a parameter *k̃ₐ* that captures a nonlinear phenomenon, the parameter being used in linear equations (1) and (2). As will be explained further below, the relationship between *k̃ₐ* and ${{k}^{⇀}}_{a}$ is only used when pretraining the machine learning model, as thereafter all training and predictions exclusively use *k̃ₐ*.

The number of stages N is not limited and any number of stages can be used. In practice, there is a balance between accuracy, stability and computational efficiency. The higher the number of stages the higher the resolution of the physical (mass flow) model, the lower the burden on the machine learning model to accurately capture complex dynamics, but also the higher the chance of numerical integration running into issues of instability due to the stiffness of gradients within small volumes. Thus, the higher the number of stages the higher the computational burden to run the model but the lower the computational burden (and training data requirement) to train the machine learning model. Conversely, the lower the number of stages the lower the resolution of the physical (mass flow) model, the higher the burden on the machine learning model to accurately capture complex dynamics (since more of the accurate capture of the dynamics of the entire system is pushed from the physical model to the machine learning model), and the lower the chance of numerical integration instabilities. Similarly, the lower the number of stages the lower the computational burden to run the model but the higher the computational burden (and training data requirement) to train the machine learning model. Higher number of stages are expected to result in higher accuracy predictions but the present inventors have found that very accurate results can still be obtained with very small numbers of stages, with lower numbers of stages reducing the risk of numerical issues due to very small gradients as the value of ΔV decreases and increasing the robustness of the predictions (avoiding overfitting of the machine learning model since as explained below the same model is used to predict the binding and diffusion coefficients in each of the stages). The present inventors tested numbers of discrete volumes from 5 to 20 and all led to results with similar accuracy (although the computational efficiency decreased with increased numbers of volumes). For general use, the present inventors settled on the use of 10 volumes as likely to ensure robustness, accuracy and computational efficiency across a vast range of scenarios. However, they believe that any number of volumes preferably including a plurality of volumes (i.e. 2 or more volumes) could be used.

Note that the machine learning model is trained for a specific set of products and inerts, and a specific static and mobile phase. However, the model is independent of the geometry of the column (and takes concentrations and feed flow rate as inputs) and therefore immediately usable for scale up and assessment of the effect of variations in feed concentrations and flow rate.

The functioning of the machine learning will now be explained. In the present example, as illustrated on **Figure 3****,** the machine learning model combines a parameter prediction submodel 22B (in these examples, a neural network), and a recurrent state submodel 22A (also referred to herein as "recurrent module"). The combination is referred to herein as "recurrent neural network", although it is not a recurrent neural network in the traditional sense of a network where nodes in one layer affect subsequent inputs to the same nodes. Indeed, here a recurrent module is added which captures information from preceding states and provides an input to the neural network per se. The recurrent module is optional. The recurrent module enables to capture dynamics of the system by enabling the machine learning model to make predictions informed by the previous state of the system. The architecture of the machine learning model used in the present examples is shown in **Figure 7****.** At each iteration *k* of integration of the physics based model (i.e. each time point that is being simulated), the model takes as inputs vectors of concentrations of unbound products ( ${{c}^{⇀}}_{u , k , n}$; i.e. for each stage n and iteration k, a vector comprising the respective concentration of unbound product for each of the respective products), bound products ( ${{c}^{⇀}}_{b , k , n}$; i.e. for each stage n and iteration k, a vector comprising the respective concentration of bound product for each of the respective products) and inerts ( ${{c}^{⇀}}_{i , k , n}$; i.e. for each stage n and iteration k, a vector comprising the respective concentration of inert for each of the respective inerts), and the flow rate fₖ, for all discrete volumes n. In the implementation used in the present examples, data from all stages of the column are passed to the neural network in one call (although the implementation prevents the network from making use of information about other stages when making predictions for any particular stage in order to reduce the risk of overfitting). This advantageously enables to parallelize the computation, for example enabling implementation on a multicore machine and/or GPU. Alternatively, the model could be used to predict parameters for each discrete volume n individually (which could still be run in parallel through multiple instances of the model). In either case, the machine learning model is trained to predict the parameters for each stage individually. In other words, the predictions for one discrete volume element (stage) do not depend on the predictions for another discrete volume element. Inclusion of the flow-rate variable allows the neural network to adapt to the changes in binding and diffusion effects observed in columns as flow changes. The modeling framework does not explicitly use physics-based equations derived from fluid-mechanics and binding dynamics, which is beneficial as it reduces the experimental burden of identifying the model. Instead, fluid-mechanic, binding and diffusion effects are learned from experimental data generated at different flow-rates. Because the flow variable, fₖ, is not used by the neural network in a first-principle derived equation, this variable may be "transformed" by the user before being passed to the neural network model. Transformations such as converting from volumetric-flow to linear velocity or residence time have been demonstrated in other simulation methods to result in models that are less scale dependent. This property is useful for applications where there is a desire to identify models form experiments conducted in small columns and make predictions using those models for larger-scale (commercial manufacturing relevant) columns. The present methods have been demonstrated to be applicable to scale up settings even without this transformation, but the transformation is simple to do in the present methods such that there is essentially only benefits to be expected from making the transformation.

The machine learning model as illustrated on **Figure 7** also takes as input a recurrent state vector ${{x}^{⇀}}_{r , k , n}$ which is a state vector for each iteration k and discrete volume n that allows the model to take into account information from one or more previous time steps captured in "catch-all" arbitrary states. As will be explained further below, the recurrent states store values that are obtained through a nonlinear transformation of the states of the column (vectors of concentration and flow rate) at preceding iterations, where the recurrent states values are updated at every iteration based on the values of the recurrent states at the preceding iteration and the states of the column at the current iteration. As explained further below, there is in principle no limit to dimension of the elements in ${{x}^{⇀}}_{r , k , n}$ (i.e. the number of recurrent states for each discrete volume element n that the model keeps track of at every iteration, i.e. the number of degrees of freedom in the recurrent state information). However, higher dimensions lead to higher complexity and potential overfitting, and the present inventors have found (see below) that 1 state was sufficient to accurately capture the dynamics of the system. Thus, unless indicated otherwise a single recurrent state is used for each stage. Note that although the model can in principle take into account states from any number of preceding iterations, in practice due to the physics of the system being modelled it is expected that the benefits of taking previous states into account are mostly in taking into account states that occurred in recent iterations. Indeed, the system has no "memory" of recurrent states beyond the immediately preceding recurrent state and the recurrence is designed to promote updating these states in every iteration. Note that recurrent neural network architectures such as long-short term memory networks (LSTM) could be used instead but these recurrence structures are designed to promote longer "memories" and therefore do not appropriately reflect the dynamic behavior (physics) of the system. This distinction also has a practical impact on training since LTSMs take into account many previous states, thereby making them far less computationally efficient, and less likely to converge to robust and accurate solutions than the presently proposed solution. As illustrated on **Figure 7****,** the states vector ${{x}^{⇀}}_{r , k , n}$ is concatenated with the other input variables (concentration vectors and flow rate), optionally after going through a tanh function (hyperbolic tangent function) to ensure that the state value does not increase to dominate the other input variables. Note that the tanh function can be omitted or replaced by any other function that can take an unbounded input and produce a bounded output, such as e.g. tanh or logistic/sigmoid functions. The concatenated input is fed into both (a) a recurrent state submodel (722A) and (b) a parameter prediction submodel (722B). The role of the recurrent state submodel 722A is to provide an updated state vector ${{x}^{⇀}}_{r , k + 1 , n}$ for use at the next iteration. The role of the parameter prediction submodel 722B is to provide predictions of the vectors *k̃ₐ* and ${{k}^{⇀}}_{d}$ for use at the current iteration k for a volume *n* (*k̃_{a,k,n}* and ${{k}^{⇀}}_{d , k , n}$) associated with concentrations ${{c}^{⇀}}_{u , k , n} , {{c}^{⇀}}_{b , k , n} , {{c}^{⇀}}_{i , k , n ,}$, flow rate fₖ, and current state vector ${{x}^{⇀}}_{r , k , n}$ . The flow rate is a parameter of the simulation, the concentrations ${{c}^{⇀}}_{u , k , n} , {{c}^{⇀}}_{b , k , n} , {{c}^{⇀}}_{i , k , n ,}$ are obtained by integration of the model provided by equations (1)-(3) (which itself uses predictions from the machine learning model for the *k̃ₐ* and ${{k}^{⇀}}_{d}$ parameters), and the state vector is predicted by the trained recurrent state submodel. The recurrent state submodel takes as input the same concatenated vector as that fed into the parameter prediction submodel 722B, and the current state vector (optionally after tanh or other bounding transformation). As illustrated, the recurrent state submodel 722A comprises two branches respectively including a sigmoid function with learnable weights vector ${{w}^{⇀}}_{a}$ and a tanh function with learnable weights vector ${{w}^{⇀}}_{u}$, both of which take as input the concatenated vector that is fed into the parameter prediction submodel 722B. Note that any function that can provide an output between 0 and 1 can be used instead of the sigmoid function, and any function that can provide a bounded output from an unbounded input can be used instead of the tanh function. The first branch with learnable weights vector ${{w}^{⇀}}_{a}$ produces as output a factor α which can be seen as a "forgetting factor" and represents a probability that the state vector is not updated at the current iteration. The lower the value of alpha the more likely the current state is updated (i.e. the higher the value of (1-α) the more likely the current state is updated - note that α could be used instead with the opposite consequences). The second branch with learnable weights vector ${{w}^{⇀}}_{u}$ determines a proposed update to the current state vector. If α=1, the current state (illustrated as "x" on **Figure 7****)** is simply used as it is for the next iteration (i.e. no update, top branch evaluates to 0). If α<1, the current state (illustrated as "x" on the top branch of Figure 7) is updated to a value that is the sum of (1- *α)x* where x is the current state (i.e. current state multiplied by 1- α) and *αx* where *x* is an updated state that is output by the tanh function with learnable weights ${{w}^{⇀}}_{u}$. In other words, a new updated state vector is obtained as a weighted sum of the current state and a new proposed state, with weighting factor (1- α) and α, respectively for the current and proposed new states. The parameter prediction submodel 722B is illustrated here as a simple fully connected neural network with parameters **W**^{[1...L]} which are weights associated with each neuron in each layer L. The weights ${{w}^{⇀}}_{a} , {{w}^{⇀}}_{u}$, and **W**^{[1...L]} are all learned together using a training procedure that will be described below.

The recurrence structure in the proposed neural network was designed specifically for this application. In essence, this application of the recurrent network removes the "long memory" part of the LSTM structure since it is very unlikely that a state observed many sampling instances in the past would influence the current dynamics of the system. Instead, the proposed structure can be viewed as adding "free" states which evolve with nonlinear dynamics determined by the neural network. It is left to the training algorithm to determine how to best apply these new nonlinear dynamics. The use of recurrent states enables to capture dynamic behavior caused by diffusion. This diffusion effect may occur in binding substrates, mobile phase, or other parts of the pathway between the bulk liquid phase and binding sites within the column. Many prior art models explicitly or implicitly ignore diffusion effects, which are hard to model with first principles models.

An important benefit of the proposed approach is that the same training weights are used by the neural network at every discrete volume in the spatial discretization of the column. In other words, the vectors in in *w̅ₐ, w̅ᵤ, and W are* not indexed by n. Practically, the implication of this decision is that the dynamic response of the column should be the same at the inlet that it is at the outlet. This design decision is technically accurate for new columns where the stationary phase should be homogeneous throughout the column volume. In older columns, it is possible that this assumption would be less accurate due to irreversible binding effects which may disproportionately influence the inlet portion of the column. This can be addressed by providing to the machine learning model one or more additional inputs (additional states) that are indicative of the age of the column. For example, the machine learning model can additionally take as input a variable indicative of the number of cycles (i.e. number of complete load, wash, elute, regenerate cycles) that the column has experienced, or a variable indicative of the total number of column volumes that the column has experienced. Instead or in addition to this, the machine learning model can be trained using training data comprising data for a plurality of complete cycles, enabling the model to learn how the column parameters change over time. However, there are substantial advantages to training a single binding dynamic model for the whole column in terms of greatly reducing the likelihood of overfit. This approach parallels techniques developed in image analysis using tied weights in convolutional neural networks. In both cases, by training the weights on "sliding views" of the same system, localized anomalies are down-weighted and a more representative set of weights emerges in the training process.

### Model training

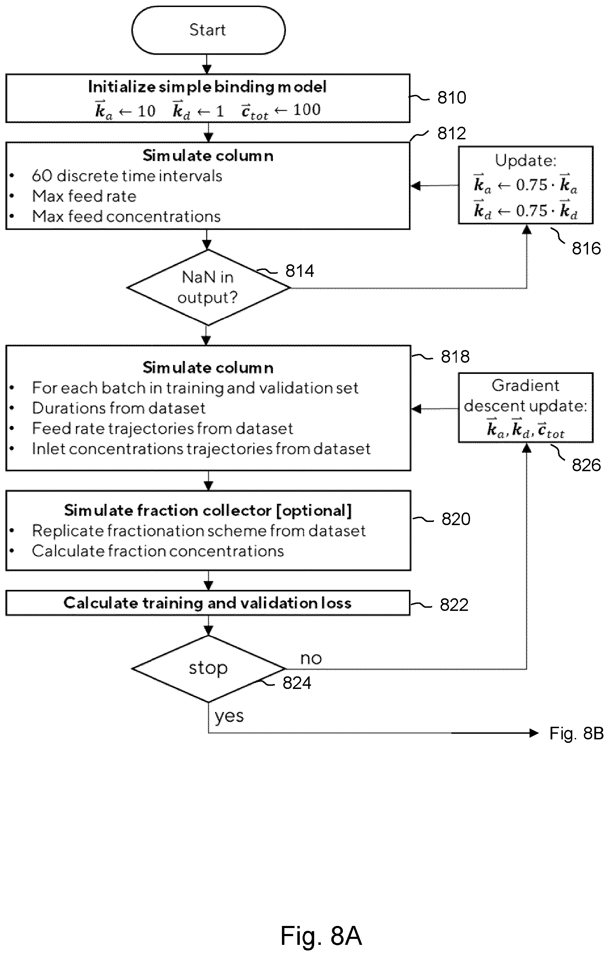

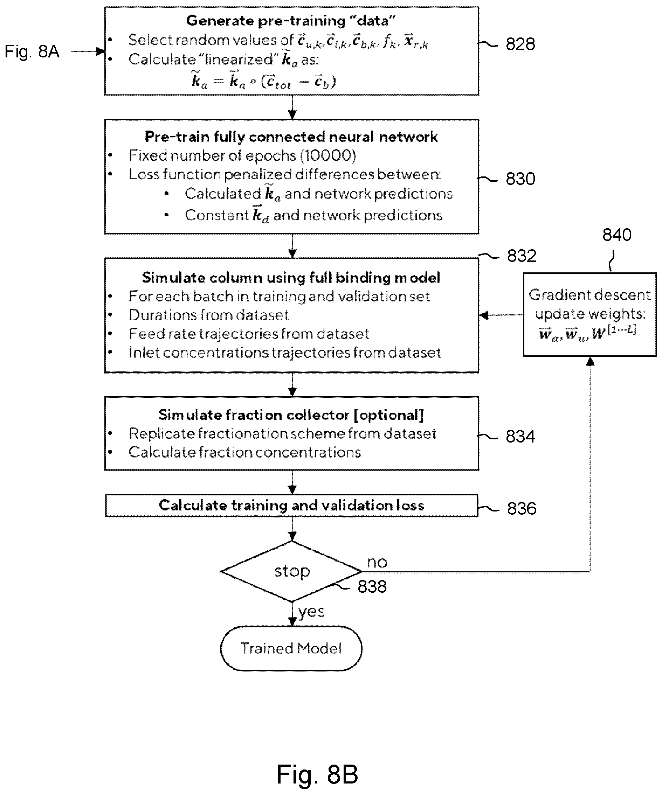

A training algorithm was developed by the inventors which enables reliable training of neural networks for binding kinetic behavior from commonly available, column eluate (outlet) data, including experimental data collected using a fraction collector (fractionated) on the column outlet stream. This algorithm is believed to be novel in at least three ways. First, the approach directly accounts for the aggregation of samples that occurs through fractionation in common, lab scale, chromatography experiments during product development. Ability to use fractionated sample data makes the proposed technique practically viable compared to alternatives that require complete time-series concentration data. Second, the inventors have developed a series of heuristic techniques for training the proposed recurrent neural network in stages to achieve numerically stable gradient descent during the training phase. Finally, the inventors have developed a method for linearizing and discretizing spatial dimensions (through the use of the differential volume elements model described above) and time dimensions (through the use of discretized time steps corresponding to iterations of the process of machine learning model prediction and solution of the column model ODEs) in the problem. This discretization algorithm removes the need for application of adaptive step-size partial differential equation solvers. As a consequence, the algorithms proposed are readily implementable in computational graph environments, like PyTorch, such that loss function errors can be backpropagated through the physics equations, to the neural network, and ultimately the training weights. The complete training algorithm flow sheet is shown on **Figure 8****.**

At step 810, the model is initialized using default values for ${{k}^{⇀}}_{a}$ and ${{k}^{⇀}}_{d}$ (here illustrated as 10 and 1, respectively, for all n stages) and for ${{c}^{⇀}}_{tot}$ (here illustrated as 100). The parameter ${{c}^{⇀}}_{tot}$ is a vector of the respective total binding capacity (static binding capacity) of the column for each of the respective products. This parameter is only explicitly used in the pretraining steps illustrated on **Figure 8** as steps 810-830. At step 812, the column is simulated by solving the column model provided by equations (1)-(3) using these default values and the maximum feed concentration and maximum feed rate available in the training data. In the illustrated embodiment, the model is iteratively solved over 60 discrete time intervals. The length of time corresponding to any number of intervals k depends on the temporal discretization frequency (i.e. length of time corresponding to an iteration k), which is a user defined parameter (as is the total number of iterations). The present inventors have found that for most reasonable temporal discretizations, 60 sampling instances was long enough to observe any instability in the model since the most numerically unstable time in most column loading data comes early in the run since that is when concentrations are changing the most and therefore the gradients (stiffness) of the problem is highest. Therefore, for this pretraining step 60 iterations was found to be sufficient. Note that in practice when simulating a column (i.e. not in model training), the model can be allowed to run for as many iterations as necessary to capture the behaviour of the column that the user is interested in (e.g. full loading phase until a plateau in the breakthrough curve is reached). At k=0, initial values of ${{c}^{⇀}}_{u , k , n} , {{c}^{⇀}}_{b , k , n} , {{c}^{⇀}}_{i , k , n ,}$ are assumed. These are typically 0 for the bound and unbound products (as when simulating a loading phase the column has not yet been loaded with product), and either 0 or constant values for any inerts that are present in the buffer initially filling the columns. These concentrations (concentrations of any inerts modelled in the buffer initially filling the column) are known for a particular chromatography process to be modelled. When modelling a wash or elution phase, the initial values of ${{c}^{⇀}}_{u , k , n} , {{c}^{⇀}}_{b , k , n} , {{c}^{⇀}}_{i , k , n ,}$ can be obtained from simulation of the preceding phase. At step 814, it is checked whether the simulated output contains any NAs, i.e. whether the numerical integration ran into instability issues due to stiffness of gradients in the volume elements over the chosen time intervals. In the affirmative, the current default values for ${{k}^{⇀}}_{a}$ and ${{k}^{⇀}}_{d}$ are reduced by a predetermined factor, here illustrated as 25% (although any other value can be used), at step 816. Steps 812, 814 and 816 are repeated iteratively until the current values for ${{k}^{⇀}}_{a}$ and ${{k}^{⇀}}_{d}$ are such that the model converges for all time points (i.e. there are no longer any instability issues). At step 818, the column is simulated using the values for ${{k}^{⇀}}_{a}$ and ${{k}^{⇀}}_{d}$ obtained at the last iteration of steps 812, 814 and 816, for each data set in the training and validation data, using a number of discrete time intervals corresponding to the durations from the respective data sets, with feed rate trajectories from the respective datasets and inlet concentrations trajectories from the respective datasets. If any of the training and validation datasets are fraction data, the corresponding simulations obtained at step 818 are converted to fraction results at step 820, by replicating the fractionation scheme from the respective data set (i.e. combining the volumes of effluent corresponding to the respective fractions) and calculating the corresponding concentrations. Note that this is optional and only performed if the data contains fraction data. At step 822, a training and validation loss (all losses shown are mean square error, MSE, although root mean square error, RMSE has also been used with the same results) are calculated as the difference between the simulated and observed data from the training set and validation set, respectively. At step 824, one or more stopping criteria applying to the losses calculated at step 822 are evaluated. In the present examples the stopping criteria included a criterion on the validation loss (i.e. validation loss was used for early stopping). In the present examples, the validation data was also used for learning rate scheduling, where the learning rate is adaptively reduced based on the rate of improvement of the validation data. This is optional and the model could also be trained using the training data alone. When one or more of the stopping criteria are satisfied, ${{k}^{⇀}}_{a} , {{k}^{⇀}}_{d}$ and ${{c}^{⇀}}_{tot}$ are set to the values used at the current iteration. While the stopping criteria are not satisfied, a gradient descent procedure is used to obtain updated values of ${{k}^{⇀}}_{a} , {{k}^{⇀}}_{d}$ and ${{c}^{⇀}}_{tot}$ at step 826. These are then used in a further iteration of steps 818, 820, 200 and 824.

As a result of the procedure explained above, "warm start" values of ${{k}^{⇀}}_{a} , {{k}^{⇀}}_{d}$ and ${{c}^{⇀}}_{tot}$ are obtained. Specifically, steps 810-816 serve to ensure that the process of identifying starting values for ${{k}^{⇀}}_{a} , {{k}^{⇀}}_{d}$ and ${{c}^{⇀}}_{tot}$ starts with initial guesses that do not lead to numerical instability when integrating the column model (simply by reducing the value of these parameters until small enough gradients occur in the model for it to be solvable at all iterations). This is performed on a single default setting (which can be informed by the training / validation data) and is therefore extremely computationally efficient. Steps 818-826 then serve to provide starting values that are informed by the training and validation data, by exploring a space of values that is unlikely to lead to numerical instability. This is less computationally efficient than steps 810-816 because it requires a separate simulation for each set of operating parameters in the training and validation data, but is still highly computationally efficient compared to steps that also update the weights of a machine learning model at each iteration. The resulting values are used to provide a "warm start" to the training of the machine learning model, which ensures that model training converges every time. Note that steps 810-826 (and steps 828-830 through which weight values for the machine learning model corresponding to these warm start values are obtained) can be omitted and the machine learning model can be trained with default weights ${{w}^{⇀}}_{a} , {{w}^{⇀}}_{u}$, and W^{[1...L]} (which can be e.g. all the same value, random values, or values from a previously trained model if available). This is essentially equivalent to performing only steps 810 and 832-840. However, this has a much higher likelihood of the model failing to converge because of numerical instability.

At step 828, pre-training data is generated by randomly sampling values of ${{c}^{⇀}}_{u , k , n} , {{c}^{⇀}}_{b , k , n} , {{c}^{⇀}}_{i , k , n ,}$ fₖ and ${{x}^{⇀}}_{r , k}$ and calculating a linearized value of ${{k}^{⇀}}_{a}$ (*k̃ₐ*) based on the ${{k}^{⇀}}_{a}$ and ${{c}^{⇀}}_{tot}$ obtained from steps 810-826, by calculating ${{k}^{˜}}_{a} = {{k}^{⇀}}_{a} ∘ \left({{c}^{⇀}}_{tot}-{{c}^{⇀}}_{b}\right)$. The random sampling is performed within respective ranges for each of the values defined based on the range of values seen in the forward pass steps of the initial fit at step 818. For example, ranges calculated as ±20% (or any other % such as 10, 15, 20, 25, or 30%) of the ranges seen in the forward pass steps of the initial fit at step 818 can be used. As explained above, the use of *k̃ₐ* instead of ${{k}^{⇀}}_{a}$ and ${{c}^{⇀}}_{tot}$ reduces the number of parameters coming out of the neural network, reducing the number of possible solutions, which helps the solver converge, and including the relationship between ${{c}^{⇀}}_{tot}$ and ${{k}^{⇀}}_{a}$ in the neural network through *k̃ₐ* makes the solution a lot more stable and computationally tractable. At step 830, the pre-training data obtained at step 828 is used to pretrain the neural network (in the illustrated embodiment a fully connected neural network and recurrent module) using a fixed number of epochs (e.g. 10000 although other numbers can be used), and a loss function that penalizes: (i) differences between the *k̃ₐ* from step 828 and network predictions for *k̃ₐ*, and (ii) differences between the ${{k}^{⇀}}_{d}$ from steps 810-826 and network predictions for ${{k}^{⇀}}_{d}$. In essence, step 830 serves to train the model to provide predictions that match the "warm start" predictions obtained through steps 810-826. The corresponding pretrained weights ${{w}^{⇀}}_{a} , {{w}^{⇀}}_{u}$, and **W**^{[1...L]} are then further trained using the training data and a back propagation strategy at steps 832-840. In particular, the column model is simulated at step 832 using the *k̃ₐ*, ${{k}^{⇀}}_{d}$ values from steps 810-826, for each data set in the training and validation data, using a number of discrete time intervals corresponding to the durations from the respective data sets, with feed rate trajectories from the respective datasets and inlet concentrations trajectories from the respective datasets. If any of the training and validation datasets are fraction data, the corresponding simulations obtained at step 832 are converted to fraction results at step 834, by replicating the fractionation scheme from the respective data set (i.e. combining the volumes of effluent corresponding to the respective fractions) and calculating the corresponding concentrations. Note that this is optional and only performed if the data contains fraction data. At step 836, a training and validation loss (MSE, although again RMSE or other losses would produce the same results) are calculated as the difference between the simulated and observed data from the training set and validation set, respectively. At step 838, one or more stopping criteria applying to the losses calculated at step 836 or the gradient applied to the weights at step 840 are evaluated. When one or more of the stopping criteria are satisfied, the weights ${{w}^{⇀}}_{a} , {{w}^{⇀}}_{u} ,$ and W^{[1...L]} are set to the values used at the current iteration, i.e. a trained model is obtained. While the stopping criteria are not satisfied, a gradient descent procedure is used to obtain updated values weights ${{w}^{⇀}}_{a} , {{w}^{⇀}}_{u} ,$ and **W**^{[1...L]} at step 840 based on the training loss. As explained above, the validation loss is used both as part of an early stopping criterion, and for learning rate scheduling, where the learning rate is adaptively reduced based on the rate of improvement of the validation data. This is optional and the model could also be trained using the training data alone.

Solving of the column model (at steps 818 and 832) is explained in the "model deployment" section below, and follows the same principles at model training time and model deployment time. To solve the column model, at each discrete time point, k, the column model is discretized based on the current state (concentrations and recurrent state) of the system, as explained below. In particular, the concentrations and recurrent states are put through a forward pass of the neural network (722B) and the output values from that network (*k̃ₐ,* ${{k}^{⇀}}_{d}$) are then plugged into the ODE equations of the column model, which is solved over a discrete time step.

### Model deployment

**Figure 9** illustrates the method used to deploy the above-described model, i.e. to simulate a column using a trained hybrid model as described above. **Figure 9A** illustrates the general principles applied. First, predictions for *k̃_{a,n},* ${{k}^{⇀}}_{d , n}$, and ${{x}^{⇀}}_{r , k + 1 , n}$ for all n E [1, ··· , *N*] are obtained using the machine learning model (here the neural network described above) and inputs: ${{x}^{⇀}}_{r , k , n} , {{c}^{⇀}}_{u , k , n} , {{c}^{⇀}}_{b , k , n} , {{c}^{⇀}}_{i , k , n}$ *fₖ.* These *k̃_{a,n}*, ${{k}^{⇀}}_{d , n}$ are used as parameters of the model in equations (1)-(3), to solve the column model at the current discrete time point k. In particular, the ODEs in (1)-(3) are linearised around the current state (defined by ${{c}^{⇀}}_{u , k , n} , {{c}^{⇀}}_{b , k , n} , {{c}^{⇀}}_{i , k , n}$ *fₖ*). Note that in both training and subsequent application of the model, the recurrent states ${{x}^{⇀}}_{r , k , n}$ are initialized at 0 (i.e. they are 0 at k=0). Since these states are arbitrary, that is a safe assumption as long as the training and application are consistent. As explained above, ${{c}^{⇀}}_{u , k , n}$, ${{c}^{⇀}}_{b , k , n}$ are initialized to 0 for the bound and unbound products when using concentrations as described in the present example, and a default value when using latent variable values as will be explained in Example 4, where the default value can latent variable values corresponding to the buffer solution or 0 when all latent variable values are centred using said buffer latent variable values - since under normal conditions, the column is pre-conditioned with buffer -i.e. at the initial time the column only contains buffer, and it is a safe assumption that no buffer binds to the column. , ${{c}^{⇀}}_{i , k , n}$ are initialized to 0 or a known concentration in the buffer filling the column, for the inerts. It is also possible to initialize these values to any known concentrations (e.g. from previous phase simulations or for situations in which some amount of irreversible binding is expected such that ${{c}^{⇀}}_{b , k , n}$ is not 0 at k=0).

The matrices on **Figure 9B** show how the linearized system dynamics and linearized states are constructed. Once linearized (by obtaining the predictions from the machine learning model, which capture all nonlinearities, i.e. given a specific prediction of *k̃ₐ*, ${{k}^{⇀}}_{d}$ for a current time step, equations (1)-(3) are linear, although formally (i.e. when considered not in the context of a single iteration with fixed predicted values for each of these parameters) they are nonlinear since these parameters change over time in a nonlinear manner), the system is solved over the discrete interval by calculating a discrete state-space model: ${\left({e}^{\left[\begin{matrix}A & B \\ 0 & 0\end{matrix}\right]}\right)}^{T} = \left[\begin{matrix}{A}_{d} & {B}_{d} \\ 0 & I\end{matrix}\right]$ where A and B are the matrices shown in the top part of **Figures 9B1-9B3**, and developed on **Figure9B-4**, i.e.: $\left[\begin{matrix}\frac{d {\vec{x}}_{u}}{dt} \\ \frac{d {\vec{x}}_{b}}{dt} \\ \frac{d {\vec{x}}_{i}}{dt}\end{matrix}\right] = A \left[\begin{matrix}{\vec{x}}_{u} \\ {\vec{x}}_{b} \\ {\vec{x}}_{i}\end{matrix}\right] + B \left[\begin{matrix}{\vec{c}}_{u , i , n} \\ {\vec{c}}_{i , i , n}\end{matrix}\right] where A = \left[\begin{matrix}{A}_{u , u} & {A}_{u , b} & 0 \\ {A}_{b , u} & {A}_{b , b} & 0 \\ 0 & 0 & {A}_{i , i}\end{matrix}\right] , B = \left[\begin{matrix}{B}_{u} \\ 0 \\ {B}_{i}\end{matrix}\right] .$

Having calculated A_{d} and B_{d} as the results of the matrix exponential in equation (4), it is trivial to calculate the updated state for one or more intervals (until the linearization has substantially changed, i.e. until the values of A and B are substantially different) using: ${x}_{k + 1} = {A}_{d} {x}_{k} + {B}_{d} {u}_{k}$ where xₖ₊₁ is any updated state (i.e. any of ${{c}^{⇀}}_{u , k + 1 , n} , {{c}^{⇀}}_{b , k + 1 , n} , {{c}^{⇀}}_{i , k + 1 , n}$) and x is the corresponding current state (i.e. any of ${{c}^{⇀}}_{u , k , n} , {{c}^{⇀}}_{b , k , n} , {{c}^{⇀}}_{i , k , n}$). By default, the values of A_{d} and B_{d} can be recalculated at every iteration. However, as calculating equation (4) is computationally expensive compared to the rest of the solving process, it is possible to increase computational efficiency significantly by calculating the values of the A and matrices at each iteration, comparing them to the previous iteration, and reusing the values of A_{d} and B_{d} from the previous iteration to calculate xₖ₊₁ at the current iteration if the values of A and B have not changed by more than predetermined thresholds (i.e. the same A_{d} and B_{d} can be used to calculate updated states for a plurality of subsequent intervals, each associated with values of A and B that are within predetermined ranges from the values of A and B from which the values of A_{d} and B_{d} were calculated).

Interestingly, the inventors have observed anecdotally that any error introduced by the linearization scheme (particularly in the spatial dimension - i.e. any errors introduced by the discretization in stages) can be easily accounted for by the learned dynamics of the recurrent neural network. In other words, the approach is robust to the number of stages used. At the same time, the physics-based structure of the flow model prevents the data-driven components of the model from producing invalid outputs (such as negative concentrations).

### Example 2 - Demonstrating Uses of the Universal Chromatography Model

The use of the approach described in Example 1 has been demonstrated on a variety of datasets and for a range of applications.

### Recipe Optimisation

Firstly, the inventors demonstrated the use of the method for exhaustive characterisation of the design space of a chromatography process, e.g. for process optimisation and scale up.

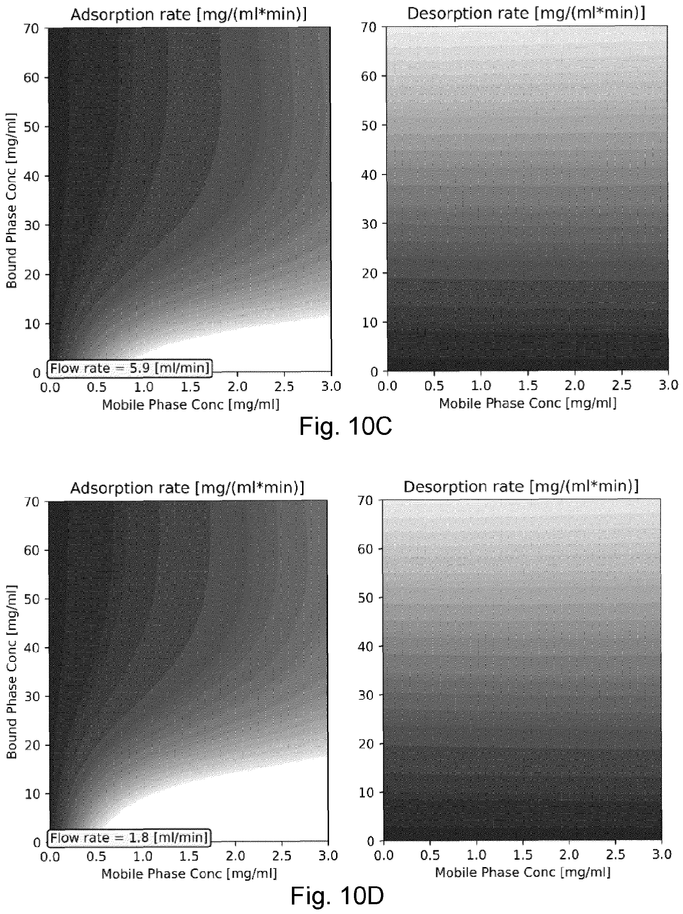

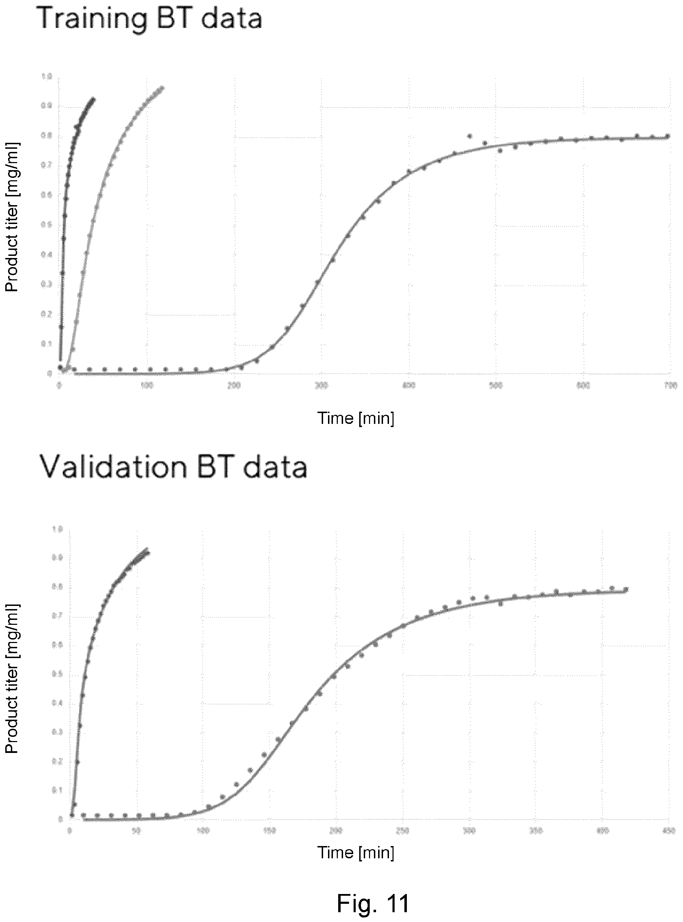

**Figure 10A-D**show the results of a simulation of a chromatographic process using methods described herein with varying values of the flow rate through the chromatographic process **(A:** flow rate=20 ml/min, B: flow rate=13.9 ml/min, **C:** flow rate=5.9 ml/min, **D:** flow rate=1.8 ml/min). Each panel shows adsorption rate (*k̃ₐ*) and desorption rate ( ${{k}^{⇀}}_{d}$) calculated from simulated data at the indicated flow rate over a range of mobile phase concentration (_{cu}) and bound phase concentrations (c_{b}) of the product (in this case a monoclonal antibody on a protein A column). The adsorption rate and desorption rate are calculated by holding the recurrent states at nominal (zero) values and then sweeping through a mesh-grid (i.e. exhaustive combinations) for a range of Cu and Cb values with the different flow rates. **Figure 11** shows representative model prediction performance for both training data (i.e. data used to identify model parameters) and validation data unseen by the training algorithm, for the same column and product. Scatter points (filled circles) in this figure represent experimental measurements of product concentration at column outlet (monoclonal antibody titer in mg/ml) while solid lines represent corresponding model predictions. Examples are shown for three different feed-flow rates used as training data and two feed-flow rates used as validation cases. **Figure 10** shows how the binding model (data driven component) works for hypothetical concentrations, where mobile phase and binding phase concentrations (Cu and Cb) were generated in a mesh grid across ranges that were representative of values seen in the training stages of the model. These concentrations were fed to the forward pass of the neural network (722B from Figure 7) with a flow rate also drawn from the range in the training data. The resulting output values for *k̃ₐ* and ${{k}^{⇀}}_{d}$ are shown in the heatmaps. Significantly, these heatmap figures allow human readable insight into the relationships captured by the neural networks making the model interpretable (unlike many black-box, purely data-driven model). For instance, we can clearly understand from the figure that, as expected, overall adsorption is highest when the mobile phase concentration is relatively high and the bound phase concentration is relatively low. **Figure 11** shows predictions made using those relationships for real set ups (with corresponding experimental data, showing that the predictions from the machine learning model and corresponding column behavior simulations have high accuracy over a range of seen and unseen conditions).

### Transition from batch to continuous chromatography

Further, the inventors demonstrated the use of the method to enable the transition from batch to continuous chromatography. In particular, the inventors applied the described modelling framework for predictions of multi-column chromatography systems from batch data. This allows a process development team, without access to a lab-scale multi-column setup, to predict how a multi-column chromatography device would improve on traditional batch chromatography.

So called "continuous" chromatography using multiple columns connected in series during the loading phase of preparative chromatography is a relatively new technology in biomanufacturing. In other words, instead of the traditional batch chromatography in which the product is loaded into one column, washed and then eluted, in multi-column chromatography columns are placed in series. The product is loaded onto the first column and the breakthrough is captured onto the second column, then when the first column is saturated (or at a predetermined % of product breakthrough) the feed switches to directly load column 2 (which breaks through onto column 3 if available). While column 2 is being loaded, column 1 is washed, eluted and regenerated. Once column 1 is ready again and column 2 is saturated (or at a predetermined % of product breakthrough), column 2 is washed, eluted and regenerated and the feed switches to column 3, while the breakthrough from column 3 goes to column 1.

There are readily understandable theoretical advantages to using continuous chromatography systems. Perhaps the strongest of these arguments is the ability to use the complete column binding capacity without losing product during the loading phase. However, despite these advantages, adoption of continuous chromatography technology into commercial biomanufacturing has been limited. One of the implementation challenges preventing adoption of this technology is the relatively more complex task of designing recipes for multi-column systems compared to traditional, single-column, batch chromatography. Modeling tools are a potential solution to this adoption problem. Simple tools have been designed to aid in use of continuous chromatography systems, such as the Resolute^{®} BioSC and Resolute^{®} BioSMB platforms from Sartorius Stedim Chromatography Systems. These typically rely on simple, column capacity calculations to help determine durations for each step in the multi-column recipe. While these tools have been helpful for simple, traditional use-cases (e.g. protein A resin columns for mAb capture), they may not correctly predict performance for advanced columns (e.g. resin columns, monoliths, etc.) and advanced therapeutics (e.g. viral chromatography applications). Furthermore, these tools typically do not accurately account for the impact of varying feed-rates, feed-titers, and impurity profiles. In most cases, this means that recipes generated are at best starting points, from which additional experimentation is needed to identify final recipes. The flexibility and broad applicability of the universal column modeling proposed in this work makes it an attractive alternative for use in multi-column recipe design. Furthermore, the computational efficiency of the proposed method makes it suitable for use in numerical optimization to automate multi-column recipe design.

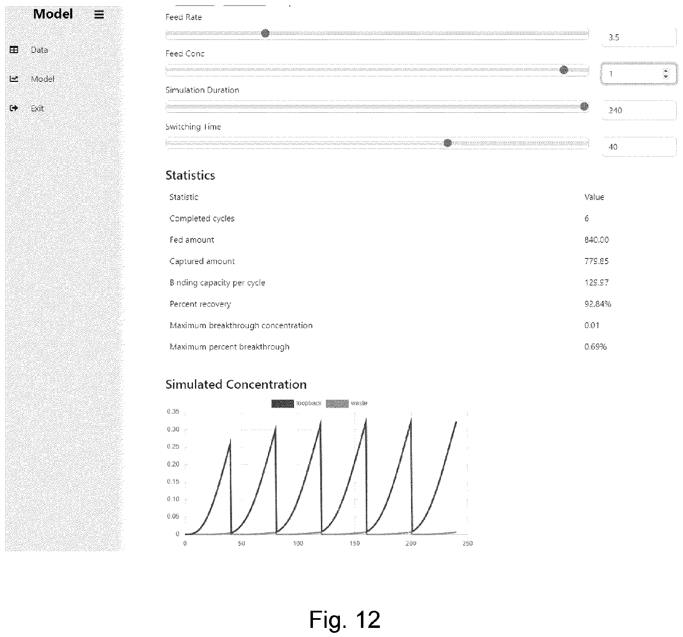

The proposed modeling framework has been used in a prototype application to aid in recipe design for multi-column chromatography systems. A screenshot of this application is shown in **Figure 12****.** The application works by connecting two instances of the model such that the outlet concentration of the first simulated column becomes the feedstock of the second column. In this way, the mobile phase concentration of the multi-column system can be forecast for different recipe parameters. The model used was a 2 layer deep network with 30 activation functions (i.e. 30 nodes) per layer. Two recurrent states were used. The model was trained on batch breakthrough curve experiments in a resin protein A column (a 5 ml Cytiva MabSelect column). The product of interest was a monoclonal antibody. The model was trained with three breakthrough curves at differing feed rates (1.5 ml/min to 10 ml/min) and feed concentrations in the range of 0.8 to 1 g/L. The validation of the model was done with two additional breakthrough curves at novel feed rates and concentrations. Fractions for these experiments were collected in 1 ml volumes. The fraction titers were determined through size exclusion chromatography (SEC). The parameters varied through recipe design were: feed rate (ml/min), feed conc (g/L), simulation duration (minutes), and switching time (i.e. how long to load each column from fresh feed) (minutes). In the illustrated multi-column mode, there are three columns (in some situations, even more). Initially, column 1 is fed from fresh feed and column 2 is fed from the eluate of column 1. Column 3 is in elution/regeneration. When the switching time is reached, column 1 goes into regeneration, column 2 gets fed from fresh feed and column 3 (freshly regenerated) gets fed from the eluate of column 2. The next cycle after that, column 3 is fed from fresh feed, column 1 gets fed from the eluate of column 1 and column 2 goes into regeneration. This process ensures that a fresh column is always at the end of the chain to prevent product loss from the column that is being loaded from fresh feed. In **Figure 12****,** the blue line represents the concentration of the target product flowing between the first and second column in series (i.e. concentration of the product in the effluent of the first column) while the pink line represents the concentration of the product leaving the second column. The user can manipulate loading time, feed rates, and titers by changing sliders to simulate different conditions which could be experienced in production and develop a multi-column recipe robust to these variations. The results of the simulation (concentration of the product in the effluent of the columns as a function of time) also enable the calculation of the total captured amount (calculated as the sum of c_{b} over all stages at the end of loading of the column multiplied by ΔV, before regeneration occurs - this assumes that the loaded product will be completely recovered in the elution phase), binding capacity per cycle (calculated from the total captured amount for the cycle as total amount captured divided by (number of cycles * volume of the column)), percent recovery (calculated from the total captured amount as total captured amount divided by integrated concentration in the feed over the loading phase), maximum breakthrough concentration (maximum concentration of the product observed at the outlet of the last column in series, over the simulation) and maximum percent breakthrough (ratio of the maximum breakthrough concentration and feed concentration).

### Comparison of different chromatography technologies

Another practical use case of the approach described is to compare different chromatography technologies, such as e.g. different stationary phases (e.g. membranes, monoliths and resins). Because the framework is agnostic to the type of stationary phase (which effects are captured in the training of the machine learning model), it is possible to compare different technologies directly within the same modelling framework (albeit using respective machine learning models trained using training data acquired using the respective technologies).

The present inventors demonstrated this potential by training two machine learning models (both comprising a neural network with the architecture on **Figure 7****,** where the prediction submodel 722B is a fully connected neural network with 2 hidden layers each comprising 20 nodes, and the final layer comprises 2 notes each with a tanh activation function, respectively for prediction of *k̃_{a,k,n}* and ${{k}^{⇀}}_{d , k , n}$) on data from columns for purification of protein A using different stationary phases, namely MAbSelect SuRe Resin chromatography and Sartobind Rapid A membrane chromatography. Each machine learning model was trained as explained in example 1 for 1000 epochs using 4 experimentally determined breakthrough curves obtained with the respective chromatograph technology. The models were trained in approximately 3 minutes on an Intel I9 14900K processor. They were then used to simulate the columns using the same parameters, i.e. feed rate=2.5 ml/min, feed concentration=1, simulation duration=200 minutes, breakthrough threshold %=5.

**Figure 13** shows the results of this experiment for **(A-B)** a MAbSelect SuRe Resin chromatography (calculated breakthrough time=53.77 min, calculated dynamic binding capacity=134.42 mg/ml) and **(C-D)** Sartobind Rapid A membrane chromatography (calculated breakthrough time=24.10 min, calculated dynamic binding capacity=50.20mg/ml). A and C show the results of the simulation, and B and D show model validation data and associated R² and RMSE between predicted (solid lines) and observed (points) breakthrough curves.

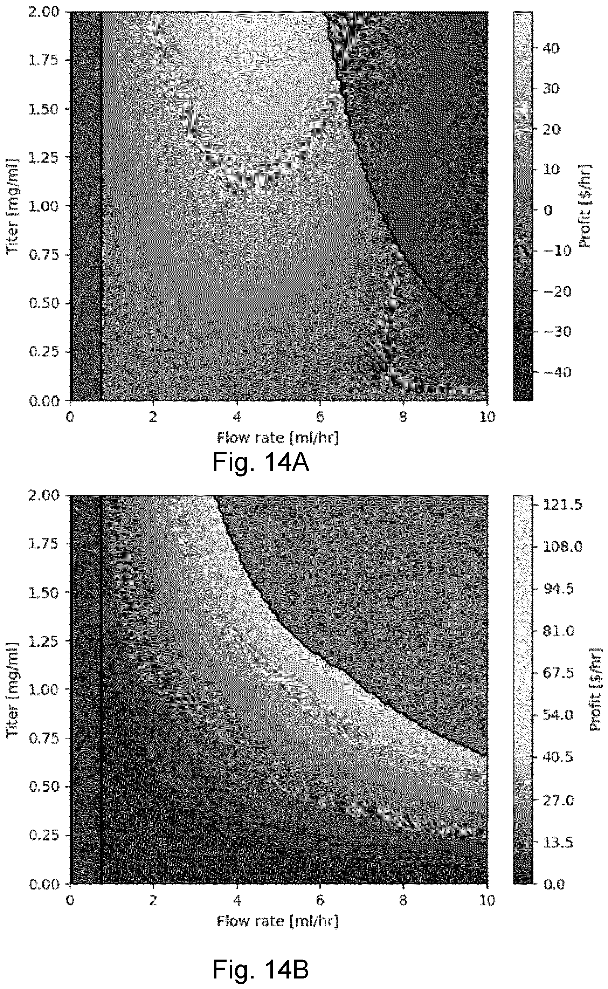

The models used to generate the data on **Figure 13** were then used to exhaustively estimate the economic impact of different recipes using the respective chromatography platform. In particular, the two chromatography platforms were simulated for a grid of flow rate values and titer values (concentration of the product in the feed). Note that the columns have the same volume so this is a direct comparison of the two platforms for the same operating parameters and mobile phases. The costs and gain associated with each recipe were then estimated using an economic model that took into account the costs associated with regeneration (using a known fixed cost per regeneration associated with each column and a an assumption of a fixed number of cycles lifespan for the columns, here 100 regenerations - although any numbers corresponding to the known or expected lifespan of a particular column can be used), the cost of buffers consumed, the cost of waste generated, and the gains associated with the amount of product recovered. The costs and gains were combined into a single metric of profit in $/hour of running the process (taking into account time for running through a cycle of load-wash-elute-regeneration, buffer consumption rates, buffer preparation requirements including buffer storage costs, and amount of product recovered in each cycle). **Figure 14** shows the results of this experiment: the heatmaps show the profit associated with running a chromatographic process with the indicated values of titer and flow rate, using either a MAbSelect SuRe Resin chromatography column **(A)** or a Sartobind Rapid A Membrane chromatography column **(B).** These results enable an informed choice of a chromatography platform and recipe that can maximise the profits associated with the process. Note that any other desired characteristic can also be optimized using similar simulations, such as e.g. concentration of product in the effluent, concentration of any impurities, etc. Further, the same approach outlined can also be used to compare the economics of multi-column chromatography vs batch chromatography.

### Enabling scale up during process development

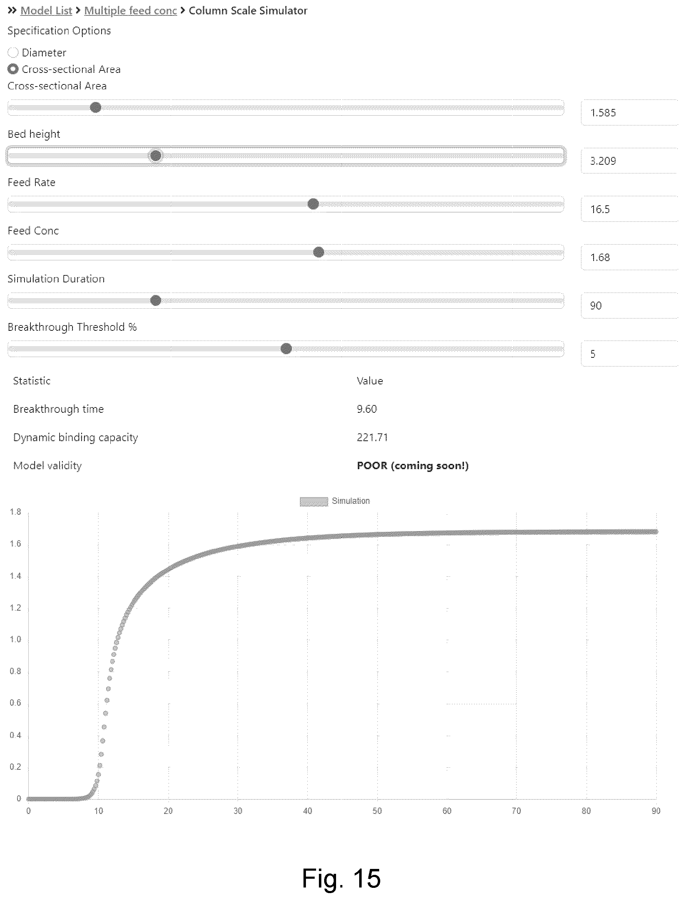

The new approach provided herein also enables the prediction of binding capacities at large scale from small scale trials, recipe design for continuous chromatography at scale based on development scale equipment, and investigation of the effects of bed-height vs column diameter (or equivalently cross-sectional area). The latter can be explored by using the linear velocity of the feed flow as the feed flow rate input to the neural network. In that case, changing the bed height while holding the cross-sectional area constant for the same flow rate does not impact linear velocity that the neural network sees (it just requires more discrete volumes to simulate the system if the discrete volumes are kept at the same ΔV). By contrast, increasing cross-sectional area decreases linear-flow for the same flow rate and therefore impacts the predictions of the neural network, which ultimately impacts the simulation output. **Figure 15** shows an example of the use of a method described herein for column scale up prediction. A model as described in Example 1 (comprising a neural network with the architecture on **Figure 7****,** where the prediction submodel 722B is a fully connected neural network with 2 hidden layers each comprising 20 nodes, and the final layer comprises 2 nodes each with a tanh activation function, respectively for prediction of *k̃_{a,k,n}* and ${{k}^{⇀}}_{d , k , n}$) was trained using training data comprising data from a protein A column (specifically Sartobind^{®} Rapid A Membrane, Sartorius Stedim Biotech GmbH) consisting of 6 breakthrough curves at two different feed concentrations (3 g/L and 0.6 g/L) of a monoclonal antibody and two different feed rates [3 ml/min and 10 ml/min]. Validation was completed with 6 additional feed-rates at the same two feed-concentrations, for the same product and column. The model was then used to predict breakthrough curves and dynamic binding capacity for any process using the same chromatography technology with a range of bed height and column cross-sectional area.

### Real time monitoring and adaptive real-time optimisation of chromatography recipes

The approach described in Example 1 can also be usefully deployed in the context of chromatography process monitoring and control.

Simulations can be run as the chromatography process is under way using the same operating parameters as the chromatography process (i.e. the simulations can act as a digital twin), enabling to compare measurements from the column to predictions for a "healthy" column. These comparisons can be used for: early detection (and also optionally diagnosis) of deviations (i.e. fault detection), to trigger repacking (e.g. when an unacceptable deviation is detected), and to provide a data informed way of monitoring the columns enabling more extended use of columns between re-packing (i.e. making it possible to run a less conservative, and therefore less costly, operation).

Further, simulations can be run while the chromatography process is underway using one or more candidate sets of operating parameters, to enable automatic adaptation of the operating parameters of a continuous chromatography process in response to measured or forecast variations in feedstock (which is typically influenced by the upstream process). Similarly, simulations can be run while the chromatography process is underway using one or more candidate sets of operating parameters, to enable optimisation (using economic predictions or any other criterion or set of criteria to be optimised and applying to outputs of the simulations or metrics derived therefrom) of column use in multi-column chromatography processes (e.g. deciding when to switch columns, how to set flow rates, etc. at any point during the process in order to optimise chosen criteria).

Further, the simulations can also be used to provide information to an upstream process, for example enabling control of the upstream process in a manner that optimises any criterion or set of criteria applying to outputs of the simulations or metrics derived therefrom (since the effect of changes in chromatography process feed, which are associated with upstream process harvest feed, on the optimisation criteria can be readily obtained by simulating the chromatography process as described herein).

### Example 3 - Robustness Assessment & Validation of the Universal Chromatography Model

First, the inventors set out to evaluate the robustness of the method described in Example 1 to various settings. In particular, the inventors tested the effects of various parameters of the machine learning model training on the performance of the method. Training data was collected from purification process on a protein A column, including breakthrough curve experiments conducted at three different feed rates with multiple replicates at each feed rate. Simulations were performed with a time discretization interval of 1 minute. The following experiments were performed:

**Table 1. Set up of robustness experiments.**

| **Exper. No.** | **Number of recurrent states** | **Prediction submodel - n hidden layers** | **Prediction submodel - n nodes per hidden layer** | **Feed** |
|---|---|---|---|---|
| 1 | 1 or 2 | 2 | 8 to 60 nodes (8, 16, 24, 36, 48, 60) | 3 g/L feed concentration; feed rate of 4 ml/min |
| 2 | 1 | 4 | 8 to 60 nodes (8, 16, 24, 36, 48, 60) | 3 g/L feed concentration; feed rate of 4 ml/min |
| 3 | 1 | 1, 2 or 4 | 8 to 60 nodes (8, 16, 24, 36, 48, 60) | 3 g/L feed concentration; feed rate of 4 ml/min |
| 4 | 1 | 2 | 20 nodes | 3 g/L feed concentration; variable flow rate |
| 5 | 1 | 2 | 20 nodes | Variable |

In all experiments, the captured amount, dynamic binding capacity and validation loss associated with each of the different simulations in experiments 1, 2 and 3 were calculated and compared to assess the effect of the changes in the model between variants. In experiments 4 and 5 the simulated breakthrough curves were compared. The prediction submodel was a fully connected neural network in all cases. The configuration of the hidden layers varied, but the last layer was in all cases a 2 nodes layer with a tanh activation function.

Experiment (1) aimed to determine the effect of using 1 or 2 recurrent states (i.e. 2 states that are updated at each iteration, i.e. xᵣ is a 2x1 vector for each iteration k and discrete volume n), with various levels of model complexity (number of nodes in the hidden layers). This showed that having more than 1 recurrent state (where recurrent states are sum parameters remembering past states of the column during a simulation, as explained above) does not result in significant differences between the metrics derived from the simulations (e.g. no significant difference between validation error with 1 or 2 recurrent states at least when using 16 nodes onwards; similar captured amounts and dynamic capacity estimates). This shows that 1 recurrent state is sufficient, although more could be included with the main cost likely to be computational efficiency (and potential overfitting in some cases). Experiment (2) aimed to assess the repeatability of the model fitting procedure. Model fitting with the same data and network configuration was repeated twice (i.e. with different random initializations of the weights) over each of a range of layer sizes. The results of the simulations were then compared for each of these repeat fits, to demonstrate the reliability of identifying consistent parameters. The data showed that the iterations across all model types were similar, indicating that all models were providing robust predictions regardless of the exact configuration of the neural network. Experiment (3) aimed to determine whether there was an effect associated with model complexity. Model complexity increases with more layers and nodes. The higher the complexity the higher the likelihood to overfit. Models with 1 or 2 layers showed very similar results, and models with 4 layers tended to have slightly higher validation error indicating potential overfitting. The results indicated that the method is robust to the choice of architecture, even though overfitting is possible as in any other machine learning problem. Experiment (4) aimed to investigate the effects of training data granularity. Variants of the machine learning model were trained using training data with various levels of granularity (number of data points) obtained by downsampling available online data (1000x downsampling, 500x downsampling, 100x downsampling). The models were then used to simulate processes with the same parameters. Simulated breakthrough curves were compared to corresponding training data (3 sets of 3 replicates, each with a respective flow rate that differs between sets). These results showed that the model could be successfully trained in each of these cases. In this case having around 10 points describing the breakthrough curve was sufficient to find a meaningful model. This shows that the proposed approach is extremely robust to the amount of training data available (and in particular easily supports low resolution training data such as fractionated sample data). Experiment (5) aimed to investigate the effects of the range and amount of training data. Variants of the machine learning model were trained using training data comprising either 1 or 3 replicates for each of 5 or 3 sets of flow rates. The resulting simulated breakthrough curves were compared to the corresponding training data. The results showed that the model tries to accommodate between the replicates, whereas with one replicate the predictions expectedly match the replicate. This indicates that the proposed approach can be trained with minimal amounts of training data replicates and is able to learn from variability between replicates when replicates are available.

Next, the inventors set out to extensively validate the method using data from a state of the art detailed first principles modeling tool (CADET). CADET (Chromatography Analysis and Design Toolkit, von Lieres & Andersson 2010) is a state-of-the-art open-source mechanistic chromatography simulation platform available at cadet.github.io/master/index.html. CADET implements a detailed general rate model of column liquid chromatography. The software was used to set up a data-generation pipeline for numerical simulation model and subsequent validation with the universal chromatography model described in Example 1. The data pipeline stages included the following steps: (i) store user defined design space as sets of parameters; (ii) create numerical models in CADET from sets of parameters; (iii) integrate column outlet results to fractions; (iv) save fraction data to excel sheet for use by the universal chromatography model. The data was then used to train and validate the universal chromatography model.

A trial run was performed to show the ability of the universal chromatography model to extrapolate to flow rates unseen in the training data. By showing the error of the model solution compared to the validation data the inventors established that the model learns the underlying physics of the synthetic data and is able to predict mass transport of unseen flow rates. Multiple numerical models were set up with the following settings: a modulated Langmuir isotherm was used as the binding model, axial dispersion was sampled from the values {1*10⁻⁷, 1*10⁻⁵, 1*10⁻⁴} m²s⁻¹ (low, medium and high axial dispersion), column volume was sampled from the values {1, 5, 15, 75, 200} ml, length to volume ratio was sampled from the values {2.5, 5, 7.5}, column flow rate was sampled from the values {0.05, 0.25, 1.0, 2.5, 7.5} ml·min⁻¹ and loading time, column capacity, adsorption rate, desorption rate constant (excluding modulation effects). A collection of experiments was built using the Cartesian product of all parameters sets. The flow rate in each experiment was then scaled by a set {2.0, 3.0, 4.0, 5.0, 6.0} to generate 5 time series per experiment. The time series were fractioned and collected in fractions corresponding to {30, 60, 120}s, to add some variation to amount of data points collected in the sets. For each experiment (5 time series), the universal chromatography model was trained on four timeseries and validated on a final series. PDF reports were then automatically generated with results after mechanistic (CADET) and universal chromatography model training for training and validation sets.

This process is illustrated on **Figure 16** which shows, for a single synthetic experiment, the mobile phase concentration of a target molecule to be separated (target), and the mobile phase concentration of a buffer solution that has the effect of negating the binding effect of the target molecule to the solid phase hence causing the target molecule to elute modulator), both at the inlet and outlet of the column, together with how the data is used to integrate time periods of the synthetic dataset to generate synthetic fraction point measurements of target mobile phase concentration indicated by black squares **(****Figure 16A). Figure 16B** shows a template used to generate the dataset. An "experiment" here is composed of 5 model evaluations, and the solid line is the high-resolution data generated (from the CADET software) from which points (indicated by squares) are picked to generate the data for that experiment (here every 60s). Each individual simulated run that makes up a synthetic experiment, used for training and validation of the universal chromatography model, differs in initial flow rate scaling as indicated.

When evaluating the new numerical simulation method, the inventors looked for effects of steep gradients or "stiffness", effects of grid refinement, stability or oscillatory behavior as well as vector norms and their convergence. Here since the method being evaluated is a hybrid approach comprising a machine learning model (neural network), they also evaluated effects of parameters related to the neural network. Based on the robustness experiments above, the inventors already postulated that larger network size (e.g. 10 or more nodes per layers over two layers) is beneficial for reducing loss. All experiments were therefore conducted with a model with 3 layers and 256 nodes per layer. The results of these extensive experiments (180 experiments in total) were summarized in terms of distributions of losses across validation and training datasets (visualized as histograms and as boxplots). These showed that the vast majority of the results had a validation loss below 0.1 (10⁻¹). The validation loss median was 4.3·10⁻³, indicating that the universal chromatography model is able to recapitulate the behavior of the much more complex and less computationally efficient general rate model with extremely high average accuracy. In general, the inventors also observed that more datapoints (here realized as higher fractionation frequency) yielded higher accuracy for the model, indicating that the method is capable of extremely high accuracy with good training data. Stiffness was not an issue with these settings as no instability or oscillatory behavior was observed after training meaning that these effects, if apparent, are nullified by the action of the machine learning model (i.e. the overall model is stable and does not have oscillatory behavior problems).

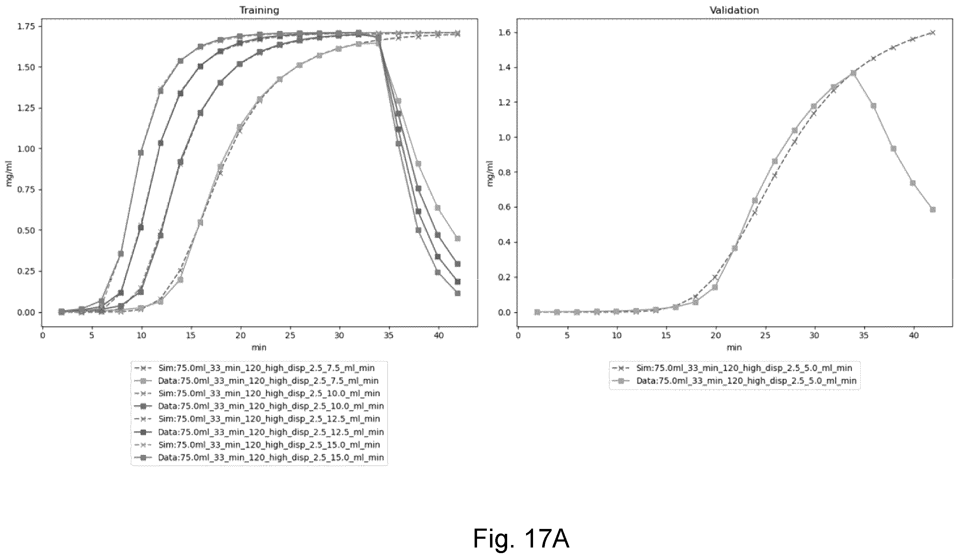

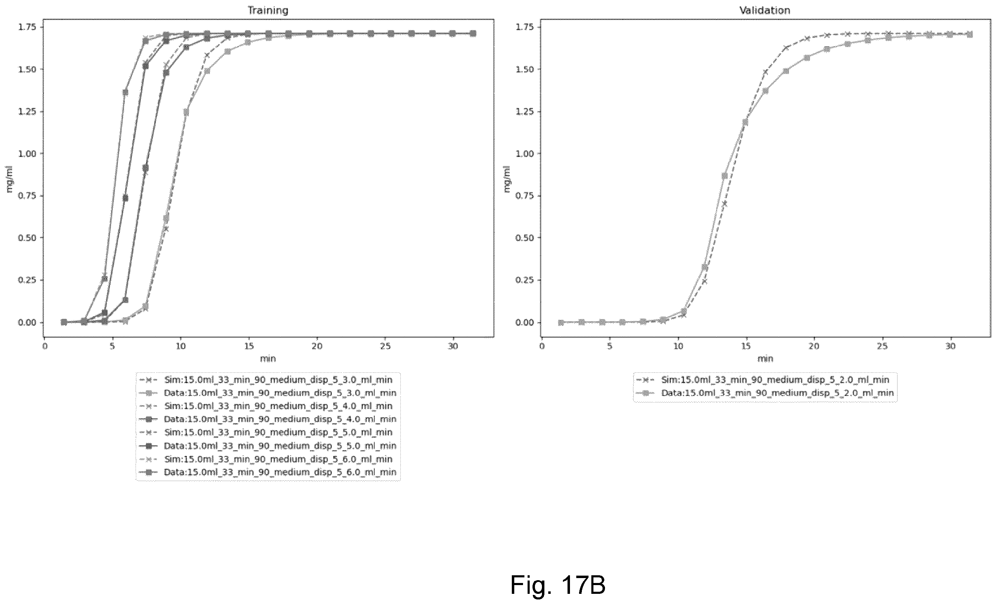

There were some outliers in terms of validation and training loss, the majority of which could be explained by the dataset including parts of the wash phase (which is not what the particular universal chromatography model tested was designed to capture since the machine learning model used was trained only on loading phase data). This is illustrated with an example of a simulation with a 10⁻¹ validation loss on **Figure 17A****.** This shows the data from CADET as the solid lines and the corresponding simulation from the universal chromatography model as the dashed lines, for the 4 training breakthrough curves (left) and the one validation breakthrough curve (right) in a single experiment. The parameters of each simulation are indicated below each plot, i.e. in this experiment the training data was generated with the following parameters: column volume 75 ml, time 33 minutes, fractions 120 seconds, axial dispersion 1*10⁻⁴ m²s⁻¹, length to volume ratio=2.5, flow rate 7.5, 10.0, 12.5 or 15 ml/min. The validation data was generated with the same parameters except the flow rate was set to 5 ml/min. The results show that the validation loss being high (compared to other experiments), i.e. 0.1, is due to a mismatch in the data generation automation, not to performance of the universal chromatography model. In other words, this data shows that if the model had been evaluated against the correct training and validation data (limited to the breakthrough curve up to and before start of the wash around 30 minutes), the validation and training loss would likely have been close to the observed median of 4.4·10⁻³. Thus, even the examples with the highest validation loss were in fact extremely accurate predictions. **Figure 17B** shows an example of an experiment with a validation loss around 4.4·10⁻³ (which is the median validation loss, i.e. 50% of all 180 experiments performed had a validation loss at least as low as this). Again this shows the data from CADET as the solid lines and the corresponding simulation from the universal chromatography model as the dashed lines, for the 4 training breakthrough curves (left) and the one validation breakthrough curve (right) in a single experiment. The parameters of each simulation are indicated below each plot, i.e. in this experiment the training data was generated with the following parameters: column volume 15 ml, time 33 minutes, fractions 90 seconds, axial dispersion 1*10⁻⁵m²s⁻¹, length to volume ratio=5, flow rate 3, 4, 5 or 6 ml/min. The validation data was generated with the same parameters except the flow rate was set to 2ml/min. This shows that the universal chromatography model was able to provide extremely accurate simulations (as noted above, this level of accuracy is far more common amongst all experiments than the few outliers with lower accuracy, all of which can be explained by either data generation problems or edge cases). The accuracy was high for the training data than the validation data (which is an unseen flow rate), indicating that even higher validation accuracies could be obtained when evaluating on data that is within the design space of the training data (rather than using a parameter outside of the range of parameters that the model was trained on).

### Example 4 - Universal Chromatography Model with spectral measurements

### Introduction

Examples 1-3 present a new method for identifying models to predict the performance of a chromatography column, or chromatography system. The method takes a hybrid approach where bulk concentrations in the mobile and bound phases of the system were tracked using first principles ordinary differential equations while more complex, binding rates were modelled using neural networks. To train the weights of the neural network portions of these models, a gradient descent approach is used, where calculation of gradients is achieved by back propagating errors between measured and predicted concentrations through a loss function, the physics model, and ultimately to each layer of the neural network.

In typical applications, the concentration of the target molecule (therapeutic) would be the most important concentration measured in the system. For processes such as monoclonal antibody production, measurement of titer, while not trivial, is possible at reasonably high throughput. However, it is not only the concentration of target molecules that has bearing on the performance of the chromatography system. In fact, given the complex chemistry of biologically manufactured products, there could be hundreds or thousands of other chemical species present in chromatography feedstocks that impact column performance. Furthermore, chromatography columns are never perfectly specific, meaning that some of these species bind to the column at the same time as the target molecule. Through this mechanism of competitive binding, some of these species can co-elute from the column allowing impurities to pass into the product stream as well. Modeling the behavior of such competitively binding impurities within the column would be beneficial to optimize selectivity of the chromatographic process. While the above-described modeling method can in theory capture the impact of competitively binding species in the column, practically doing so explicitly requires measurement of each potentially impactful chemical species. Measurement of even the most prevalent impurities, such as host cell proteins (HCPs) is time-consuming and expensive (costs of up to $2500 USD per sample).

Spectral measurements such as Raman spectroscopy and UV absorbance have an established track record for measuring chemical composition in biological science. In biomanufacturing, both UV and Raman have been used successfully for monitoring and control of upstream processes. Recently, there has been a substantial increase of interest in applying Raman and UV spectroscopy to downstream processes as well. A common approach in these studies has been to build soft-sensing models. In these models, samples of known concentrations are used to learn the spectral signature of different chemical species. Then, spectra of new samples with unknown composition can be passed into the soft-sensors to estimate concentrations. In chromatography, soft-sensors have been built for target molecules (titer predictions), glycosylation (target molecule structure related to quality), host-cell proteins (impurities), DNA (impurities), and other chemical characteristics relevant to chromatography performance. To take advantage of these, the chromatography modeling framework described above can be used with concentrations predicted from a spectral soft-sensor model. While combining a soft-sensor with the hybrid chromatography approach does extent the scope of practical applicability of the method, the inventors have discovered an even more impactful way to use spectral data for chromatography modeling.

The key idea behind this new method is that any change in the spectral signature measured in either the inlet or outlet of a chromatography column is fundamentally related to a change in concentration. This concept can be extended to include spectral signatures measured anywhere in a multi-column chromatography system (e.g. between columns in a multi-column system, etc.). Furthermore, for a well-adjusted spectral device (adjustment of which is standard practice in the field), it is expected that the relationship between spectral signature from both UV and Raman is mostly linearly related to concentration. Therefore, an affine transformation on spectral data that allows for capturing variation in spectral signatures can be used as a proxi for changes in concentration. It follows that the scores of a principal component analysis (PCA) model trained on historical spectral data from multiple points in a chromatography system can be treated mechanistically as concentrations. Further, if minor non-linear effects are present (i.e. the relationship between spectral signature and concentration is mostly linear, but minor non-linear effects cannot be excluded), known projection methods (such as e.g. PCA, PLS) can account for those through additional latent variables. With this motivation, rather than calibrating soft-sensors to predict concentrations of individual species, the inventors have adapted the modeling method described in Example 1 to work directly on scores of a PCA model trained from spectral data. The present example describes and demonstrates the use of such an improved hybrid chromatography modeling approach.

### Training data generation

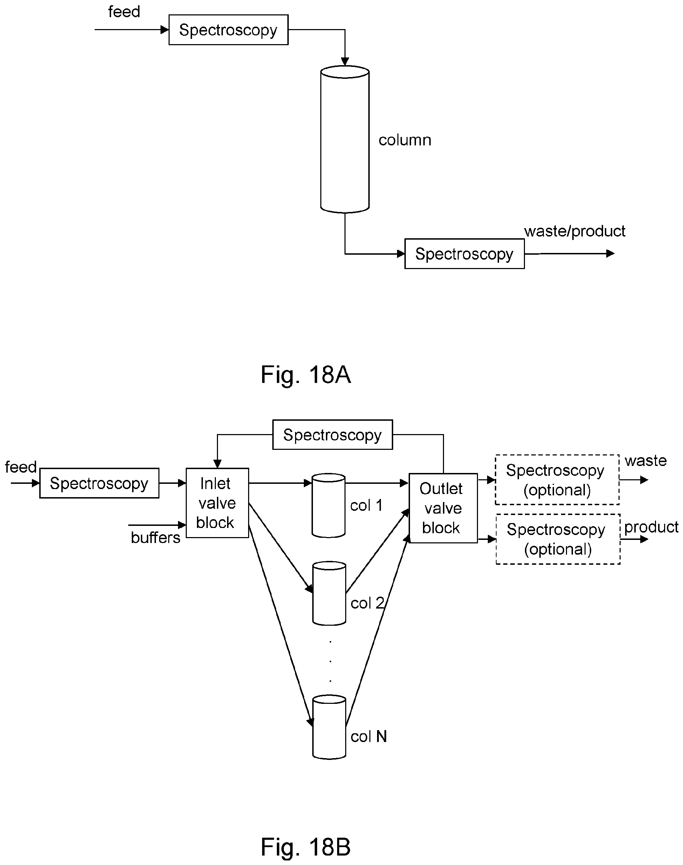

A typical training data generation process for a method of the present example is explained below and by reference to **Figure 18****,** where Fig. 18A illustrates a set up for an exemplary single column system and **Fig. 18B** illustrates a set up for an exemplary multi-column system (N columns). The spectroscopy blocks can represent Raman and/or UV spectroscopy measurements.

Training data is obtained by generating a set of breakthrough curves at varied flowrates (e.g. 3 to 5 flow rates are amply sufficient and may be used in a typical scenario) with feedstocks that are representative of expected normal operation for the process that is to be modelled. For best modeling results, care should be taken to use feedstocks covering the normal operating range of the process. For example, for a perfusion process where the composition of the feed may be expected to vary during operation of the process, data may be collected for feedstocks that represent both early stage and late stages of the perfusion process. Spectral measurements are taken in real time (e.g. UV and/or Raman are commonly used and suitable for use in the present methods), at a minimum at the inlet and outlet of a single column system (as illustrated on Fig. 18A) or at the inlet and in the connection between two columns in series in a multi column system (as illustrated on Fig. 18B). Additional measurements may also be obtained on the elution and waste streams from a chromatography system (i.e. multicolumn system, as illustrated on Fig. 18B). Reference to "real time" measurement refers to measurements that are obtained with sufficient frequency to observe the dynamic behavior of column performance. This is typically once per second or few seconds, although the present inventors have found that measurements taken at 1.5 seconds intervals downsampled by a factor of 10 (i.e. effectively once per 15 seconds) still worked very well to train an accurate model. Thus, the term "real time" encompasses sampling frequencies up to once every 20 seconds, 30 seconds or even 1 minute. As the skilled person understands, there is no single exact measurement frequency that is sufficient and in reality there is up to a point very little impact of increasing the sampling interval, with accuracy of the model decreasing more significantly thereafter.

Concentrations of critical species (including but not limited to product titer) may also be recorded but are not required. When concentrations are measured these are typically available at much lower sampling frequencies than spectral measurements. Indeed, online (real time) sensors are only available for a very limited set of compounds, and therefore concentrations of things like products are typically measured offline at specific (infrequent) sampling intervals or in fractions. An important feature of the methods of the present example is that NO chemical concentrations are required at the training phase of the chromatography model, only spectral data is required. Nevertheless, concentration data can be leveraged if available, the point being that model training does not *rely* on such concentration data.

Additional samples (offline samples) can optionally be generated by taking spectral measurements, but not passing through the chromatography system, to further enhance the mapping between chemical species and scores.

### Model training procedure

In a first step, a single dimensionality reduction model (here illustrated as a principal component analysis (PCA) model) is constructed on all available spectral data from all times and all offline samples (if available). This is illustrated on **Figure 19****,** where the dashed blocks marked with * are optional data blocks. A data matrix is constructed comprising spectral data at the inlet and outlet (including at least the product outlet, and optionally including waste outlet data if available) for a plurality of times along the breakthrough curves, and any optional offline and/or online data. In the illustrated examples this includes UV and Raman spectroscopy data. The purpose of the PCA model is to find a mapping between spectra and scores indicative of concentrations that vary within the system (i.e. all concentrations of species that bind to the column and that are measurable using the spectroscopy modalities used should be inherently captured by the scores, since these aim to reduce dimensionality while capturing as much variability as possible). Ideally, this mapping can quantify any variation in composition that occurs anywhere through the system. Therefore, any spectral data available at measurement point in the system can be included. This should preferably include at least inlet data and product outlet data, but other data (including e.g. waste outlet spectral data, offline data) included can improve the spectra to score mapping. The data is concatenated across runs and measurement location (e.g. inlet, product outlet, waste outlet if used - with time points concatenated as shown), and aligned such that multiple measurements for the same time point of the same run at the same measurement location are aligned. For example, when measurements obtained using different types of spectroscopy (which is optional, and here illustrated as UV and Raman spectroscopy) and/or concentration data (which is also optional) are used, these are aligned such that measurements for the same time points are aligned (e.g. in the same row in the example illustrated on Fig. 19). Obtaining such aligned data can comprise downsampling measurements from one spectroscopy type that has a higher measurement frequency than other spectroscopy type(s) used. For example, UV measurement frequency is fractions of a second whereas Raman spectroscopy typically have lower frequencies pf detection, and therefore downsampling the UV spectroscopy data to the Raman measurement frequency can be easily done to align these two datasets. Instead or in addition to this, residence times based on the known volumes of the system (e.g. known volumes of the chromatography column and non-column parts of the system, also referred to as "dead volumes") may be used to align data between different runs. This may be used e.g. to align data between two sensors that are located at physically separate locations in the system, e.g. to take into account a lag between two measurements of the same solution as the solution flows from the location of one sensor to the location of another sensor. This can also be used to align data to take into account piping between the column and the sensors, e.g. to take into account a time difference between the measurement of a sensor assumed to correspond e.g. to input or output solution and the time at which the solutions entered or exited the column. This is optional and the inventors believe that the residence times from the "non-column" parts of the system in a typical chromatography unit are likely to have a negligible contribution to dynamics relative to the dynamic behavior of the column binding.

Spectral data for samples that are not inlet/outlet samples (denoted "offline" spectra on Fig. 19) can also be added to the PCA training data. The PCA scores obtained for offline data are not used in the models below, they simply serve to introduce variance in the training data for the PCA model. For examples, samples dosed with product or some impurity that are measured offline can be included. These can be samples that are expected to be possibly observed in the system, or samples with more extreme concentrations or specific sets of impurities that the user wants to ensure the model has the ability to capture. Even though there is no guarantee that such variations would show up in the column model training data (i.e. the offline samples may not in fact be representative of a real condition observed in the training data obtain from actual runs on columns), they can still heighten the sensitivity of the resulting model to the species included in these offline samples.

The data may have been pre-processed as known in the art prior to application of the PCA, where the preprocessing typically depends on the data. For example, issues like baseline drift are known to occur in Raman spectroscopy data and can be addressed e.g. using polynomial fitting (see e.g. Liu et al. 2015), smoothing spline fitting, an asymmetric least-squares (ASLS) method for Raman baseline correction (see e.g. Eilers & Boelens, 2005), or applying wavelet decomposition and integration or derivatives (first or higher orders) to reduce baseline effects (see e.g. Liu et al. 2015). In general, any of the data in the data matrix can have been individually normalized (e.g. using the Standard Normal Variate (SNV) method - see e.g. Huang, Romero-Torres & Moshgbar, 2010, Water band normalization (or any other band)), smoothed (e.g. using Savitzky-Golay filtering - see e.g. Barton et al. 2018), baseline corrected (e.g. using ASLS, polynomial methods, spline methods, smoothing-base methods, derivatives, etc. including but not limited to any of the methods implemented in the pybaselines library see Erb, D. (2024) see pybaselines.readthedocs.io/en/latest/introduction.html), scaled (e.g. using univariate data analysis or mean centering), denoised etc. The methods of the present disclosure are not limited in this regard, since the present disclosure does not relate to preprocessing of spectral data, and any method known in the art for this purpose can be used.

Any method known in the art to determine an optimal number of principal components may be used (see e.g. Joliffe, 2002 - Chapter 6). Alternatively, a fixed (predetermined) number of principal components may be used. Determination of the number of components using rigorous methods such as cross validation is more likely to lead to improved modeling results as it ensures that variability in the data is appropriately captured. Cross validation comprises, for each of a plurality of candidate values of the number of principal components, iteratively removing parts of the input data, fitting a PCA model to the remaining data, and using the fitted model to predict the data that was removed. An error term (also referred to as "loss", such as e.g. mean squared error) between predictions and data is calculated over all iterations. The optimal number of principal components is then selected as the candidate values that is associated with the lowest prediction error.

As illustrated on Fig. 19, spectral data can be augmented with additional columns for any known (measured) concentrations corresponding to the spectral data (i.e. concentrations of any species in the same samples from which the spectral data of the same row was acquired - where multiple additional columns can be included if multiple species were measured in these samples). When known concentrations exist for some observations but not others (e.g. inlet data but not outlet data), known missing data methods from PCA may be applied. For example, any imputation method compatible with PCA can be used, such as e.g. multiple imputation. Alternatively, PCA algorithms that can handle missing data can be used, such as the NIPALS algorithm (Wold, 1966), or an implementation of singular value decomposition that can deal with missing data (see e.g. docs.scipy.org/doc/scipy/reference/sparse.linalg.svds-arpack.html).

In a second step, the PCA scores obtained in the first step for the spectroscopy data are used as a drop-in replacement for concentrations to train the hybrid chromatography models. These can be centred prior to use by subtracting from the PCA scores for any data used to train or deploy the model, the PCA scores obtained for buffer only spectral data. This has the effect of producing scores that are equal to 0 when the column is pre-conditioned with buffer only, which helps to set intuitive initial conditions. This is however not necessary, as initial conditions that correspond to buffer spectra can simply be used instead. In particular, the concentration vectors in the ODEs on Fig. 6 (Equations (1) and (2) above) are replaced with vectors of scores representing the affine transformation on the spectral data, leading to equations (6) and (7) below: $\frac{d {{t}^{⇀}}_{u , n}}{dt} = \frac{{f}_{k}}{ΔV} \left({{t}^{⇀}}_{u , n - 1}-{{t}^{⇀}}_{u , n}\right) - {{k}^{˜}}_{a} ∘ {{t}^{⇀}}_{u , n} + {{k}^{⇀}}_{d} ∘ {{t}^{⇀}}_{b , n}$ $\frac{d {{t}^{⇀}}_{b , n}}{dt} = {{k}^{˜}}_{a} ∘ {{t}^{⇀}}_{u , n} - {{k}^{⇀}}_{d} ∘ {{t}^{⇀}}_{b , n}$ where ${{t}^{⇀}}_{u}$ represents a vector of scores for each component corresponding to unbound concentrations and represents a vector of scores for each component corresponding to bound concentrations, and *k̃ₐ* is estimated by the machine learning model as a function of fₖ, ${{t}^{⇀}}_{u}$ and ${{t}^{⇀}}_{b}$, i.e. ${{k}^{˜}}_{a} = {f}_{NN} \left({f}_{k}, {{t}^{⇀}}_{u , n}, {{t}^{⇀}}_{b , n}\right)$. Similarly to what is described above, a warm-up value of *k̃ₐ* can be estimated during model pre-training using ${{k}^{˜}}_{a} = {{k}^{⇀}}_{a} ∘ \left({{t}^{⇀}}_{tot}-{{t}^{⇀}}_{b}\right)$ where ${{t}^{⇀}}_{tot}$ is an estimated parameter (corresponding to ${{c}^{⇀}}_{tot}$ when using concentrations).

When inerts are being modelled, Equations (6) and (7) can be supplemented with Equation (3) as described in Example 1: $\frac{d {{c}^{⇀}}_{i , n}}{dt} = \frac{{f}_{k}}{ΔV} \left({{c}^{⇀}}_{i , n - 1}-{{c}^{⇀}}_{i , n}\right)$

Inert species are represented as concentrations (and not included in the PCA above) because: (i) it is assumed that all scores of PCA model have the option to "bind" to the column, and (ii) inert concentrations are typically more straightforwardly available. Introducing inert species into the PCA is however possible, as the neural network would just learn that the corresponding score does not bind to the column, however introducing inert concentrations to the PCA model would needlessly increase the complexity of learning the binding function and is therefore bad practice.

The neural network is then trained using gradient descent as described in Example 1 (see Figs. 8A, 8B with all instances of ${{c}^{⇀}}_{tot} , {{c}^{⇀}}_{u}$ and ${{c}^{⇀}}_{b}$, replaced by ${{t}^{⇀}}_{tot} , {{t}^{⇀}}_{u}$ and ${{t}^{⇀}}_{b}$, respectively) except that the objective is to minimize the error between the predicted column outlet scores over time (i.e. predicted by the hybrid model) and the observed outlet scores over time (i.e. obtained by passing outlet spectral data through the affine (PCA) transform). This is illustrated on **Figure 20****.**

### Model uses and advantages

Once trained, the hybrid model can predict score vectors at any point in time and any spatial dimension within the column. This follows the process described in Example 1 (see Fig. 9) except that ${{t}^{⇀}}_{u}$ and ${{t}^{⇀}}_{b}$ are used instead of ${{c}^{⇀}}_{u}$ and *c_{b}.* Briefly, predictions for *k̃_{a,n}*, ${{k}^{⇀}}_{d , n}$, and ${{x}^{⇀}}_{r , k + 1 , n}$ for all n E [1, ··· , N] are obtained using the machine learning model (here the neural network described above) and inputs: ${{x}^{⇀}}_{r , k , n} , {{t}^{⇀}}_{u , k , n} , {{t}^{⇀}}_{b , k , n}$, *fₖ*, and optionally ${{c}^{⇀}}_{i , k , n}$. These *k̃_{a,n}*, ${{k}^{⇀}}_{d , n}$ are used as parameters of the model in equations (6)-(7) (and optionally (3)), to solve the column model at the current discrete time point k. In particular, the ODEs in (6)-(7) (and optionally (3)) are linearised around the current state (defined by ${{t}^{⇀}}_{u , k , n} , {{t}^{⇀}}_{b , k , n}$, *fₖ*, and ${{c}^{⇀}}_{i , k , n}$ if used), and the system is solved over the discrete interval by calculating a discrete state-space model, thereby determining the values of ${{t}^{⇀}}_{u}$ and ${{t}^{⇀}}_{b}$ at time k. This is iteratively repeated, resulting in predicted scores in the column and at the outlet.

The predicted scores can be mapped back to spectral / concentration data using inverse PCA. These are directly interpretable as having the corresponding physical meaning at least for the predicted effluent data (breakout curves), which are of primary interest when assessing chromatography performance. The spectral data can then be mapped to concentrations, if desired, using soft sensor approaches known in the art. In practice where spectral measurements are available, they are likely to be used directly to obtain concentrations using soft sensor approaches. However, the ability to obtain such concentrations from "synthetic" spectra (i.e. spectra derived from simulated PCA loadings) is particularly advantageous in cases where not spectra are available, such as e.g. for positions in the middle of the column, either bound or unbound, and also in a multi-column setup (essentially anywhere where it would not be possible or practical for physical reasons to take real spectral measurements). Note that as explained further elsewhere, mapping the PCA scores back to spectral measurements and optionally then to concentrations is completely optional as simulation, control, monitoring and optimization of the chromatography system can be performed entirely in PCA scores space.

The approach can be used in any of the use cases described herein, including e.g. those in Example 2. There are many additional advantages to the methods of the present example. Firstly, calibration experiments can be conducted after training the column model to correlate simulated spectral signatures to species (i.e. soft sensor models can be implemented at a later date without the need to re-train the column model).

Further, any species that can be observed through either Raman or UV will have the opportunity to influence the column model, for instance through competitive binding effects learned by the neural network. By contrast, if soft sensor approaches are simply used to determine concentrations from spectral data using the concentration-based method in Example 1, then a separate soft sensor must be extensively identified for each species that one wishes to model (which is a significant amount of work, before chromatography modelling can even begin). Additionally, there is inherent risk of error and arbitrariness in selecting which species should be modeled.

Another advantage is that no offline concentration analysis is required. This model is able to learn in real time, online, from data as it becomes available. In other words, the model can be continuously retrained and improved in real time as chromatography processes are running.

Further, the approach requires very minimal input from experimenters or modelers. In fact, the entire process of learning a column model can be automated on the chromatography device platform and run lights out. Finally, models are interpretable, through the loadings of the spectral PCA model, so it is possible to explain how the model is arriving at its conclusions.

### Experimental proof of concept

The efficacy of this approach was demonstrated by collecting real-time, in-line Raman data during a chromatography experiments run on the Resolute^{®} BioSC Platform. A model protein (Lysozyme) was fed to the column. A Sartobind^{®} cation exchange column was used. Two complete cycles of cation exchange binding, washing, eluting, and regeneration were conducted. Because only one Raman probe was available for these experiments, the column was bypassed at regular intervals throughout the experiment to get "simulated" column inlet Raman spectra. The set up for these experiments is illustrated on **Figure 21****.** In commercial practice, a multiplexer would be used in the fiber optic line allowing the same Raman device to measure both before and after the column (nearly simultaneously). The experimental steps (including instances where the column was bypassed for inlet measurement simulation) are presented in **Table 2** below along with timestamps:

**Table 2. Schedule for universal chromatography modelling with spectral data proof of concept experiments.**

| **Steps** | **Timestamp** |
|---|---|
| Column - NaCl 1 | 12:36:50 |
| Column - Blank 1 | 12:44:50 |
| Bypass - Blank 1 | 12:58:50 |
| Bypass - NaCl 1 | 13:02:20 |
| Bypass - Blank 2 | 13:13:52 |
| Bypass - Feedstock 1 | 13:16:38 |
| Column - Blank 2 | 13:24:32 |
| Column - Load 1 | 13:30:43 |
| Column - Wash 1 | 14:37:20 |
| Column - Elute 1 | 14:52:37 |
| Column - Caustic 1 | 15:07:07 |
| Bypass - Blank 3 | 15:18:35 |
| Bypass - NaCl 2 | 15:28:54 |
| Bypass - Feedstock 2 | 15:39:56 |
| Column - NaCl 2 | 15:48:39 |
| Column - Blank 3 | 15:58:56 |
| Column - Load 2 | 16:10:21 |
| Column - Wash 2 | 16:35:35 |
| Column - Elute 2 | 16:45:37 |
| Column - Caustic 2 | 16:58:05 |
| Column - Blank 4 | 17:11:12 |

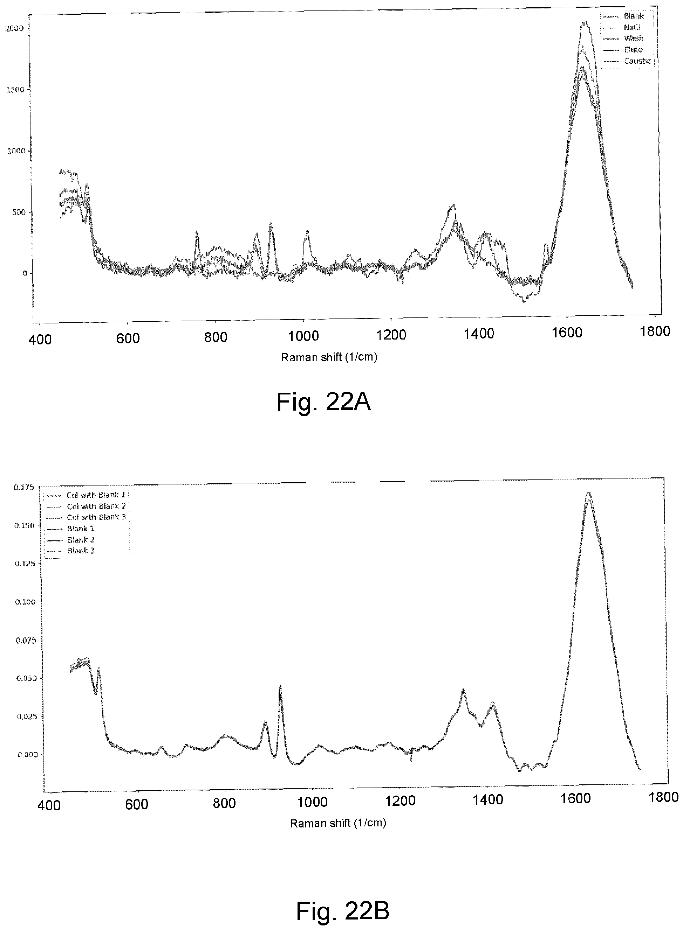

Feedstock 1 used a flow rate of 0.6 ml/min with a feed concentration of 1.55 mg/ml lysozyme, feedstock 2 used a flow rate of 2 ml/min with a feed concentration of 2.0 mg/ml lysozyme. Complete Raman spectra were measured every 1 seconds using a HyperFlux^{™} PRO Plus Raman spectrometer with exposure=1000 ms per spectrum. Representative raw spectra are plotted **Figure 22****.** On **Fig. 22B****,** Blank 1 is the blank going through the bypass for the very first time, column with blank 1 is the blank going through the column for the first time, etc (see **Table 2** for the corresponding schedule and **Fig. 21** for the physical set up). Note that even with the naked eye, variations in Raman spectra are observable over the duration of the experiment (i.e. between different stages of chromatography) - see **Fig. 22A****.** To account for baseline drift (common in Raman) a baseline correction was applied using ASLS (Asymmetric least squares - see Eilers & Boelens, 2005; as implemented in the pybaselines Python library, see pybaselines.readthedocs.io/en/latest/algorithms/whittaker.html) and mean-centering to each individual Raman spectra before further processing. As discussed above, a single PCA model was constructed on all Raman spectra from all phases of the experiment. The inventors fitted six components. As mentioned above, cross validation can be used to make sure that the components fitted do not describe noise. However, in this case the inventors simply plotted timeseries of the scores and stopped adding components based on how noisy the scores looked. This is one nice advantage of having a PCA model that is agnostic to time but applied over a time series. Because of the statistical independence of subsequent samples, it is quite easy to tell when a higher dimensional score becomes too noisy to use, because the score time series for the score of the last added component becomes noisy. This was done manually in this case but can be automated using any signal to noise ratio metric known in the art (e.g. comparing a smoothed signal to the observed signal for the time series of subsequent principal components, and stopping the inclusion of additional principal components when the signal to noise ratio metric falls below a predetermined threshold). This is likely to perform better than a traditional cross validation approach in the present context because it advantageously takes into account the time series nature of the data from which the scores originate.

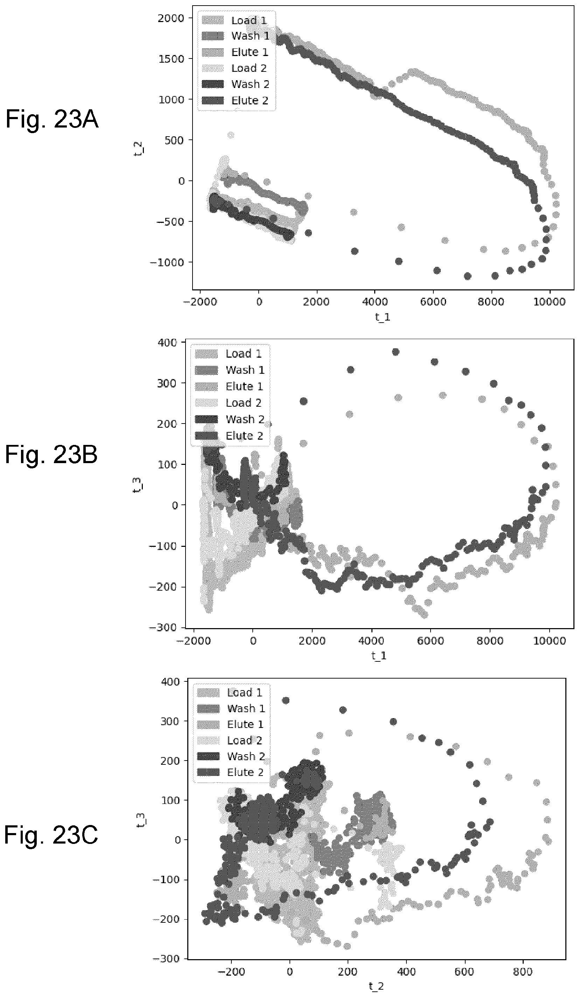

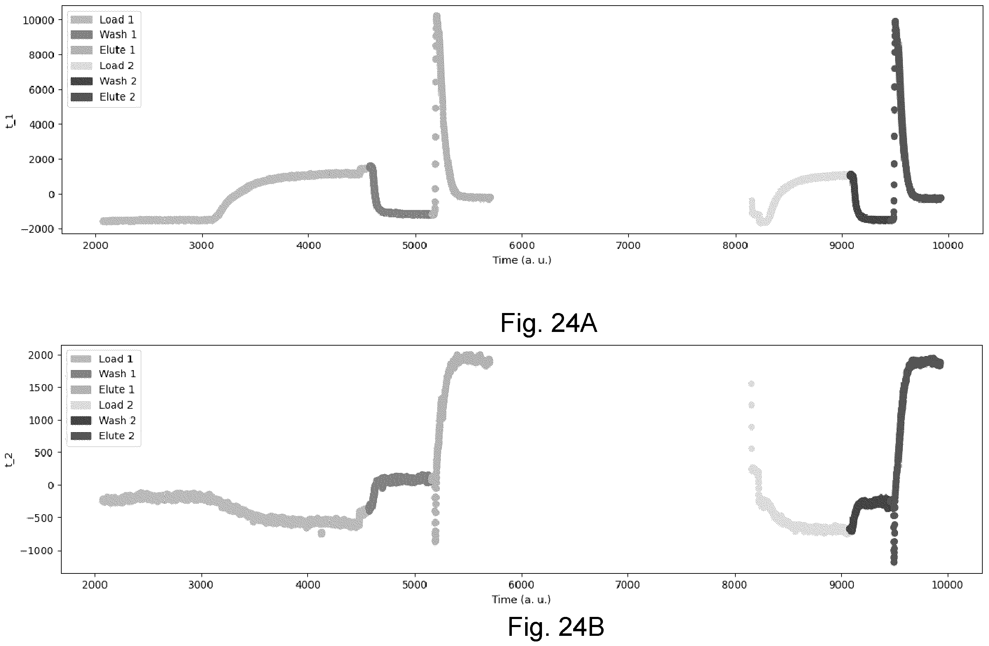

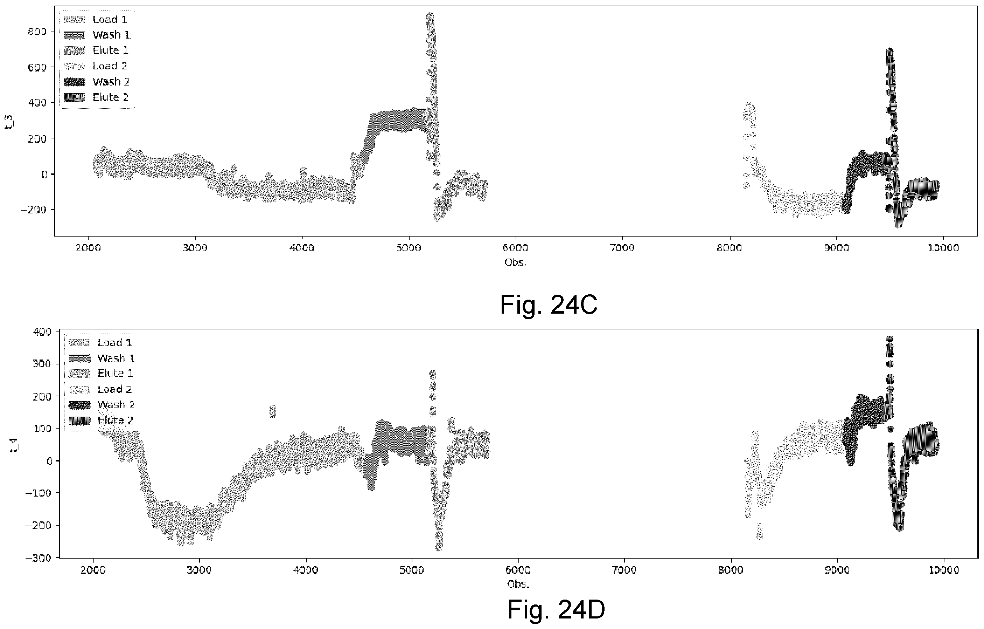

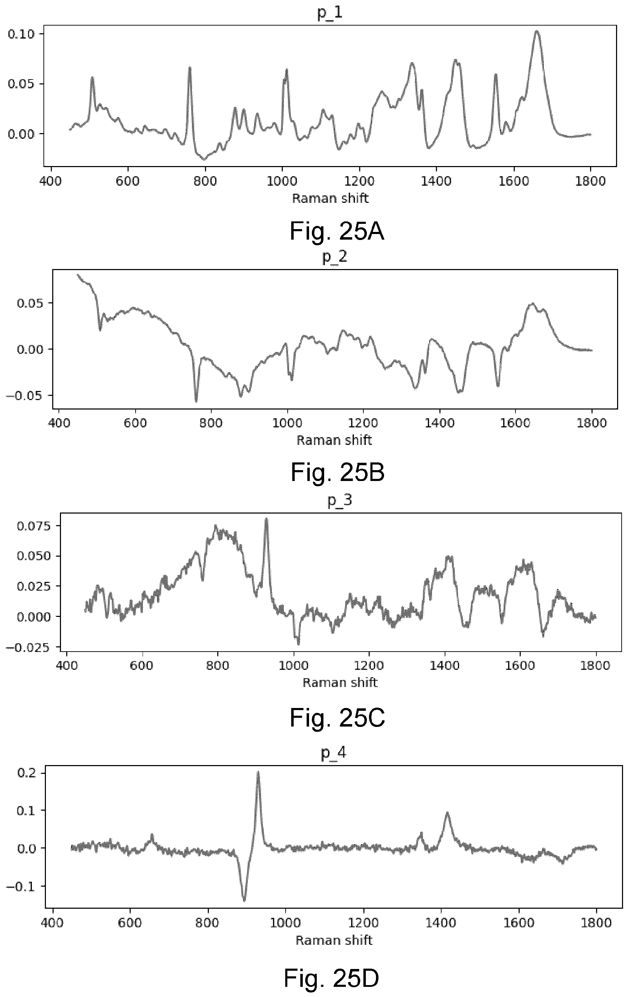

**Figures 23** **and** **24** show the latent "score" values of the resulting observations colored by the phase of the experiment, as a function of each other and as time series. Of particular note is that in all scores (t1, t2, ... , t4) the shape of the time-series during the loading phase matches expectations for a typical breakthrough curve (where concentration is measured directly, often by offline analytics on outlet fractions). Comparing Fig. 24A and Fig. 24B shows that the time profile of t21 (latent variable values for the first principal component, i.e. PC1 loadings) looks like a typical breakthrough curve while the time profile of t2 (latent variable values for the second principal component, i.e. PC2 loadings) looks like an inverted breakthrough curve due to the well-known phenomenon of sign flipping that occurs in PCA (i.e. inverting the t2 scores leads to a curve that has the expected shape). **Figure 25** shows loading plots demonstrating that the PCA models capture variation in spectral regions that are characteristic of proteins known to be in the feedstocks (again, validating the assertion that variations in scores can be treated directly as variations in concentrations). This is evident when comparing with the curve for "Elute" on Fig. 22A which displays a spectrum of the protein at very high concentration. While the spectrum also contains bands originating from the elution buffer, quite specific protein bands are also clearly visible, for example around 750 cm⁻¹, 1020 cm⁻¹, 1580 cm⁻¹. These are also visible on Fig, 25.Finally, the resulting scores were used to train a hybrid (universal chromatography) model as described above. Specifically, the fully connected portion of the neural network contained three layers with 80 nodes per layer (ReLU activation). The recurrent portion of the network used 6 recurrent states. The model was trained with an initial learning rate of 0.001 and a learning rate decay of .95. An epoch limit of 10000 iterations was enforced with an early stopping policy to prevent over-fit. The results of this proof-of-concept experiment are shown on **Figure 26****,** which shows that the trends in scores are well captured by the hybrid (mechanistic and neural network) model trained using scores as concentrations analogs.

### References

All references listed below and any documents mentioned in this specification are incorporated herein by reference in their entirety.
Shekhawat LK, Rathore AS. An overview of mechanistic modeling of liquid chromatography. Prep Biochem Biotechnol. 2019;49(6):623-638. doi: 10.1080/10826068.2019.1615504. Epub 2019 May 20. PMID: 31107163.
Narayanan, H., Seidler, T., Luna, M. F., Sokolov, M., Morbidelli, M., & Butté, A. (2021). Hybrid Models for the simulation and prediction of chromatographic processes for protein capture. Journal of Chromatography A, 1650, 462248.
von Lieres, E.; Andersson, J.: A fast and accurate solver for the general rate model of column liquid chromatography, Computers and Chemical Engineering 34,8 (2010), 1180-1191.
Jolliffe, I. T. (2002). Choosing a Subset of Principal Components or Variables. In: Principal Component Analysis. Springer Series in Statistics. Springer, New York, NY.
H. Wold. Estimation of principal components and related models by iterative least squares. In Multivariate Analysis (Ed., P.R. Krishnaiah), Academic Press, NY, 1966, pp. 391-420.
Feidl, Fabian, et al. "A new flow cell and chemometric protocol for implementing in-line Raman spectroscopy in chromatography." Biotechnology progress 35.5 (2019): e2847.
Wang, Jiarui, et al. "In-line product quality monitoring during biopharmaceutical manufacturing using computational Raman spectroscopy." Mabs. Vol. 15. No. 1. Taylor & Francis, 2023.
Wei, Bingchuan, et al. "Multi-attribute Raman spectroscopy (MARS) for monitoring product quality attributes in formulated monoclonal antibody therapeutics." MAbs. Vol. 14. No. 1. Taylor & Francis, 2022.
Rolinger, Laura, Jürgen Hubbuch, and Matthias Rüdt. "Monitoring of ultra-and diafiltration processes by Kalman-filtered Raman measurements." Analytical and Bioanalytical Chemistry 415.5 (2023): 841-854.
Feidl, Fabian, et al. "Combining mechanistic modeling and Raman spectroscopy for monitoring antibody chromatographic purification." Processes 7.10 (2019): 683.
Lin, Yu Kiat, et al. "Raman spectroscopy as process analytical tool in downstream processing of biotechnology." Chinese Journal of Chemical Engineering 30 (2021): 204-211.
Eilers, Paul HC, and Hans FM Boelens. "Baseline correction with asymmetric least squares smoothing." Leiden University Medical Centre Report 1.1 (2005): 5.
Liu J, Sun J, Huang X, Li G, Liu B. Goldindec: A Novel Algorithm for Raman Spectrum Baseline Correction. Appl Spectrosc. 2015 Jul;69(7):834-42.
Sinead J. Barton, Tomas E. Ward, Bryan M. Hennelly. "Algorithm for optimal denoising of Raman spectra". Anal. Methods, 2018,10, 3759-3769
Jun Huang, Saly Romero-Torres, Mojgan Moshgbar. "Practical Considerations in Data Pre-treatment for NIR and Raman Spectroscopy". American Pharmaceutical Review, Oct 1, 2010. www.americanpharmaceuticalreview.com/Featured-Articles/116330-Practical-Considerations-in-Data-Pre-treatment-for-NIR-and-Raman-Spectroscopy/
Erb, D. (2024). pybaselines: A Python library of algorithms for the baseline correction of experimental data. https://doi.org/10.5281/zenodo.5608581.

### Equivalents and Scope

Unless context dictates otherwise, the descriptions and definitions of the features set out above are not limited to any particular aspect or embodiment of the invention and apply equally to all aspects and embodiments which are described. Any section headings used herein are for organizational purposes only and are not to be construed as limiting the subject matter described.

"and/or" where used herein is to be taken as specific disclosure of each of the two specified features or components with or without the other. For example "A and/or B" is to be taken as specific disclosure of each of (i) A, (ii) B and (iii) A and B, just as if each is set out individually herein. It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about" or "approximately", it will be understood that the particular value forms another embodiment. The terms "about" or "approximately" in relation to a numerical value is optional and means for example +/- 10%. Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps. Other aspects and embodiments of the invention provide the aspects and embodiments described above with the term "comprising" replaced by the term "consisting of" or "consisting essentially of", unless the context dictates otherwise.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilized for realizing the invention in diverse forms thereof. While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention, which is defined by the appended claims.

For the avoidance of any doubt, any theoretical explanations provided herein are provided for the purposes of improving the understanding of a reader. The inventors do not wish to be bound by any of these theoretical explanations.

## Claims

1. A computer-implemented method of designing, monitoring or controlling a chromatography process whereby a feed flow comprising one or more products is passing through a chromatography unit comprising a stationary phase that the one or more products interact with, the method comprising:
simulating the chromatography process by solving a bulk flow mass balance model over one or more discrete volume elements along the chromatography unit by numerical integration,
wherein the bulk flow mass balance model is an ordinary differential equations model that represents the change in concentration of bound and unbound fractions of the one or more products in a discrete volume element, wherein the concentration of bound and unbound fractions of the one or more products are expressed as latent variables values of a dimensionality reduction model obtained from spectroscopy data,
wherein the ordinary differential equations model comprises binding and diffusion terms, wherein a binding term captures the binding of a product to the stationary phase and a diffusion term captures the diffusion of a bound product, wherein said binding and diffusion terms are each parameterised by a single respective parameter that is predicted by a machine learning model trained to take inputs comprising the latent variable values corresponding to the concentration of the bound and unbound fractions of the one or more products in a discrete volume element and produce as output a prediction of the parameters of the binding and diffusion terms.

2. The method of claim 1, wherein the dimensionality reduction model is a model that applies an affine transformation to input data, optionally a principal component analysis model, or an autoencoder model, or a t-distributed stochastic neighbor embedding.

3. The method of any preceding claim, wherein the spectroscopy data comprises one or more of:
Raman spectra, UV spectra, fluorescence spectra and near infrared spectra, optionally wherein the spectroscopy data comprises Raman spectra and/or UV spectra.

4. The method of any preceding claim, wherein the dimensionality reduction model has been previously obtained from training data comprising spectroscopy data obtained at a plurality of sampling times of input and output flows of one or more chromatography processes, optionally wherein the one or more chromatography processes are chromatography processes using a feed flow that has a composition representative of the feed flow of the simulated chromatography process,
optionally wherein the training data further comprises spectroscopy data obtained from offline samples comprising one or more species of interest and/or wherein the training data further comprises one or more species concentrations measured in samples associated with any one or more of the spectroscopy data.

5. The method of claim 4, wherein the dimensionality reduction model has been previously obtained from training data comprising spectroscopy data obtained at a plurality of sampling times of input and output flows of a plurality of chromatography processes, optionally at least 3 chromatography processes, and/or
wherein the dimensionality reduction model has been previously obtained from training data comprising spectroscopy data obtained at a plurality of sampling times of input and output flows of one or more chromatography processes, wherein the plurality of sampling times are spaced apart by at most 1 minute, and/or
wherein the dimensionality reduction model has been previously obtained from training data comprising spectroscopy data obtained at a plurality of sampling times of input and output flows of one or more chromatography processes, the plurality of sampling times spread along the duration of an elution phase of a respective chromatography process, and/or
wherein the dimensionality reduction model has been previously obtained from training data further comprising spectroscopy data obtained at a plurality of sampling times of elution and/or waste flows of one or more chromatography processes, and/or
wherein the dimensionality reduction model has been previously obtained from training data comprising spectroscopy data obtained at a plurality of sampling times of input and output flows of one or more individual columns of a multi-column chromatography process.

6. The method of any preceding claim the bulk flow mass balance model comprises:
(a) one or more ordinary differential equations that represent the change in concentration of bound fractions of the one or more products in a discrete volume element expressed as latent variables values of a dimensionality reduction model obtained from spectroscopy data; and
(b) one or more ordinary differential equations that represent the change in concentration of unbound fractions of the one or more products in a discrete volume element expressed as latent variables values of a dimensionality reduction model obtained from spectroscopy data;
wherein the number of equations in (a) and (b) is equal to the number of latent variables in the dimensionality reduction model.

7. The method of any preceding claim, wherein the bulk flow mass balance model comprises linear terms representing the flow of unbound compounds (products and optionally inerts) in and out of the discrete volume element, and the binding and diffusion terms, wherein a binding term captures nonlinearities of the process of adsorption of unbound product on the static phase through the prediction of the respective parameter of the term by the machine learning model at each iteration of the numerical integration; and/or
wherein the bulk flow mass balance model comprises equations (6) and (7) below: $\frac{d {{t}^{⇀}}_{u , n}}{dt} = \frac{{f}_{k}}{ΔV} \left({{t}^{⇀}}_{u , n - 1}-{{t}^{⇀}}_{u , n}\right) - {{k}^{˜}}_{a} ∘ {{c}^{⇀}}_{u , n} + {{k}^{⇀}}_{d} ∘ {{t}^{⇀}}_{b , n}$ $\frac{d {{t}^{⇀}}_{b , n}}{dt} = {{k}^{˜}}_{a} ∘ {{t}^{⇀}}_{u , n} - {{k}^{⇀}}_{d} ∘ {{t}^{⇀}}_{b , n}$
where fₖ is the feed flow rate, ΔV is the volume of the discrete volume element *n,* ${{t}^{⇀}}_{u , n}$ is a vector of latent variable values corresponding to concentrations of the unbound products in the discrete volume element n, ${{t}^{⇀}}_{b , n}$ is a vector of latent variable values corresponding concentrations of the bound products in the discrete volume element *n,* ${{t}^{⇀}}_{u , n - 1}$ is a vector of latent variable values corresponding to concentrations of the unbound products in the discrete volume element preceding the discrete volume element n, where discrete volume elements are sequentially labelled from input to output of the chromatography unit, and ∘ is an elementwise product; and/or
wherein the bulk flow mass balance model is solved over N discrete volume elements, wherein N is at least 2, wherein N is between 5 and 20, wherein is between 5 and 15, wherein N is selected from 8, 9, 10, 11, 12, or wherein N is 10; and/or wherein the discrete volume elements comprise a plurality of discrete volume elements along the chromatography unit in which binding and diffusion occurs, preceded by a discrete volume element in which no binding or diffusion occurs (entry dead volume) and followed by a discrete volume element in which no binding or diffusion occurs (exit dead volume).

8. The method of any preceding claim, wherein the machine learning model inputs further comprise the feed flow rate.

9. The method of any preceding claim, wherein the machine learning model is a recurrent machine learning model, wherein a recurrent machine learning model is a machine learning model that is able to account of the values of one or more predictions made at one or more preceding iterations of the numerical integration when making predictions at a current iteration of the numerical integration, optionally wherein the machine learning model further takes as input a recurrent states vector ${{x}^{⇀}}_{r , k , n}$ which comprises one or more state values for a current iteration k and discrete volume element n, and produces as output an updated recurrent state vector ${{x}^{⇀}}_{r , k + 1 , n}$ for use at the subsequent iteration, optionally wherein the machine learning model comprises a parameter prediction submodel and a recurrent state submodel, wherein the recurrent state submodel is configured to predict the updated recurrent states vector ${{x}^{⇀}}_{r , k + 1 , n}$ for use at the subsequent iteration based on the inputs of the machine learning model and the parameter prediction submdodel is configured to predict the parameters of the binding and diffusion terms based on the inputs of the machine learning model.

10. The method of any preceding claim, wherein the machine learning model comprises a recurrent state submodel and a parameter prediction submodel that are parameterized by respective weights that are all learned simultaneously, and/or wherein the trained machine learning model is associated with learned weights that are the same for every discrete volume element and every iteration of the numerical integration, and/or wherein the machine learning model is a nonlinear regression model, and/or wherein the machine learning model comprises a neural network, optionally wherein the neural network is a fully connected neural network, a neural network comprising at least 2 hidden layers, a neural network comprising between 1 and 4 hidden layers, a neural network comprising 2 or 3 hidden layers, and/or a neural network comprising between 8 and 60 nodes in each hidden layer.

11. The method of any preceding claim, further comprising training the machine learning model using training data comprising latent variable values of the dimensionality reduction model obtained from training data comprising spectroscopy data obtained at a plurality of sampling times of input and output flows of a plurality of chromatography processes, optionally wherein the training data comprises latent variable values from input and output spectroscopy data each associated with a respective discrete time point during a chromatographic process and/or latent variable values from input and/or output spectroscopy data associated with a time range during a chromatographic process.

12. The method of claim 11, wherein training the machine learning model comprises iteratively updating weights of the machine learning model by:
for each of one or more training datasets each comprising latent variable values of the dimensionality reduction model corresponding to spectroscopy data obtained for an input flow, and latent variable values of the dimensionality reduction model corresponding to spectroscopy data obtained for an output flow and feed flow rate data for a chromatographic process corresponding to a plurality of time points during the chromatographic process, solving the bulk flow mass balance model using values of the parameters of the binding and diffusion terms predicted by the machine learning model at a preceding iteration of the training at discrete time intervals corresponding to plurality of time points from the training dataset, with feed rate trajectories corresponding to the feed flow rate data from the training dataset and latent variable values from the training dataset, thereby obtaining simulated data corresponding to each of the one or more training dataset;
evaluating a loss function quantifying the difference between the simulated data and the corresponding one or more training datasets; and
updating the weights of the machine learning model based on the weights of the machine learning model at the current iteration and the value of the loss function, optionally using a gradient descent procedure, until one or more predetermined stopping criteria are satisfied.

13. The method of any preceding claim, wherein solving the bulk flow mass balance model comprises:
(a) iteratively integrating the model over a plurality of discrete time intervals of predetermined duration, wherein at each iteration predictions for the parameters of the binding and diffusion terms are obtained for each of the discrete volume elements using the machine learning model and a current state vector comprising the latent variable values corresponding to the concentration of bound products in each discrete volume element at a latest iteration, the latent variable values corresponding to the concentrations of unbound products in each discrete volume element at the latest iteration, and optionally the concentrations of inerts in each discrete volume element at the latest iteration, and optionally the feed flow rate, identifying a discrete state-space model using the bulk flow mass balance model parameterised using said predictions, and determining an updated state vector for the time interval corresponding to the current iteration using the values of the current state vector and the coefficients of the discrete state-space model; and/or
(b) integrating the model for each of the one or more discrete volume elements at a plurality of discrete time points, thereby obtaining simulated data comprising the latent variable values corresponding to the concentration of the products in the effluent (output) of the chromatography unit at the plurality of discrete time points, and determining using said simulated data and an inverse dimensionality reduction model, spectroscopy data comprising one or more spectra for the effluent at one or more of the plurality of discrete time points.

14. The method of any preceding claim, comprising:
(a) simulating a chromatography process using the method of any of claims 1 to 13, using feed flow rate data corresponding to measured or planned feed flow rates of a chromatography process and latent variables values data for the feed flow of the chromatography process corresponding to measured feed spectroscopy data or spectroscopy data corresponding to planned feed concentrations of the chromatography process, thereby obtaining simulated effluent latent variable values corresponding to the effluent latent variable values of the chromatography process; and
comparing the simulated effluent latent variable values or one or more metrics derived therefrom to observed effluent latent variable values or metrics derived therefrom, and determining whether to repack the chromatography unit based on the results of the comparing, whether to switch the feed to a different column in a multi-column chromatography process, or whether a fault or aging condition is present in the chromatography unit; and/or
(b) simulating the chromatography process using a plurality of candidate sets of process parameters each comprising at least latent variables values data for the feed flow and a feed flow rate using the method of any preceding claim, thereby obtaining simulated latent variables values data for the effluent flow for each candidate set of process parameters, and
comparing the simulated latent variables values data for the effluent flow or one or more metrics derived therefrom to select a set of process parameters from the sets of candidate process parameters to use in operating the chromatography process.

15. A system comprising:
at least one processor; and
at least one non-transitory computer readable medium containing instructions that, when executed by the at least one processor, cause the at least one processor to perform the method of any of preceding claim;
optionally wherein the system further comprises, in operable connection with the processor, one or more of:
a chromatography unit;
a user interface; and
one or more sensors.
